(19) **Europäisches Patentamt / European Patent Office / Office européen des brevets**

(11) **EP 3 039 443 B1**

(12) # EUROPÄISCHE PATENTSCHRIFT

(45) Veröffentlichungstag und Bekanntmachung des Hinweises auf die Patenterteilung:
**27.12.2017 Patentblatt 2017/52**

(21) Anmeldenummer: **14758504.6**

(22) Anmeldetag: **25.08.2014**

(51) Int Cl.:
**G01R 27/32** *(2006.01)*　　**G01R 35/00** *(2006.01)*

(86) Internationale Anmeldenummer:
**PCT/EP2014/002320**

(87) Internationale Veröffentlichungsnummer:
**WO 2015/028139 (05.03.2015 Gazette 2015/09)**

(54) **VERFAHREN ZUR KALIBRIERUNG EINES MESSAUFBAUS**

METHOD FOR CALIBRATING A MEASUREMENT SETUP

PROCÉDÉ D'ÉTALONNAGE UN DISPOSITIF DE MESURE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **26.08.2013 DE 102013014175**

(43) Veröffentlichungstag der Anmeldung:
**06.07.2016 Patentblatt 2016/27**

(73) Patentinhaber: **Rosenberger Hochfrequenztechnik GmbH & Co. KG
83413 Fridolfing (DE)**

(72) Erfinder:
• **ZIETZ, Christian
59555 Lippstadt (DE)**
• **HAERKE, Dominic
30982 Pattensen (DE)**

(74) Vertreter: **Zeitler Volpert Kandlbinder
Patent- und Rechtsanwälte Partnerschaft mbB
Postfach 26 02 51
80059 München (DE)**

(56) Entgegenhaltungen:
DE-A1- 4 401 068

• HU J ET AL: "Calibrated non-linear vector network measurement without using a multi-harmonic generator", IET MICROWAVES ANTENNAS & PROPAGATION,, Bd. 5, Nr. 5, 11. April 2011 (2011-04-11), Seiten 616-624, XP006038342, ISSN: 1751-8733, DOI: 10.1049/IET-MAP:20100580

• HOLGER HEUERMANN: "Calibration of a Network Analyzer Without a Thru Connection for Nonlinear and Multiport Measurements", IEEE TRANSACTIONS ON MICROWAVE THEORY AND TECHNIQUES, IEEE SERVICE CENTER, PISCATAWAY, NJ, US, Bd. 56, Nr. 11, 1. November 2008 (2008-11-01), Seiten 2505-2510, XP011236944, ISSN: 0018-9480, DOI: 10.1109/TMTT.2008.2005883

• THOMAS ZELDER ET AL: "Contactless network analysis system for the calibrated measurement of the scattering parameters of planar two-port devices", MICROWAVE CONFERENCE, 2007. EUROPEAN, IEEE, PI, 1. Oktober 2007 (2007-10-01), Seiten 246-249, XP031191780, ISBN: 978-2-87487-001-9

• MOUHAMAD ABOUCHAHINE ET AL: "Broadband Time-Domain Measurement System for the Characterization of Nonlinear Microwave Devices With Memory", IEEE TRANSACTIONS ON MICROWAVE THEORY AND TECHNIQUES, IEEE SERVICE CENTER, PISCATAWAY, NJ, US, Bd. 58, Nr. 4, 1. April 2010 (2010-04-01), Seiten 1038-1045, XP011304549, ISSN: 0018-9480

• ROGER B MARKS ED - DAVID F WAIT: "Formulations of the Basic Vector Network Analyzer Error Model including Switch-Terms", ARFTG CONFERENCE DIGEST-SPRING, 19TH ARFTG, IEEE, PI, 1. Dezember 1997 (1997-12-01), Seiten 115-126, XP031056045, ISBN: 978-0-7803-5686-3

- **DAVID E ROOT ET AL: "X-Parameter: Das neue Paradigma zur Beschreibung nichtlinearer HF-und Mikrowellenbauelemente // X-parameters: The New Paradigm for the Description of Non-linear RF and Microwave Devices", TECHNISCHES MESSEN TM, R.OLDENBOURG VERLAG. MUNCHEN, DE, Bd. 77, Nr. 7-8, 1. Januar 2010 (2010-01-01), Seiten 413-418, XP002703955, ISSN: 0171-8096, DOI: 10.1524/TEME.2010.0065**
- **ENGEN G F ET AL: "THRU-REFLECT-LINE: AN IMPROVED TECHNIQUE FOR CALIBRATING THE DUAL SIX-PORT AUTOMATIC NETWORK ANALYZER", IEEE TRANSACTIONS ON MICROWAVE THEORY AND TECHNIQUES, IEEE SERVICE CENTER, PISCATAWAY, NJ, US, Bd. MTT-27, Nr. 12, 1. Dezember 1979 (1979-12-01), Seiten 987-993, XP001084385, ISSN: 0018-9480, DOI: 10.1109/TMTT.1979.1129778**

- **FERRERO A ET AL: "A NEW IMPLEMENTATION OF A MULTIPORT AUTOMATIC NETWORK ANALYZER", IEEE TRANSACTIONS ON MICROWAVE THEORY AND TECHNIQUES, IEEE SERVICE CENTER, PISCATAWAY, NJ, US, Bd. 40, Nr. 11, 1. November 1992 (1992-11-01), Seiten 2078-2085, XP000321270, ISSN: 0018-9480, DOI: 10.1109/22.168766**

**EP 3 039 443 B1**

**Beschreibung**

Die vorliegende Erfindung betrifft ein Verfahren zum Kalibrieren einer Messvorrichtung zum Vermessen eines Zweitor-Prüfobjektes (DUT - Device Under Test), welches in einer Kalibrierebene ein erstes Tor und ein zweites Tor aufweist.

Zu den wichtigsten Messaufgaben der Hochfrequenz- und Mikrowellentechnik gehört die Messung von Reflexionsfaktoren oder allgemein - bei Mehrtoren - die Messung von Streuparametern. Durch die Streuparameter wird das linear beschreibbare Netzwerkverhalten eines Testobjektes (DUT - Device Under Test) charakterisiert. Häufig interessiert man sich nicht nur für die Streuparameter bei einer einzigen Messfrequenz, sondern für deren Frequenzabhängigkeit über ein endlich breites Messband. Das zugehörige Messverfahren bezeichnet man als Netzwerkanalyse. Je nach der Bedeutung der Phaseninformation bei der jeweiligen Messaufgabe kann man die Streuparameter entweder nur dem Betrage nach oder auch komplex messen. Im ersten Fall spricht man von skalarer, im zweiten Fall von vektorieller Netzwerkanalyse. Je nach Verfahren, Torzahl und Messfrequenzbereich ist der Netzwerkanalysator ein mehr oder weniger aufwendiges System aus Testsignalquelle und Empfängern, die nach dem Homodyn- oder dem Heterodynprinzip arbeiten. Weil die Messsignale durch Leitungen und sonstige Komponenten mit unbekannten und nichtidealen Eigenschaften zum Messobjekt und wieder zurückgeführt werden müssen, treten bei der Netzwerkanalyse neben zufälligen Fehlern auch systematische Fehler auf. Durch Kalibriermessungen, deren Ziel die Bestimmung möglichst vieler der unbekannten Parameter der Messeinrichtung ist, können die systematischen Fehler in gewissen Grenzen rückgängig gemacht werden. Es existieren hier sehr viele Verfahren und Strategien, die sich im Umfang des Fehlermodells und damit in Aufwand und Leistungsfähigkeit erheblich unterscheiden. (Uwe Siart; "Kalibrierung von Netzwerkanalysatoren"; 4. Januar 2012 (Version 1.51); http://www.siart.de/lehre/nwa.pdf).

Jedoch beschreiben derart kalibriert gemessene Streuparameter nur lineare, zeitinvariante Testobjekte vollständig. Eine Erweiterung der Streuparameter auf nichtlineare Testobjekte stellen die X-Parameter dar (D. Root et al: "X-Parameter: Das neue Paradigma zur Beschreibung nichtlinearer HF- und Mikrowellenbauelemente". In: tm - Technisches Messen Nr. 7-8, Vol. 77, 2010), die ebenfalls über der Frequenz definiert sind. Allerdings lässt sich jedes Testobjekt auch durch Messung der Ströme und Spannungen respektive der absoluten Wellengrößen an seinen Toren im Zeitbereich beschreiben. Die Messung im Zeitbereich erfasst inhärent sämtliche bspw. durch die Nichtlinearität hervorgerufenen weiteren Spektralanteile sowie die zeitliche Veränderung des Testobjekts oder dessen Eingangssignals. Auch eine derartige Zeitbereichsmessung bedarf der Kalibrierung. Zur Messung absoluter Größen können allerdings die oben genannten Kalibrierverfahren nicht unverändert angewendet werden, da sie nur die Bestimmung relativer Größen (Streuparameter) erlauben.

Da der Einsatz verschiedenster nichtlinearer Bauteile in der Hochfrequenztechnik unverzichtbar ist, ist es von großem Interesse, das Verhalten solcher Schaltungselemente beschreiben zu können. Mit einem Modell ähnlich der Streuparameter für lineares Bauteilverhalten, könnten dann Nichtlinearitäten im Voraus in Schaltungssimulationen berücksichtigt werden. Um korrekte und zuverlässige Ergebnisse zu erhalten ist es notwendig, diesen Messaufbau zunächst zu kalibrieren. Eine Kalibrierung dient der Bereinigung der Ergebnisse um die in nichtidealen Messungen zwangsläufig auftretenden Systemfehler. Hierdurch wird sichergestellt, dass die Endergebnisse nur das Verhalten des Prüflings (DUT: Device Under Test) beschreiben und keine Einflüsse wie beispielsweise frequenzabhängige Dämpfung beispielsweise von Zuleitungen oder anderen Elementen des Aufbaus enthalten.

Um die Systemfehler einer Messvorrichtung bzw. eines Messaufbaus zu ermitteln, gilt es, dessen Fehlerterme zu bestimmen. Die Fehlerterme werden meist in Form einer Matrix, der Fehlermatrix, angegeben. Diese beschreibt dann das Zweitor zwischen Messgerät und der Systemebene bis zu der kalibriert werden soll (Kalibrierebene). Die Kalibrierebene fällt dann üblicherweise mit dem Eingangstor des Prüflings (DUT) zusammen. Im Zuge einer Kalibrierung werden dafür zumeist drei (bei manchen Verfahren auch vier oder fünf) unterschiedliche Kalibrierstandards mit einem VNA gemessen. Je nach Kalibrierverfahren sind unterschiedliche Eigenschaften der Standards vorgeschrieben (HIEBEL, Michael: Grundlagen der vektoriellen Netzwerkanalyse. 1. Auflage, Rohde & Schwarz GmbH & Co. KG, 2006). Nachdem anhand der Messergebnisse der einzelnen Kalibrierschritte zunächst die Fehlerterme ermittelt worden sind, können diese anschließend für eine Korrekturrechnung verwendet werden, die die Messungen des DUTs von den Systemfehlern befreit.

Aus dem Artikel "Calibrated non-linear vector network measurement without using a multi-haromic generator" von Hu J. et al., IET MICROWAVES ANTENNAS & PROPAGATION, Bd. 5. Nr. 5, 11. April 2011, Seiten 616 bis 624 (XP006038342) ist ein Verfahren zum Kalibieren einer Messvorrichtung bekannt, die einen ersten und einen zweiten Richtkoppler aufweist. Diese Messvorrichtung dient zum Vermessen eines Zweitor-Prüfobjektes, welches in einer Kalibrierebene ein erstes Tor und ein zweites Tor aufweist, wobei zum Kalibrieren der Messvorrichtung ein vektorieller Netzwerkanalysator (VNA) mit Messtoren mit dem ersten und zweiten Tor in der Kalibrierebene verbunden wird. Für die Kalibrierung wird ein einzelner Signalgenerator verwendet. Die Kalibierung zwischen den tatsächlichen Messebenen und den idealen Messebenen verwendet ein lineares 8-Term-Fehlermodell wobei die Torwellen in den DUT-Ebenen $a_1$, $b_1$, $a_2$, $b_2$ und die unbearbeiteten (raw) Empfängermessungen A, B, C und D mittels einer 4x4-Matrix in Relation zue-

inander gesetzt werden.

$$\begin{bmatrix} a_1(f) \\ b_1(f) \\ a_2(f) \\ b_2(f) \end{bmatrix} = K(f) \begin{bmatrix} 1 & e_{12}(f) & 0 & 0 \\ e_{21}(f) & e_{22}(f) & 0 & 0 \\ 0 & 0 & e_{33}(f) & e_{34}(f) \\ 0 & 0 & e_{43}(f) & e_{44}(f) \end{bmatrix} \times \begin{bmatrix} A(f) \\ B(f) \\ C(f) \\ D(f) \end{bmatrix}$$

Hierbei wird angenommen, dass die aktuellen Empfängermessungen und die Torwellen in den idealen Messebenen linear miteinander verknüpft sind. Auf diese Weise verknüpft für jede Frequenz $f$ eine Matrix, welche Fehlerterme $e_{ii}(f)$ enthält, die aktuellen Empfängermessungen $A(f)$, $B(f)$, $C(f)$ und $D(f)$ mit den Torwellen $a_i(f)$, $b_i(f)$, $a_2(f)$, $b_2(f)$ in den idealen Messebenen. Zur absoluten Phasenkalibrierung wird ein Zusatzfaktor $K(f)$ dem Fehlermodell hinzugefügt, um die absolute Leistung und Phase zu korrigieren.

Der Erfindung liegt die Aufgabe zugrunde, ein Zeitbereichsmessverfahren für nichtlineare Bauteile zu entwickeln, mit dessen Ausgangsgrößen ein Modell erzeugt werden kann, das die Berücksichtigung von Nichtlinearitäten im Voraus in Schaltungssimulationen ermöglicht.

Diese Aufgabe wird erfindungsgemäß durch ein Verfahren der o.g. Art mit den in Anspruch 1 angegebenen Merkmalen gelöst. Vorteilhafte Ausgestaltungen der Erfindung sind in den weiteren Ansprüchen beschrieben.

Bei einem erfindungsgemäßen Verfahren ist erfindungsgemäß folgendes vorgesehen: Verfahren zum Kalibrieren einer, einen ersten und einen zweiten Richtkoppler aufweisenden Messvorrichtung zum Vermessen eines Zweitor-Prüfobjektes (DUT - <u>D</u>evice <u>U</u>nder <u>T</u>est), welches in einer Kalibrierebene ein erstes Tor und ein zweites Tor aufweist; wobei zum Kalibrieren der Messvorrichtung ein vektorieller Netzwerkanalysator (VNA) mit einem ersten, zweiten, dritten, vierten, fünften und sechsten Messtor mit dem ersten und zweiten Tor in der Kalibrierebene derart verbunden wird, dass das erste Messtor mit dem ersten Tor in der Kalibrierebene, das zweite Messtor mit dem zweiten Tor in der Kalibrierebene, das dritte und vierte Messtor mit dem ersten Richtkoppler sowie das fünfte und sechste Messtor mit dem zweiten Richtkoppler über einen jeweiligen Wellenleiter für elektromagnetische Wellen verbunden ist; wobei an dem ersten Messtor eine elektromagnetische Welle $a_1$ in Richtung des ersten Tors in der Kalibrierebene ausläuft und eine elektromagnetische Welle $b_1$ aus Richtung des ersten Tores in der Kalibrierebene einläuft; wobei an dem zweiten Messtor eine elektromagnetische Welle $a_2$ in Richtung des zweiten Tors in der Kalibrierebene ausläuft und eine elektromagnetische Welle $b_2$ aus Richtung des zweiten Tores in der Kalibrierebene einläuft; wobei an dem ersten Tor in der Kalibrierebene eine elektromagnetische Welle $a_{DUT,1}$ aus Richtung des ersten Messtores einläuft und eine elektromagnetische Welle $b_{DUT,1}$ in Richtung des ersten Messtores ausläuft; wobei an dem zweiten Tor in der Kalibrierebene eine elektromagnetische Welle $a_{OUT,2}$ aus Richtung des zweiten Messtores einläuft und eine elektromagnetische Welle $b_{DUT,2}$ in Richtung des zweiten Messtores ausläuft; wobei zwischen dem ersten Messtor und dem ersten Tor in der Kalibrierebene ein Anteil der Welle $a_1$ als $a_{Mess,1}$ durch den ersten Richtkoppler ausgekoppelt und dem dritten Messtor des VNA zugeführt wird; wobei zwischen dem ersten Messtor und dem ersten Tor in der Kalibrierebene ein Anteil der Welle $b_1$ als $b_{mess,1}$ durch den ersten Richtkoppler ausgekoppelt und dem vierten Messtor des VNA zugeführt wird; wobei zwischen dem zweiten Messtor und dem zweiten Tor in der Kalibrierebene ein Anteil der Welle $a_2$ als $a_{Mess,2}$ durch den zweiten Richtkoppler ausgekoppelt und dem fünften Messtor des VNA zugeführt wird; wobei zwischen dem zweiten Messtor und dem zweiten Tor in der Kalibrierebene ein Anteil der Welle $b_2$ als $b_{Mess,2}$ durch den zweiten Richtkoppler ausgekoppelt und dem sechsten Messtor des VNA zugeführt wird; wobei zum Kalibrieren der Messvorrichtung anstatt des DUTs mindestens drei verschiedene Kalibrierstandards in der Kalibrierebene angeordnet werden; wobei für jeden Kalibierstandard $K$ und für jeden gewünschten Frequenzpunkt einer Frequenz $f$ von $a_1$ bzw. $a_2$ Streuparameter $S_{xy,K,f}$ mit $x = 1, 2, 3, 4, 5$ oder $6$ und $y = 1$ oder $2$ zwischen dem $y$-ten und dem $x$-ten Messtor des VNA für den Kalibrierstandard $K$ und die Frequenz $f$ aus den bekannten Größen $a_{1,K,f}$ und $a_{2,K,f}$ sowie aus den gemessenen Größen $b_{1,K,f}$, $b_{2,K,f}$, $a_{Mess,1,K,f}$, $b_{Mess,1,K,f}$, $a_{Mess,2,K,f}$, $b_{Mess,2,K,f}$ bestimmt werden, wobei

$$\begin{bmatrix} b_{1,K,f} \\ b_{2,K,f} \end{bmatrix} = \begin{bmatrix} S_{11,K,f} & S_{12,K,f} \\ S_{21,K,f} & S_{22,K,f} \end{bmatrix} \begin{bmatrix} a_{1,K,f} \\ a_{2,K,f} \end{bmatrix}$$

$$\begin{bmatrix} a_{Mess,1,K,f} \\ b_{Mess,1,K,f} \end{bmatrix} = \begin{bmatrix} S_{31,K,f} & S_{32,K,f} \\ S_{41,K,f} & S_{42,K,f} \end{bmatrix} \begin{bmatrix} a_{1,K,f} \\ a_{2,K,f} \end{bmatrix}$$

$$\begin{bmatrix} a_{Mess,2,K,f} \\ b_{Mess,2,K,f} \end{bmatrix} = \begin{bmatrix} S_{51,K,f} & S_{52,K,f} \\ S_{61,K,f} & S_{62,K,f} \end{bmatrix} \begin{bmatrix} a_{1,K,f} \\ a_{2,K,f} \end{bmatrix}$$

gilt;

wobei aus den gemessenen Streuparametern $S_{xy,K,f}$ mit x = 3, 4, 5, 6 und y = 1, 2 der Kalibrierstandards eine die Übertragung über die Richtkoppler beschreibende Streumatrix $\mathbf{S_{unkorr,K,f}}$

$$\mathbf{S_{unkorr,K,f}} = \begin{bmatrix} S_{11,unkorr,K,f} & S_{12,unkorr,K,f} \\ S_{21,unkorr,K,f} & S_{22,unkorr,K,f} \end{bmatrix},$$

mit Streuparametern $S_{11,unkorr,K,f}$, $S_{12,unkorr,K,f}$, $S_{21,unkorr,K,f}$ und $S_{22,unkorr,K,f}$ berechnet wird, gemäß

$$S_{11,unkorr,K,f} = \frac{b_{Mess,1,K,f}}{a_{Mess,1,K,f}} = \frac{S_{41,K,f}}{S_{31,K,f}} = \sigma_{11}$$

$$S_{21,unkorr,K,f} = \frac{b_{Mess,2,K,f}}{a_{Mess,1,K,f}} = \frac{S_{61,K,f}}{S_{31,K,f}} = \sigma_{21}$$

$$S_{12,unkorr,K,f} = \frac{b_{Mess,1,K,f}}{a_{Mess,2,K,f}} = \frac{S_{42,K,f}}{S_{52,K,f}} = \sigma_{12}$$

$$S_{22,unkorr,K,f} = \frac{b_{Mess,2,K,f}}{a_{Mess,2,K,f}} = \frac{S_{62,K,f}}{S_{52,K,f}} = \sigma_{22}$$

wobei mit den gemessenen Streuparametern $S_{xy,K,f}$ mit x = 1, 2 und y = 1, 2 der Kalibrierstandards eine die Übertragung zwischen dem ersten Messtor des VNA und dem ersten Tor in der Kalibrierebene einerseits sowie zwischen dem zweiten Messtor des VNA und dem zweiten Tor in der Kalibrierebene andererseits beschreibende Streumatrix $\mathbf{S_{I,K,f}}$ als

$$\mathbf{S_{I,K,f}} = \begin{bmatrix} S_{11,K,f} & S_{12,K,f} \\ S_{21,K,f} & S_{22,K,f} \end{bmatrix}$$

bestimmt wird;

wobei mit den gemessenen Streuparametern $S_{xy,K,f}$ mit x = 1, 2 und y = 1, 2 der Streumatrix $\mathbf{S_{I,K,f}}$ Terme $i_{00}$, $i_{01} \cdot i_{10}$ und $i_{11}$ einer Fehlermatrix $\mathbf{I_A}$ mit

$$\mathbf{I_A} = \begin{bmatrix} i_{00} & i_{01} \\ i_{10} & i_{11} \end{bmatrix}$$

für eine Signalübertragung zwischen dem ersten Messtor einerseits und dem ersten Tor in der Kalibrierebene andererseits in Abhängigkeit von einer Frequenz f der Wellen $a_1$ bzw. $a_2$ mittels eines vorbestimmten Kalibrieralgorithmus bestimmt werden, wobei $\mathbf{I_A}$ eine Streumatrix gemäß

$$\begin{bmatrix} b_1 \\ a_{DUT,1} \end{bmatrix} = \mathbf{I_A} \begin{bmatrix} a_1 \\ b_{DUT,1} \end{bmatrix}$$

ist;

wobei mit den gemessenen Streuparametern $S_{xy,K,f}$ mit x = 1, 2 und y = 1, 2 der Streumatrix $\mathbf{S_{I,K,f}}$ Terme $i_{22}$, $i_{23} \cdot i_{32}$ und $i_{33}$ einer Fehlermatrix $\mathbf{I_B}$ mit

$$\mathbf{I_B} = \begin{bmatrix} i_{22} & i_{23} \\ i_{32} & i_{33} \end{bmatrix}$$

für eine Signalübertragung zwischen dem zweiten Messtor einerseits und dem zweiten Tor in der Kalibrierebene andererseits in Abhängigkeit von einer Frequenz f der Wellen $a_1$ bzw. $a_2$ mittels eines vorbestimmten Kalibrieralgorithmus bestimmt werden, wobei $I_B$ eine Streumatrix gemäß

$$\begin{bmatrix} a_{DUT,2} \\ b_2 \end{bmatrix} = \mathbf{I_B} \begin{bmatrix} b_{DUT,2} \\ a_2 \end{bmatrix}$$

ist,
wobei für jeden Frequenzschritt mit der Frequenz f von $a_1$ bzw. $a_2$ und für jeden Kalibrierstandard K eine Korrektur der Streumatrix $\mathbf{S_{unkorr,K,f}}$ zu einer korrigierten Streumatrix $\mathbf{S_{c,K,t}}$ gemäß der Formel

$$\mathbf{S_{c,K,f}} = \frac{1}{D} \begin{bmatrix} \sigma_{11} - \sigma_{12}\sigma_{21}\Gamma_{F,K,f} & \sigma_{12} - \sigma_{11}\sigma_{12}\Gamma_{R,K,f} \\ \sigma_{21} - \sigma_{22}\sigma_{21}\Gamma_{F,K,f} & \sigma_{22} - \sigma_{12}\sigma_{21}\Gamma_{R,K,f} \end{bmatrix}$$

durchgeführt wird, wobei $D = 1 - \sigma_{12}\sigma_{21}\Gamma_{F,k,f}\Gamma_{R,k,f}$ ist und $\Gamma_{F,K,f} = \dfrac{S_{51,K,f}}{S_{61,K,f}}$ das Verhältnis von am Ausgang des zweiten Richtkopplers gemessener hin- zu rücklaufender Welle bei Speisung durch das erste Messtor des VNA und

$\Gamma_{R,K,f} = \dfrac{S_{32,K,f}}{S_{42,K,f}}$ das Verhältnis von am Ausgang des ersten Richtkopplers gemessener hin- zu rücklaufender Welle bei Speisung durch das zweite Messtor des VNA beschreibt;
wobei mit den Streuparametern der Streumatrix $\mathbf{S_{c,K,f}}$ Terme $e_{00}$, $e_{01} \cdot e_{10}$ und $e_{11}$ einer Fehlermatrix

$$E_A = \begin{bmatrix} e_{00} & e_{01} \\ e_{10} & e_{11} \end{bmatrix}$$

für eine Signalübertragung zwischen dem dritten und vierten Messtor einerseits und dem ersten Tor in der Kalibrierebene andererseits in Abhängigkeit von einer Frequenz f der Wellen $a_1$ bzw. $a_2$ mittels eines vorbestimmten Kalibrieralgorithmus bestimmt werden, wobei $E_A$ eine Streumatrix gemäß

$$\begin{bmatrix} b_{Mess,1} \\ a_{DUT,1} \end{bmatrix} = E_A \begin{bmatrix} a_{Mess,1} \\ b_{DUT,1} \end{bmatrix}$$

ist;
wobei mit den Streuparametern der Streumatrix $\mathbf{S_{c,K,f}}$ Terme $e_{22}$, $e_{23} \cdot e_{32}$ und $e_{33}$ einer Fehlermatrix

$$E_B = \begin{bmatrix} e_{22} & e_{23} \\ e_{32} & e_{33} \end{bmatrix}$$

für eine Signalübertragung zwischen dem fünften und sechsten Messtor einerseits und dem zweiten Tor in der Kalibrierebene andererseits in Abhängigkeit von einer Frequenz f der Wellen $a_1$ bzw. $a_2$ mittels eines vorbestimmten Kalibrieralgorithmus bestimmt werden, wobei $E_B$ eine Streumatrix gemäß

$$\begin{bmatrix} a_{DUT,2} \\ b_{Mess,2} \end{bmatrix} = E_B \begin{bmatrix} b_{DUT,2} \\ a_{Mess,2} \end{bmatrix}$$

ist;

wobei die isolierten Terme $i_{01}$ und $i_{10}$ aus dem Produkt $i_{01} \cdot i_{10}$ sowie die isolierten Terme $i_{23}$ und $i_{32}$ aus dem Produkt $i_{23} \cdot i_{32}$ gemäß den Formeln

$$i_{01} = i_{10} = \pm\sqrt{i_{01} i_{10}}$$

und

$$i_{23} = i_{32} = \pm\sqrt{i_{23} i_{32}}$$

bestimmt werden, wobei das Vorzeichen jeweils ausgehend von einem Frequenzpunkt mit bekannter Phase durch stetige Ergänzung bestimmt wird, wobei eine Phasendifferenz von einem Frequenzpunkt zu einem nächsten Frequenzpunkt um 180° vermindert wird, wenn diese Phasendifferenz einen vorbestimmten Schwellwert überschreitet; wobei der isolierte Term $e_{10}$ aus dem Produkt $e_{10} \cdot e_{01}$ gemäß der Formel

$$e_{10} = i_{10} \cdot \frac{a_1}{a_{Mess,1}} \cdot \frac{1 - e_{11} S_{11,DUT,K^*}}{1 - i_{11} S_{11,DUT,K^*}}$$

berechnet und daraus der isolierte Term $e_{01}$ bestimmt wird, wobei

$$S_{11,DUT,K^*} = \frac{\left(S_{11,K^*,f} - i_{00}\right)}{\left(i_{10} \cdot i_{01} + i_{11} \cdot \left(S_{11,K^*,f} - i_{00}\right)\right)}$$

ist und K* einen Kalibrierstandard ohne Transmission bezeichnet; wobei der isolierte Term $e_{23}$ aus dem Produkt $e_{32} \cdot e_{23}$ gemäß der Formel

$$e_{23} = i_{23} \cdot \frac{a_2}{a_{Mess,2}} \cdot \frac{1 - e_{22} S_{22,DUT,K^*}}{1 - i_{22} S_{22,DUT,K^*}}$$

berechnet und daraus der isolierte Term $e_{23}$ bestimmt wird, wobei

$$S_{22,DUT,K^*} = \frac{\left(S_{22,K^*,f} - i_{22,f}\right)}{\left(i_{32} \cdot i_{23} + i_{33} \cdot \left(S_{22,K^*,f} - i_{22,f}\right)\right)}$$

ist und K* einen Kalibrierstandard ohne Transmission bezeichnet.

Dies hat den Vorteil, dass alle einzelnen Elemente der Fehlermatrizen $\boldsymbol{E_A}$ und $\boldsymbol{E_B}$ bekannt sind, so dass die absoluten Wellengrößen $a_{DUT,1}$, $a_{DUT,2}$, $b_{DUT,1}$, $b_{DUT,2}$ in der Kalibrierebene aus den an Richtkopplern gemessenen Größen $a_{Mess,1}$, $a_{Mess,2}$, $b_{Mess,1}$ und $b_{Mess,2}$ bestimmt werden können. Gleichzeitig hat die Güte bzw. Richtschärfe der Richtkoppler keinen Einfluss auf das Messergebnis, da diese durch die Kalibrierung mittels der Korrektur der Matrix $\boldsymbol{S_{unkorr,K,f}}$ berücksichtigt wird. Die Richtschärfe muss jedoch größer Null sein.

Eine Verwendung eines VNA mit lediglich vier Messtoren wird dadurch möglich, dass das dritte und vierte Messtor des VNA durch Umschaltung zusätzlich als fünftes und sechstes Messtor verwendet werden, so dass die Wellen $a_{Mess,1}$ und $b_{Mess,1}$ am dritten und vierten Messtor des VNA zeitlich getrennt von den Wellen $a_{Mess,2}$ und $b_{Mess,2}$ am fünften und sechsten Messtor des VNA gemessen werden.

Um für die Kalibrierung eines Zweitors ein 7-Term-Modell anzuwenden, werden die Terme $e_{00}$, $e_{01} \cdot e_{10}$ und $e_{11}$ der Fehlermatrix $\boldsymbol{E_A}$ sowie die Terme $e_{22}$, $e_{23} \cdot e_{32}$ und $e_{33}$ der Fehlermatrix $\boldsymbol{E_B}$ über einen TRL-Algorithmus aus der korrigierten Streumatrix $\boldsymbol{S_{c,K,f}}$ bestimmt und die Terme $i_{00}$, $i_{01} \cdot i_{10}$ und $i_{11}$ der Fehlermatrix $\boldsymbol{I_A}$ sowie die Terme $i_{22}$, $i_{23} \cdot i_{32}$ und $i_{33}$ der Fehlermatrix $\boldsymbol{I_B}$ über einen TRL-Algorithmus aus der Streumatrix $\boldsymbol{S_{I,K,f}}$ bestimmt.

Einen numerisch besonders stabilen und zuverlässige Messergebnisse liefernden TRL-Algorithmus erzielt man dadurch, dass für den TRL-Algorithmus drei verschiedene Kalibrierstandards des folgenden Typs verwendet werden, ein erster Kalibrierstandard des Typs "Durchverbindung" ("thru"), ein zweiter Kalibrierstandard des Typs "nicht angepasster Abschluss" ("reflect") und ein dritter Kalibrierstandard des Typs "Verzögerungsleitung" ("line"), wobei der Reflexionsfaktor des Kalibrierstandards "reflect" ungleich Null ist, wobei eine Phase der Reflexion an dem Kalibrierstandard "reflect" vorab auf +/-90° genau bestimmt ist, wobei für alle Messtore des VNA der identische Kalibrierstandard "reflect" verwendet wird, wobei eine Leitungsimpedanz des Kalibrierstandards "thru" im Wesentlichen einer Leitungsimpedanz des Kalibrierstandards "line" entspricht, wobei die elektrische Länge des Kalibrierstandards "thru" definitionsgemäß 0 ist, wobei eine elektrische Länge des Kalibrierstandards "line" ungleich $n \cdot \frac{\lambda}{2}$ ist mit $\lambda$ = Wellenlänge und n eine ganze Zahl größer oder gleich 1, wobei K = "reflect", "line" oder "thru" und K* = "reflect" ist.

Eine Verbesserung der numerischen Stabilität des Verfahrens erzielt man dadurch, dass für einen Unterschied $\Delta\varphi$ der elektrischen Länge des Kalibrierstandards "line" zur elektrischen Länge des Kalibrierstandards "thru"

$$(n-1)\frac{\lambda}{2} + \delta < \Delta\varphi < n \cdot \frac{\lambda}{2} - \delta$$

mit $\delta \geq 20°$ gilt.

Eine besonders gut umsetzbare Berechnungsmethode ergibt sich dadurch, dass der TRL-Algorithmus aus den Eingangsgrößen $S_{c,K,f}$ bzw. $S_{l,K,f}$ die Ausgangsgrößen $E_A$ und $E_B$ bzw. $I_A$ und $I_B$ folgendermaßen bestimmt, die Terme der Matrizen $E_A$, $E_B$ bzw. $I_A$ und $I_B$ werden über die Terme von deren jeweiliger Transmissionsmatrizen $T_A$ und $T_B$ mit

$$T_A = \begin{bmatrix} r_{11} & r_{12} \\ r_{21} & r_{22} \end{bmatrix} = r_{22} \begin{bmatrix} a & b \\ c & 1 \end{bmatrix}$$

und

$$T_B = \begin{bmatrix} \rho_{11} & \rho_{12} \\ \rho_{21} & \rho_{22} \end{bmatrix} = \rho_{22} \begin{bmatrix} \alpha & \beta \\ \gamma & 1 \end{bmatrix}$$

bestimmt, wobei

$$\begin{bmatrix} b_{DUT,1} \\ a_{DUT,1} \end{bmatrix} = T_A^{-1} \begin{bmatrix} b_{Mess,1} \\ a_{Mess,1} \end{bmatrix}$$

$$\begin{bmatrix} a_{DUT,2} \\ b_{DUT,2} \end{bmatrix} = T_B \begin{bmatrix} a_{Mess,2} \\ b_{Mess,2} \end{bmatrix}$$

gilt für $T_A$ = Transmissionsmatrix von $E_A$ und $T_B$ = Transmissionsmatrix von $E_B$ und wobei

$$\begin{bmatrix} b_{DUT,1} \\ a_{DUT,1} \end{bmatrix} = T_A^{-1} \begin{bmatrix} b_1 \\ a_1 \end{bmatrix}$$

$$\begin{bmatrix} a_{DUT,2} \\ b_{DUT,2} \end{bmatrix} = T_B \begin{bmatrix} a_2 \\ b_2 \end{bmatrix}$$

gilt für $T_A$ = Transmissionsmatrix von $I_A$ und $T_B$ = Transmissionsmatrix von $I_B$, wobei für eine gesuchte, um die Systemfehler bereinigte Transmissionsmatrix des DUT in der Kalibrierebene $T_{DUT}$ gilt

$$T_{DUT} = \frac{1}{r_{22}\rho_{22}} \frac{1}{a\alpha} \frac{1}{1 - b\frac{c}{a}} \frac{1}{1 - \gamma\frac{\beta}{\alpha}} \begin{bmatrix} 1 & -b \\ -c & a \end{bmatrix} T_M \begin{bmatrix} 1 & -\beta \\ -\gamma & \alpha \end{bmatrix}$$

wobei $T_M$ eine Transmissionsmatrix ist, welche aus einer an den Messtoren des VNA gemessenen Streumatrix bestimmt wird;

wobei zum Bestimmen der sieben Größen $a$, $b$, $c$, $a$, $\beta$, $\gamma$, $r_{22}\rho_{22}$ eine Transmissionsmatrix $T_T$ für den Kalibriestandard "thru" und eine Transmissionsmatrix $T_D$ für den Kalibrierstandard "line" aus für diese Kalibrierstandards jeweils an den Messtoren des VNA gemessenen Streumatrizen bestimmt wird, wobei

$$T_T = T_A T_B = g \begin{bmatrix} d & e \\ f & 1 \end{bmatrix}$$

$$T_D = T_A T_L T_B$$

$$T_D T_T^{-1} = T_{DT} = \begin{bmatrix} t_{11} & t_{12} \\ t_{21} & t_{22} \end{bmatrix}$$

gilt, wobei $T_L$ eine Transmissionsmatrix des Kalibrierstandards "line" in der Kalibrierebene ist und zu

$$T_L = T_{DUT,D} = \begin{bmatrix} e^{-\overline{\gamma}l} & 0 \\ 0 & e^{+\overline{\gamma}l} \end{bmatrix}$$

definiert wird, wobei $l$ die tatsächliche, physikalische Länge der Leitung und $\overline{\gamma}$ die Ausbreitungskonstante mit $\overline{\gamma} = \overline{\alpha} + \overline{j\beta}$ ist, wobei $\overline{\alpha}$ eine Dämpfungskonstante und $\overline{\beta}$ eine Phasenkonstante ist;

wobei zum Bestimmen von b die betragsmäßig kleinere Lösung und zum Bestimmen von $\frac{a}{c}$ die betragsmäßig größere Lösung der quadratischen Gleichung

$$t_{21}x^2 + (t_{22} - t_{11})x - t_{12} = 0$$

berechnet wird;

wobei zum Bestimmen von $r_{22}\rho_{22}$ die Gleichung

$$r_{22}\rho_{22} = g \frac{1 - e\frac{c}{a}}{1 - b\frac{c}{a}}$$

berechnet wird;

wobei zum Bestimmen von $\gamma$, $\frac{\beta}{\alpha}$ und $a\alpha$ die Gleichungen

$$\gamma = \frac{f - \frac{c}{a}d}{1 - \frac{c}{a}e}$$

$$\frac{\beta}{\alpha} = \frac{e - b}{d - bf}$$

$$a\alpha = \frac{d - bf}{1 - \frac{c}{a}e}$$

berechnet werden;

wobei zum Bestimmen von a die Größen $b_{Mess,1,reflect,f}$ und $a_{Mess,1,reflect,f}$ sowie $b_{Mess,2,reflect,f}$ und $a_{Mess,2,reflect,f}$ für den transmissionsfreien Kalibrierstandard "reflect" mit einem Reflexionsfaktor $\Gamma_R$, dessen Vorzeichen bekannt ist, durch die Fehlerzweitore mit den Fehlermatrizen $\boldsymbol{E_A}$ und $\boldsymbol{E_B}$ gemessen werden und die Größen $w_1$ und $w_2$ gemäß

$$w_1 = \frac{b_{Mess,1,reflect,f}}{a_{Mess,1,reflect,f}} = \frac{a\Gamma_R + b}{c\Gamma_R + 1}$$

$$w_2 = \frac{b_{Mess,2,reflect,f}}{a_{Mess,2,reflect,f}} = \frac{\alpha\Gamma_R - \gamma}{\beta\Gamma_R - 1}$$

berechnet werden, wobei der Betrag von a gemäß

$$a = \pm\sqrt{\frac{w_1 - b}{w_2 + \gamma}\frac{1 + w_2\frac{\beta}{\alpha}}{1 - w_1\frac{c}{a}}\frac{d - bf}{1 - \frac{c}{a}e}}$$

berechnet wird, wobei das Vorzeichen von a durch Einsetzen der zwei möglichen Ergebnisse von a in die Gleichung

$$\Gamma_R = \frac{w_1 - b}{a\left(1 - w_1\frac{c}{a}\right)}$$

dadurch bestimmt wird, dass das jeweilige Vorzeichen mit dem für $\Gamma_R$ bekannten Vorzeichen verglichen und bei Übereinstimmung dieses Vorzeichen für a bestimmt wird,

wobei c aus dem bekannten Wert für a und $\frac{a}{c}$ bestimmt wird,

wobei zum Bestimmen von $\alpha$ und $\beta$ die Gleichungen

$$\alpha = \frac{1}{a}\frac{d - bf}{1 - \frac{c}{a}e}$$

$$\beta = \alpha\frac{e - b}{d - bf}$$

berechnet werden;

wobei aus den Größen $a,b,c,\alpha,\beta,\gamma,r_{22}\rho_{22}$ die Terme der Transmissionsmatrizen $\boldsymbol{T_A}$ und $\boldsymbol{T_B}$ bestimmt werden, wobei aus den Termen der Transmissionsmatrizen $\boldsymbol{T_A}$ und $\boldsymbol{T_B}$ mittels der Umrechnungsbeziehung zwischen Streumatrix und Transmissionsmatrix die Terme der zugehörigen Streumatrizen $\boldsymbol{E_A}$ und $\boldsymbol{E_B}$ bzw. $\boldsymbol{I_A}$ und $\boldsymbol{I_B}$ berechnet werden. Hierbei ist der Reflexionsfaktor $\Gamma_R = S_{11,DUT}$ für die Reflexionsmessung durch das Fehlerzweitor mit der Fehlermatrix $\boldsymbol{E_A}$ und $\Gamma_R = S_{22,DUT}$ für die Reflexionsmessung durch das Fehlerzweitor mit der Fehlermatrix $\boldsymbol{E_B}$, wobei $S_{11,OUT}$ und $S_{22,DUT}$ Terme der Streumatrix $\boldsymbol{S_{DUT}}$

$$S_{DUT} = \begin{bmatrix} S_{11,DUT} & S_{12,DUT} \\ S_{21,DUT} & S_{22,DUT} \end{bmatrix}$$

des DUT in Kalibrierebene sind. Da nur $r_{22} * \rho_{22}$ bekannt ist, können auch nur $e_{01}*e_{10}$ bzw. $e_{23}*e_{32}$ berechnet werden. Dies ergibt sich aus der Umrechnungsbeziehung von T- nach S-Matrizen.

Die Erfindung wird im Folgenden anhand der Zeichnung näher erläutert. Diese zeigt in:

Fig. 1 ein schematisches Signalflussdiagramm eines Fehlerzweitores zwischen einem Messtor eines vektoriellen Netzwerkanalysators und einem Testobjekt (DUT - Device Under Test) für eine Eintormessung;

Fig. 2 ein schematisches Signalflussdiagramm für zwei Fehlerzweitore für die Messung eines DUT mit zwei Toren in einer Kalibrierebene;

Fig. 3 ein schematisches Schaltbild eines Schaltungsaufbaus für eine Kalibrierungsmessung;

Fig. 4 einen schematischen Ablaufplan einer bevorzugten Ausführungsform des erfindungsgemäßen Verfahrens und

Fig. 5 ein schematisches Schaltbild eines Schaltungsaufbaus für eine Messwerterfassung.

Eine Methode, mit der die Fehlerterme einer Eintormessung berechnet werden können, ist das sogen. OSM-Verfahren. Dabei werden die Standards Leerlauf (open), Kurzschluss (short) und Anpassung (match) verwendet. Hierbei führt es jedoch zu einem hohen Aufwand und Kosten für die Kalibrierstandards, dass diese beziehungsweise die von ihnen erzeugten Reflexionsfaktoren $\Gamma_O$, $\Gamma_M$, $\Gamma_S$ beim OSM-Verfahren genau bekannt sein müssen.

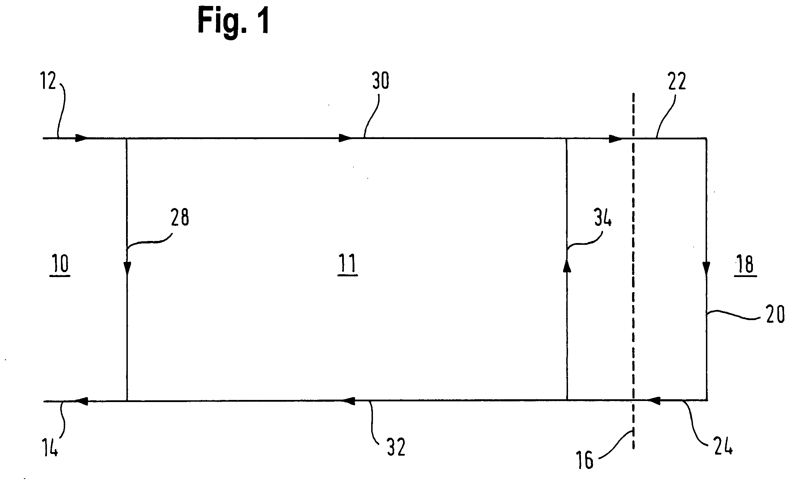

Das System, bestehend aus dem Fehlerzweitor 11 mit einer Fehlermatrix E und einem Abschluss mit dem Reflexionsfaktor $\Gamma_{DUT}$ ist in Fig. 1 veranschaulicht. An einem Messtor 10 des VNA läuft eine Welle mit der Wellengröße $\alpha_0$ 12 aus und eine Welle mit der Wellengröße $\beta_0$ 14 ein. In einer Kalibrierebene 16 befindet sich ein Tor 18 des DUT bzw. Abschluss 20 mit dem Reflexionsfaktor $\Gamma_{DUT}$. An dem Tor 18 des DUT bzw. in der Kalibrierebene 16 läuft eine Welle mit der Wellengröße $\alpha_1$ 22 ein und eine Welle mit der Wellengröße $\beta_1$ 24 aus. Die Fehlermatrix E des Fehlerzweitors 26 enthält die Terme $\varepsilon_{00}$ 28 (Reflexion am Messtor 10), $\varepsilon_{10}$ 30 (Transmission vom Messtor 10 zum Tor 18 in der Kalibrierebene 16), $\varepsilon_{01}$ 32 (Transmission von dem Tor 18 in der Kalibrierebene 16 zum Messtor 10) und $\varepsilon_{11}$ 34 (Reflexion am Tor 18 in der Kalibrierebene 16).

Das zu bestimmende Fehlerzweitor 11 lässt sich durch die Streumatrix bzw. Fehlermatrix **E**

$$E = \begin{bmatrix} \varepsilon_{00} & \varepsilon_{10} \\ \varepsilon_{01} & \varepsilon_{11} \end{bmatrix} \qquad\qquad (1)$$

beschreiben.

Der Reflexionsfaktor $\Gamma_{DUT}$ nimmt bei der Kalibrierung je nach angeschlossenem Standard den Wert $\Gamma_O$, $\Gamma_M$, $\Gamma_S$ an. Im Idealfall einer perfekten Anpassung des Match-Standards kann $\Gamma_M = 0$ angenommen werden. Die gemessenen Wellengrößen $\alpha_0$ 12 und $\beta_0$ 14 bezeichnen die vom Tor 10 des VNA auf das Fehlerzweitor 11 zulaufende bzw. die vom Fehlerzweitor 11 zum Tor 10 des VNA zurücklaufende Welle. Die Wellengrößen $\alpha_1$ 22 und $\beta_1$ 24 beschreiben die zu bestimmenden Wellengrößen in der Kalibrierebene 16, also die vom Fehlerzweitor 11 in den Abschluss 20 laufende bzw. die vom Abschluss 20 zum Fehlerzweitor 11 laufende Welle. Die mit den einzelnen Kalibrierstandards K gewonnenen Messergebnisse werden durch

$$M_K = \frac{\beta_{0,K}}{\alpha_{0,K}} \qquad\qquad (2)$$

beschrieben, wobei K für den verwendeten Kalibrierstandard (O, S bzw. M) steht. Für $M_O$, $M_S$ und $M_M$ lassen sich folgende Gleichungen aufstellen, die sich anhand von Fig. 1 nachvollziehen lassen.

$$M_O = e_{00} + \frac{e_{10}e_{01}\Gamma_O}{1 - e_{11}\Gamma_O} \qquad\qquad (3)$$

$$M_S = e_{00} + \frac{e_{10}e_{01}\Gamma_S}{1-e_{11}\Gamma_S} \qquad\qquad (4)$$

$$M_M = e_{00} \qquad\qquad (5)$$

Gleichung (5) nimmt aufgrund der weiter oben getroffenen Annahme $\Gamma_M = 0$ diese sehr einfache Form an. Nach Umformung von (3) bis (5) lassen sich die Größen $e_{00}$, $e_{11}$ und $e_{10}e_{01}$ bestimmen.

$$e_{00} = M_M \qquad\qquad (6)$$

$$e_{10}e_{01} = \frac{(\Gamma_O-\Gamma_S)(M_O-M_M)(M_S-M_M)}{\Gamma_O\Gamma_S(M_O-M_S)} \qquad\qquad (7)$$

$$e_{11} = \frac{\Gamma_S(M_O-M_M)-\Gamma_O(M_S-M_M)}{\Gamma_O\Gamma_S(M_O-M_S)} \qquad\qquad (8)$$

Da sich das Produkt $e_{10}e_{01}$ nicht ohne weiteres in seine Faktoren zerlegen lässt, kann aus den Fehlertermen zwar der systemfehlerkorrigierte Messwert $\Gamma_{DUT}$ bestimmt werden, nicht jedoch die Wellengrößen $\alpha_1$ 22 und $\beta_1$ 24, aus denen dieser besteht. Dies geschieht mit dem Messwert $M_{DUT} = \frac{\beta_{0,DUT}}{\alpha_{0,DUT}}$ anhand Gleichung (9) (HIEBEL, Michael: "Grundlagen der vektoriellen Netzwerkanalyse", 1. Auflage, Rohde & Schwarz GmbH & Co. KG, 2006).

$$\Gamma_{DUT} = \frac{\beta_1}{\alpha_1} = \frac{M_{DUT}-e_{00}}{e_{10}e_{01}+e_{11}(M_{DUT}-e_{00})} \qquad\qquad (9)$$

In Gleichung (9) wird deutlich, dass zur Auftrennung des Quotienten $\frac{\beta_1}{\alpha_1}$ zunächst das Produkt $e_{10}e_{01}$ zerlegt werden müsste.

Ist das zu untersuchende Prüfobjekt, wie im vorliegenden Fall, ein Zweitor, so muss für die Kalibrierung statt des zuvor erläuterten 3-Term-Modells ein 7-Term-Modell, wie beispielsweise das TRL-Verfahren, angewandt werden. Verfahren, wie etwa die TRL-Kalibrierung, führen auf die dafür notwendigen Größen. Der Name dieser Methode leitet sich von den drei Kalibrierstandards Durchverbindung (thru), nicht angepasster Abschluss (reflect) sowie einer Verzögerungsleitung (line) ab. Der Reflexionsfaktor des Reflect-Standards muss hierbei nicht bekannt, jedoch verschieden von Null sein. Hierfür wird ein Eintorstandard verwendet, für dessen Transmission also $S_{21} = S_{12} = 0$ gilt (EUL, H.-J. ; SCHIEK, B.: "A generalized theory and new calibration procedures for network analyzer self-calibration", In: Microwave Theory and Techniques, IEEE Transactions on 39 (1991), Apr, Nr. 4, S. 724-731, http://dx.doi.org/10.1109/22.76439 - DOI 10.1109/22.76439 - ISSN 0018-9480). Die Phase der Reflexion muss auf $\pm 90°$ genau bekannt sein und es muss der gleiche Reflect-Standard für beide Messtore 1 und 2 des VNA (Vektorieller Netzwerk Analysator) verwendet werden. Die Länge der Durchverbindung wird zu $l = 0$ angenommen. Ihre Leitungsimpedanz sollte der der Verzögerungsleitung entsprechen. Darüber hinaus ist es nicht notwendig, die exakte Länge der Verzögerungsleitung zu kennen. Ihre elektrische Länge $\varphi$ muss nur ungleich $n \cdot \frac{\lambda}{2}$ ($\lambda$ Wellenlänge) sein. Üblicherweise wird diese Bedingung noch um einen Abstand $\delta$ erweitert:

$$(n-1)\frac{\lambda}{2} + \delta < \Delta\varphi < n \cdot \frac{\lambda}{2} - \delta \qquad\qquad (10)$$

mit $\delta \geq 20°$ (ENGEN, G.F.; HOER, C.A.: Thru-Reflect-Line: An Improved Technique for Calibrating the Dual Six-Port Automatic Network Analyzer. In: Microwave Theory and Techniques, IEEE Transactions on 27 (1979), Dec, Nr. 12, S. 987-993, http://dx.doi.org/10.1109/TMTT.1979.1129778 - DOI 10.1109/TMTT. 1979.1129778 - ISSN 0018-9480).

Eigentlich gilt die Bedingung in Gleichung (10) für den Unterschied der elektrischen Länge zwischen Durchverbindung und Verzögerungsleitung. Da die erstere jedoch mit einer Länge von $l = 0$ angenommen wurde, gleicht dieser Unterschied der elektrischen Länge des Line-Standards selbst.

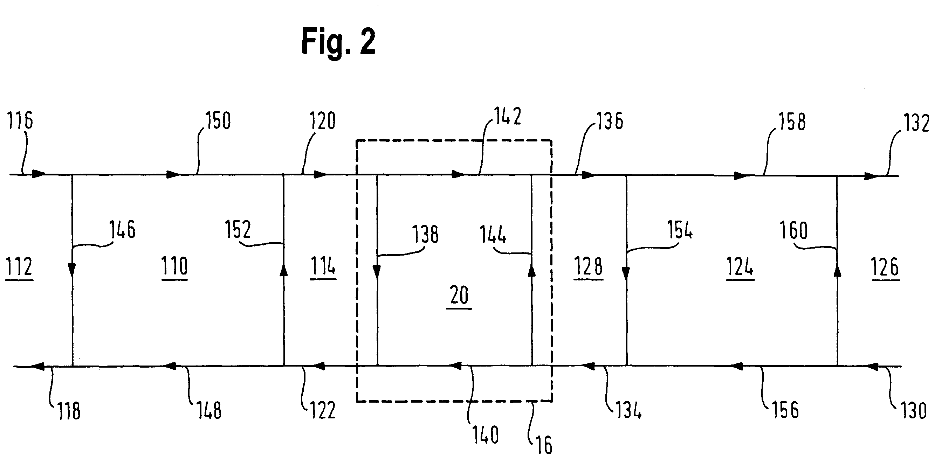

Anders als bei der Messung von Eintoren sind in diesem Fall zwei Fehlerzweitore zu bestimmen. Diese Zweitore befinden sich jeweils zwischen einem der Messtore des VNA und einem Tor des Prüflings in der Kalibrierebene, wie in Fig. 2 dargestellt. Ein erstes Fehlerzweitor 110 mit einer Fehlermatrix $X_A$ umfasst ein Tor A 112 des VNA und ein erstes Tor 114 des DUT 20 in der Kalibrierebene 16. Die an dem ersten Fehlerzweitor 110 ein- und auslaufenden elektromagnetischen Wellen haben die Wellengrößen $a_I$ 116, $b_I$ 118, $a_{DUT,1}$ 120, und $b_{DUT,1}$ 122, wobei jeweils $a_I$ 116 die an dem Tor A 112 des VNA auslaufende Welle, $b_I$ 118 die an dem Tor A 112 des VNA einlaufende Welle, $a_{DUT,1}$ 120 die an dem ersten Tor 114 des DUT 20 in der Kalibrierebene 16 einlaufende Welle und $b_{DUT,1}$ 122 die an dem ersten Tor 114 des DUT 20 in der Kalibrierebene 16 auslaufende Welle beschreibt.

Ein zweites Fehlerzweitor 124 mit einer Fehlermatrix $X_B$ umfasst ein Tor B 126 des VNA und ein zweites Tor 128 des DUT 20 in der Kalibrierebene 16. Die an dem zweiten Fehlerzweitor 124 ein- und auslaufenden elektromagnetischen Wellen haben die Wellengrößen $a_{II}$ 130, $b_{II}$ 132, $a_{DUT,2}$ 134, und $b_{DUT,2}$ 136, wobei jeweils $a_{II}$ 130 die an dem Tor B 126 des VNA auslaufende Welle, $b_{II}$ 132 die an dem Tor B 126 des VNA einlaufende Welle, $a_{DUT,2}$ 134 die an dem zweiten Tor 128 des DUT 20 in der Kalibrierebene 16 einlaufende Welle und $b_{DUT,2}$ 136 die an dem zweiten Tor 128 des DUT 20 in der Kalibrierebene 16 auslaufende Welle beschreibt.

$S_{DUT}$ mit den Matrixtermen $S_{11,DUT}$ 138, $S_{12,DUT}$ 140, $S_{21,DUT}$ 142 und $S_{22,DUT}$ 144 beschreibt hierbei die Streumatrix des Prüflings (DUT) 20 in der Kalibrierebene 16.

$$S_{DUT} = \begin{bmatrix} S_{11,DUT} & S_{12,DUT} \\ S_{21,DUT} & S_{22,DUT} \end{bmatrix} \qquad (11)$$

$$\begin{pmatrix} b_{DUT,1} \\ b_{DUT,2} \end{pmatrix} = S_{DUT} \begin{pmatrix} a_{DUT,1} \\ a_{DUT,2} \end{pmatrix} \qquad (12)$$

Die Fehlermatrix $X_A$ umfasst die Matrixterme $x_{00}$ 146, $x_{01}$ 148, $x_{10}$ 150 und $x_{11}$ 152.

$$X_A = \begin{bmatrix} x_{00} & x_{01} \\ x_{10} & x_{11} \end{bmatrix} \qquad (13)$$

$$\begin{pmatrix} b_I \\ a_{DUT,1} \end{pmatrix} = X_A \begin{pmatrix} a_I \\ b_{DUT,1} \end{pmatrix} \qquad (14)$$

Die Fehlermatrix $X_B$ umfasst die Matrixterme $x_{22}$ 154, $x_{23}$ 156, $x_{32}$ 158 und $x_{33}$ 160.

$$X_B = \begin{bmatrix} x_{22} & x_{23} \\ x_{32} & x_{33} \end{bmatrix} \qquad (15)$$

$$\begin{pmatrix} a_{DUT,2} \\ b_{II} \end{pmatrix} = X_B \begin{pmatrix} b_{DUT,2} \\ a_{II} \end{pmatrix} \qquad (16)$$

Nachfolgend wird erläutert, wie man mittels eines TRL-Verfahrens bzw. eines TRL-Algorithmus die Matrixterme der Fehlermatrizen $X_A$ und $X_B$ aus Messungen mit Kalibrierstandards bestimmt. Diese Erläuterung orientiert sich an ENGEN, G.F.; HOER, C.A.: "Thru-Reflect-Line: An Improved Technique for Calibrating the Dual Six-Port Automatic Network Analyzer", IEEE Transactions Microwave Theory and Techniques, Vol. MTT-27, No. 12, Dezember 1979.

Beschreibt man die einzelnen Blöcke $X_A$, $X_B$ und $S_{DUT}$ durch ihre entsprechenden Transmissionsmatrizen $T_A$, $T_B$ und $T_{DUT}$, so lassen sich die gemessenen Beziehungen der Wellengrößen $a_I$ 116, $b_I$ 118, $a_{II}$ 130, $b_{II}$ 132 zueinander durch die Messmatrix $T_M$ mit

$$\begin{pmatrix} a_I \\ b_I \end{pmatrix} = T_M \begin{pmatrix} a_{II} \\ b_{II} \end{pmatrix} \qquad (17)$$

$$T_M = T_A T_{DUT} T_B \qquad (18)$$

beschreiben. Die gesuchte Transmissionsmatrix des Prüflings (DUT) lässt sich nach Umstellung durch

$$T_{DUT} = T_A^{-1} T_M T_B^{-1} \qquad (19)$$

ausdrücken. Schreibt man $T_A$ als

$$T_A = \begin{bmatrix} r_{11} & r_{12} \\ r_{21} & r_{22} \end{bmatrix} = r_{22} \begin{bmatrix} a & b \\ c & 1 \end{bmatrix} \qquad (20)$$

und $T_B$ als

$$T_B = \begin{bmatrix} \rho_{11} & \rho_{12} \\ \rho_{21} & \rho_{22} \end{bmatrix} = \rho_{22} \begin{bmatrix} \alpha & \beta \\ \gamma & 1 \end{bmatrix} \qquad (21)$$

so ergeben sich deren Inverse zu

$$T_A^{-1} = \frac{1}{r_{22}} \frac{1}{a-bc} \begin{bmatrix} 1 & -b \\ -c & a \end{bmatrix} \qquad (22)$$

$$T_B^{-1} = \frac{1}{\rho_{22}} \frac{1}{\alpha-\beta\gamma} \begin{bmatrix} 1 & -\beta \\ -\gamma & \alpha \end{bmatrix} \qquad (23)$$

Setzt man nun (22) und (23) in (19) ein, so erhält man mit

$$T_{DUT} = \frac{1}{r_{22}\rho_{22}} \frac{1}{a\alpha} \frac{1}{1-b\frac{c}{a}} \frac{1}{1-\gamma\frac{\beta}{\alpha}} \begin{bmatrix} 1 & -b \\ -c & a \end{bmatrix} T_M \begin{bmatrix} 1 & -\beta \\ -\gamma & \alpha \end{bmatrix} \qquad (24)$$

die gesuchte, um die Systemfehler bereinigte Transmissionsmatrix des DUT (ENGEN, G.F.; HOER, C.A.: "Thru-Reflect-Line: An Improved Technique for Calibrating the Dual Six-Port Automatic Network Analyzer", IEEE Transactions Microwave Theory and Techniques, Vol. MTT-27, No. 12, Dezember 1979). Sind die sieben Größen $a$, $b$, $c$, $\alpha$, $\beta$, $\gamma$ und $r_{22}\rho_{22}$ aus (24) bekannt, so lassen sich zunächst die Matrixelemente der Fehlermatrizen $X_A$ und $X_B$ der beiden Fehlerzweitore bis auf das Produkt $x_{01}x_{10}$ bzw. $x_{32}x_{23}$ bestimmen und daraus letztlich auch die Matrix $T_{DUT}$.
Um diese sieben Elemente zu erhalten, werden zunächst die gemessene Transmissionsmatrix $T_M = T_T$ der Messung mit dem Kalibrierstandard "thru"

$$T_T = T_A T_B = g \begin{bmatrix} d & e \\ f & 1 \end{bmatrix} \qquad (25)$$

sowie die gemessene Transmissionsmatrix $T_M = T_D$ der Messung mit dem Kalibrierstandard "line"

$$T_D = T_A T_L T_B \qquad (26)$$

wobei $T_L$ die Transmissionsmatrix $T_{DUT,D}$ des Kalibrierstandards "line" in der Kalibrierebene ist, mit

$$T_{DUT,D} = T_L = \begin{bmatrix} e^{-\overline{\gamma}l} & 0 \\ 0 & e^{+\overline{\gamma}l} \end{bmatrix} \tag{27}$$

definiert, wobei $l$ die tatsächliche, physikalische Länge der Leitung und $\overline{\gamma}$ die Ausbreitungskonstante mit $\overline{\gamma} = \overline{\alpha} + j\overline{\beta}$ ist, wobei $\overline{\alpha}$ eine Dämpfungskonstante und $\overline{\beta}$ eine Phasenkonstante ist. Die Transmissionsmatrix $T_T$ stellt hierbei die bei Verwendung des Kalibrierstandards "thru" gemessene Matrix dar, da die Durchverbindung mit einer Länge $l = 0$ angenommen wurde. Für den Kalibrierstandard "line" gilt dies nicht, weswegen $T_L$ für dessen wahre Matrix in der Kalibrierebene und $T_D$ für die bei diesem Kalibrierstandard "line" an dem Messtor A 112 des VNA und Messtor B 126 des VNA gemessene Transmissionsmatrix steht. Stellt man (25) zu

$$T_B = T_A^{-1}T_T \tag{28}$$

um und setzt (28) in (26) ein, so erhält man

$$T_D = T_A T_L T_A^{-1} T_T \tag{29}$$

Dies lässt sich umstellen zu

$$T_D T_T^{-1} T_A = T_A T_L \tag{30}$$

Definiert man die durch Messung mit den Kalibrierstandards "thru" und "line" bestimmbare Matrix

$$T_{DT} = T_D T_T^{-1} = \begin{bmatrix} t_{11} & t_{12} \\ t_{21} & t_{22} \end{bmatrix} \tag{31}$$

und setzt (31) in (30) ein, ergibt sich

$$T_{DT}T_A = T_A T_L \tag{32}$$

Mit der Definition von $T_A$ aus (20) lässt sich (32) folgendermaßen schreiben:

$$\begin{bmatrix} t_{11} & t_{12} \\ t_{21} & t_{22} \end{bmatrix}\begin{bmatrix} a & b \\ c & 1 \end{bmatrix} = \begin{bmatrix} a & b \\ c & 1 \end{bmatrix}\begin{bmatrix} e^{-\overline{\gamma}l} & 0 \\ 0 & e^{+\overline{\gamma}l} \end{bmatrix} \tag{33}$$

Die vier Gleichungen, die in diesem System enthalten sind, lauten ausgeschrieben:

$$t_{11}a + t_{12}c = ae^{-\overline{\gamma}l} \tag{34}$$

$$t_{21}a + t_{22}c = ce^{-\overline{\gamma}l} \tag{35}$$

$$t_{11}b + t_{12} = be^{+\overline{\gamma}l} \tag{36}$$

$$t_{21}b + t_{22} = e^{+\overline{\gamma}l} \tag{37}$$

Nun kann (34) durch (35) dividiert werden und es ergibt sich eine quadratische Gleichung für $\frac{a}{c}$:

$$t_{21}\left(\frac{a}{c}\right)^2 + (t_{22} - t_{11})\left(\frac{a}{c}\right) - t_{12} = 0 \qquad (38)$$

Analog erhält man bei Division von (36) durch (37)

$$t_{21}b^2 + (t_{22} - t_{11})b - t_{12} = 0 \qquad (39)$$

Folglich sind $\frac{a}{c}$ und $b$ die zwei Lösungen der gleichen quadratischen Gleichung. Die Schwierigkeit bei der Lösung der quadratischen Gleichung aus (38) und (39) besteht nun darin, eine korrekte Zuordnung der Lösungen $\frac{a}{c}$ und $b$ zu treffen. Zunächst kann durch den Quotienten aus (37) und (35)

$$e^{2\overline{\gamma}l} = \frac{t_{21}b + t_{22}}{t_{21}\frac{a}{c} + t_{22}} \qquad (40)$$

gezeigt werden, dass die beiden Terme $\frac{a}{c}$ und $b$ nie identisch sind, da der Term $e^{2\overline{\gamma}l}$ immer ungleich 1 bleibt, was durch die Bedingung in (10) gewährleistet wird. Verdeutlicht man sich, dass $b = x_{00}$ und

$$\frac{a}{c} = x_{00} - \frac{x_{01}x_{10}}{x_{11}} \qquad (41)$$

gilt, was aus der Definition der Transformation von Streu- zu Transmissionsmatrix folgt, und dass man in realistischen Fällen $|x_{00}|, |x_{11}| \ll 1$ annehmen kann, so folgt daraus

$$|b| \ll \left|\frac{a}{c}\right| \qquad (42)$$

wodurch eine Zuordnung der Lösungen der quadratischen Gleichung möglich wird.
Mit einem Gleichungssystem mit vier Gleichungen können maximal vier Unbekannte bestimmt werden. Es wird die Determinante von (32) gebildet:

$$\det(T_{DT})\det(T_A) = \det(T_A)\det(T_L) \qquad (43)$$

Der Ausdruck $\det(T_A)$ lässt sich auf beiden Gleichungsseiten kürzen. Da für $\det(T_L)$ gilt

$$\det(T_L) = e^{-\overline{\gamma}l} \cdot e^{+\overline{\gamma}l} - 0 \cdot 0 = 1 \qquad (44)$$

führt dies nach Einsetzen in (43) auf

$$t_{11}t_{22} - t_{12}t_{21} = 1 \qquad (45)$$

Diese Gleichung zeigt, dass von den vier Messwerten $t_{xy}$ nur drei unabhängig voneinander sein können um die Gleichung erfüllen zu können. Somit existieren auch nur drei unabhängige Größen ($b$, $\frac{a}{c}$ und $e^{2\bar{\gamma}}$), da von den Gleichungen (34) bis (37) nur drei Gleichungen unabhängig voneinander sind. Diese Größen sind bereits bestimmt.

Um die weiteren, erforderlichen Unbekannten zu bestimmen wird nun (25) näher untersucht. Diese lässt sich als

$$g \begin{bmatrix} d & e \\ f & 1 \end{bmatrix} = r_{22}\rho_{22} \begin{bmatrix} a & b \\ c & 1 \end{bmatrix} \begin{bmatrix} \alpha & \beta \\ \gamma & 1 \end{bmatrix} \qquad (46)$$

schreiben. Wird die Inverse

$$\begin{bmatrix} a & b \\ c & 1 \end{bmatrix}^{-1} = \frac{1}{a-bc} \begin{bmatrix} 1 & -b \\ -c & a \end{bmatrix} \qquad (47)$$

von links an (46) multipliziert, ergibt sich

$$r_{22}\rho_{22} \begin{bmatrix} \alpha & \beta \\ \gamma & 1 \end{bmatrix} = \frac{g}{a-bc} \begin{bmatrix} 1 & -b \\ -c & a \end{bmatrix} \begin{bmatrix} d & e \\ f & 1 \end{bmatrix} \qquad (48)$$

was sich weiter zu

$$r_{22}\rho_{22} \begin{bmatrix} \alpha & \beta \\ \gamma & 1 \end{bmatrix} = \frac{g}{a-bc} \begin{bmatrix} d-gf & e-b \\ af-cd & a-ce \end{bmatrix} \qquad (49)$$

umformen lässt. Hieraus lassen sich wiederum

$$r_{22}\rho_{22} = g\frac{a-ce}{a-bc} = g\frac{1-e\frac{c}{a}}{1-b\frac{c}{a}} \qquad (50)$$

und

$$\begin{bmatrix} \alpha & \beta \\ \gamma & 1 \end{bmatrix} = \frac{1}{a-ce} \begin{bmatrix} d-bf & e-b \\ af-cd & a-ce \end{bmatrix} \qquad (51)$$

extrahieren. $r_{22}\rho_{22}$ ist eine weitere der gesuchten sieben Größen. Drei weitere Größen lassen sich durch (51) bestimmen

$$\gamma = \frac{f-\frac{c}{a}d}{1-\frac{c}{a}e} \qquad (52)$$

$$\frac{\beta}{\alpha} = \frac{e-b}{d-bf} \qquad (53)$$

$$\alpha a = \frac{d-bf}{1-\frac{c}{a}e} \qquad (54)$$

Um die isolierte Größe a bestimmen zu können, sind weitere Schritte notwendig. An dieser Stelle werden nun die Ergebnisse der Messung mit dem Kalibrierstandard "reflect" verwendet. Es werden zwei Messgrößen $w_1$ und $w_2$ definiert, die die Messungen des transmissionsfreien Kalibrierstandard "reflect" mit seinem Reflexionsfaktor $\Gamma_R$ durch die Fehlerzweitore $\mathbf{E_A}$ und $\mathbf{E_B}$ beschreiben. Diese sind durch die Wellengrößen $a_I$ 116, $b_I$ 118, $a_{II}$ 130, $b_{II}$ 132 an den Messtoren A 112 und B 126 des VNA jeweils für den Fall der Messung mit dem Kalibrierstandard "reflect" gegeben.

$$w_1 = \frac{b_I}{a_I} = \frac{a\Gamma_R + b}{c\Gamma_R + 1} \qquad (55)$$

$$w_2 = \frac{b_{II}}{a_{II}} = \frac{\alpha\Gamma_R - \gamma}{\beta\Gamma_R - 1} \qquad (56)$$

Der Einfachheit halber wird hier der Ausdruck $\Gamma_R$ verwendet. Er entspricht $S_{11,\text{OUT}}$ für die Reflexionsmessung durch das Fehlerzweitor 110 mit der Fehlermatrix $\boldsymbol{X_A}$, beziehungsweise $S_{22,\text{DUT}}$ bei der Messung durch das Fehlerzweitor 124 mit der Fehlermatrix $\boldsymbol{X_B}$, da diese beiden Reflexionen, wie weiter oben erwähnt, per Definition identisch sein müssen.

Da die Größen $b$, $\frac{a}{c}$, $\gamma$ und $\frac{\beta}{\alpha}$ bekannt sind, lassen sich diese Gleichungen zu

$$a = \frac{w_1 - b}{\Gamma_R(1 - w_1\frac{c}{a})} \qquad (57)$$

$$\alpha = \frac{w_2 + \gamma}{\Gamma_R(1 + w_2\frac{\beta}{\alpha})} \qquad (58)$$

umstellen. Nun wird (57) durch (58) dividiert, so dass sich

$$\frac{a}{\alpha} = \frac{w_1 - b}{w_2 + \gamma}\frac{1 + w_2\frac{\beta}{\alpha}}{1 - w_1\frac{c}{a}} \qquad (59)$$

ergibt. Dieses Ergebnis wird mit (54) multipliziert, was auf die Gleichung

$$a^2 = \frac{w_1 - b}{w_2 + \gamma}\frac{1 + w_2\frac{\beta}{\alpha}}{1 - w_1\frac{c}{a}}\frac{d - bf}{1 - \frac{c}{a}e} \qquad (60)$$

führt. Zieht man hieraus die Wurzel, ist schließlich ein Ausdruck für $a$ gefunden.

$$a = \pm\sqrt{\frac{w_1 - b}{w_2 + \gamma}\frac{1 + w_2\frac{\beta}{\alpha}}{1 - w_1\frac{c}{a}}\frac{d - bf}{1 - \frac{c}{a}e}} \qquad (61)$$

Ist das Vorzeichen des Reflexionsfaktors des Kalibrierstandards "reflect" bekannt, was zu Beginn vorausgesetzt wurde, so kann über den Ausdruck

$$\Gamma_R = \frac{w_1 - b}{a\left(1 - w_1\frac{c}{a}\right)} \qquad (62)$$

auch das Vorzeichen von $a$ bestimmt werden und die Kalibrierung ist abgeschlossen, da dadurch alle sieben Größen aus (24) bestimmt werden können. Da die Vorfaktoren $r_{22}$ und $\rho_{22}$ der Matrizen $\boldsymbol{T_A}$ und $\boldsymbol{T_B}$ in diesen Berechnungen nur als Produkt bestimmt werden können (siehe (50)), besteht weiterhin eine Unsicherheit bezüglich derer Auftrennung. Für die klassische TRL-Kalibrierung stellt dies kein Problem dar, da dort nur relative Größen (Streuparameter) bestimmt werden sollen. In diesem Fall kann das Produkt $r_{22}\rho_{22}$ beliebig aufgeteilt werden, da in (24) zur Bestimmung von $\boldsymbol{T_{DUT}}$

nur das Produkt beider Größen relevant ist. Möchte man die Streumatrix bestimmen, so stellt man fest, dass sich der Vorfaktor einer Transmissionsmatrix bei ihrer entsprechenden Transformation automatisch herauskürzt (SCHIEK, Burkhard, "Grundlagen der Hochfrequenz-Messtechnik", 1. Aufl., Springer-Verlag, 1999). Betrachtet man die Fehlermatrizen, so lassen sich dort aufgrund der eben genannten Unsicherheit letztlich nur die sechs Größen $x_{00}$, $x_{01}{\cdot}x_{10}$, $x_{11}$, $x_{22}$, $x_{23}{\cdot}x_{32}$ und $x_{33}$ bestimmen. Um die beiden Produkte $x_{01}{\cdot}x_{10}$, und $x_{23}{\cdot}x_{32}$ und auftrennen und somit auch absolute Größen, wie Strom und Spannung in der Kalibrierebene berechnen zu können, muss das Verfahren erweitert werden. Eine solche, zur Vermessung nichtlinearer Bauteile unabdingbare, erfindungsgemäße Erweiterung des TRL-Verfahrens wird nachfolgend näher beschrieben.

Zur Erfassung elektrischer Größen stehen Messverfahren im Zeitbereich und solche im Frequenzbereich zur Verfügung. Ein Vorteil der Messung im Zeitbereich ist die gleichzeitige Erfassung aller spektralen Anteile. Die Phaseninformation aller Spektralkomponenten bleibt somit erhalten, wodurch auch die Messung multifrequenter, nicht-periodischer Signale erleichtert wird. Die Messdynamik wird hierbei allerdings durch die zu verwendenden Oszilloskope beschränkt. Messungen im Frequenzbereich sind in diesem Punkt aufgrund der hohen Dynamik z.B. von Netzwerkanalysatoren den Zeitbereichsmessungen überlegen.

Sowohl bei der Messung im Zeitbereich als auch im Frequenzbereich ist eine Kalibrierung notwendig, um auftretende Systemfehler berechnen und die Messergebnisse um diese korrigieren zu können. Mit der zuvor beschriebenen TRL-Kalibrierung können aus den Matrizen in (13) und (15) nur die Produkte $x_{01}x_{10}$ bzw. $x_{32}x_{23}$ bestimmen korrekt berechnet werden. Dieses TRL-Kalibrierverfahren eignet sich daher nur für die Bestimmung relativer Größen (Streuparameter).

Um jedoch keine Verhältnisse sondern absolute Größen (hin- und rücklaufende Welle bzw. Strom und Spannung) bestimmen zu können, was für die Modellierung nichtlinearer Bauteile notwendig ist, wird das zuvor erläuterte TRL-Kalibrierverfahren erfindungsgemäß erweitert. Die genannten Produkte werden in ihre Einzelfaktoren zerlegt. Ein erfindungsgemäßes Verfahren, anhand dessen alle einzelnen Elemente der Fehlerzweitore $E_A$ und $E_B$ bestimmt werden können, wird im Folgenden vorgestellt. Wie damit letztlich aus Messungen im Zeitbereich die absoluten Wellengrößen, sowie Strom und Spannung, in der Kalibrierebene berechnet werden, wird ebenfalls erläutert.

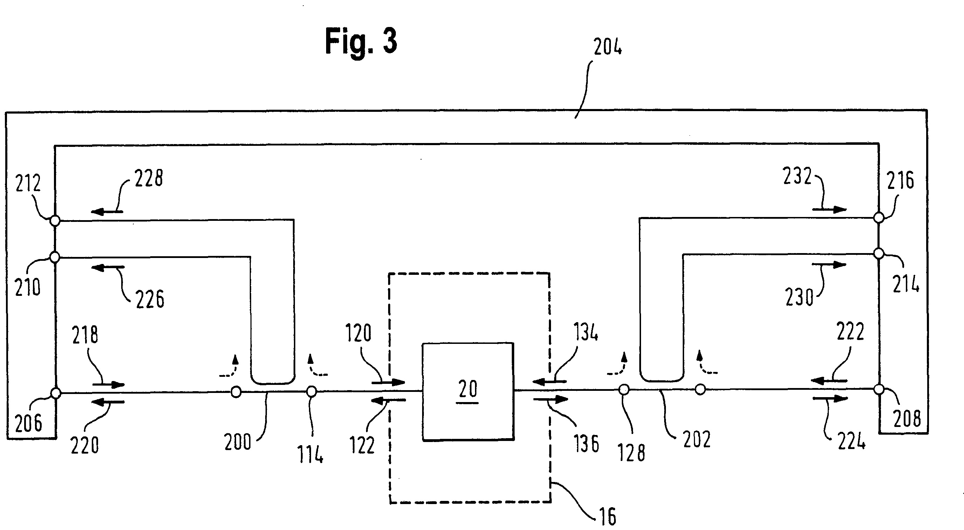

Auf Grundlage der zuvor anhand der Gleichungen (10) bis (62) erläuterten, bekannten TRL-Kalibrierung (TRL-Kalibrierverfahren) wird ein erfindungsgemäßes Kalibrierverfahren vorgeschlagen, das die absoluten Wellengrößen in der Kalibrierebene 16 bestimmen kann. Das erfindungsgemäße Verfahren beruht auf dem Aufbau einer Messvorrichtung, der in Fig. 3 dargestellt ist. In Fig. 3 sind funktionsgleiche Teile mit gleichen Bezugszeichen bezeichnet, wie in Fig. 2, so dass zu deren Erläuterung auf die obige Beschreibung der Fig. 2 verwiesen wird. Das DUT 20 ist in der Kalibrierebene 16 angeordnet und weist in der Kalibriereben 16 das erste Tor 114 und das zweite Tor 128 auf. Am ersten Tor 114 des DUT 20 in der Kalibrierebene 16 läuft eine Welle mit der Wellengröße $a_{DUT,1}$ 120 ein und eine Welle mit der Wellengröße $b_{DUT,1}$ 122 aus. Am zweiten Tor 128 des DUT 20 in der Kalibrierebene 20 läuft eine Welle mit der Wellengröße $a_{DUT,2}$ 134 ein und eine Welle mit der Wellengröße $b_{DUT,2}$ 136 aus.

Die Messvorrichtung umfasst einen ersten Richtkoppler 200 und einen zweiten Richtkoppler 202. Zum Kalibrieren dieser Messvorrichtung ist ein vektorieller Netzwerkanalysator (VNA) 204 vorgesehen, der ein ersten Messtor 206, ein zweites Messtor 208, ein drittes Messtor 210, ein viertes Messtor 212, ein fünftes Messtor 214 und ein sechstes Messtor 216 aufweist. Der erste Richtkoppler 200 ist über einen jeweiligen Wellenleiter für elektromagnetische Wellen jeweils mit dem ersten Tor 114 des DUT 20 in der Kalibrierebene 16 und mit dem ersten Messtor 206 des VNA verbunden. Der zweite Richtkoppler 202 ist über einen jeweiligen Wellenleiter für elektromagnetische Wellen jeweils mit dem zweiten Tor 128 des DUT 20 in der Kalibrierebene 16 und mit dem zweiten Messtor 208 des VNA 204 verbunden. Am ersten Messtor 206 des VNA 204 läuft eine Welle mit der Wellengröße $a_1$ 218 aus und eine Welle mit der Wellengröße $b_1$ 220 ein. Am zweiten Messtor 208 des VNA 204 läuft eine Welle mit der Wellengröße $a_2$ 222 aus und eine Welle mit der Wellengröße $b_2$ 224 ein.

Der erste Richtkoppler 200 koppelt einen Anteil der Welle $a_1$ 218 aus und führt die ausgekoppelte Welle dem dritten Messtor 210 des VNA 204 als eine Welle mit der Wellengröße $a_{Mess,1}$ 226 zu. Weiterhin koppelt der erste Richtkoppler 200 einen Anteil der Welle $b_1$ 220 aus und führt die ausgekoppelte Welle dem vierten Messtor 212 des VNA 204 als eine Welle mit der Wellengröße $b_{Mess,1}$ 228 zu.

Der zweite Richtkoppler 202 koppelt einen Anteil der Welle $a_2$ 222 aus und führt die ausgekoppelte Welle dem fünften Messtor 214 des VNA 204 als eine Welle mit der Wellengröße $a_{Mess,2}$ 230 zu. Weiterhin koppelt der zweite Richtkoppler 202 einen Anteil der Welle $b_2$ 224 aus und führt die ausgekoppelte Welle dem sechsten Messtor 216 des VNA 204 als eine Welle mit der Wellengröße $b_{Mess,2}$ 232 zu.

Diese Messvorrichtung weist nun vier Fehlerzweitore auf, deren Fehlermatrizen $X_A$ und $X_B$ durch eine Kalibrierung zu bestimmen sind. In Bezug auf Fig. 2 wurden bereits ein Paar von Fehlerzweitoren beidseitig der Kalibrierebene 16 beschrieben. Ein Paar von derartigen, in Fig. 2 dargestellten Fehlerzweitoren befinden sich zwischen der Kalibrierebene 16 einerseits und dem ersten und zweiten Messtor 206, 208 des VNA 204 andererseits. Ein weiteres Paar von derartigen, in Fig. 2 dargestellten Fehlerzweitoren befindet sich zwischen der Kalibrierebene 16 einerseits und dem dritten/vierten sowie fünften/sechsten Messtor 210/212, 214/216 andererseits. Für diese vier zu betrachtenden Fehlerzweitore gilt:

Erstes Paar von Fehlerzweitoren zwischen dem DUT 20 und dem ersten und zweiten Messtor 206, 208 des VNA:

Messtor A 112 entspricht dem ersten Messtor 206 des VNA 204 und Messtor B 126 entspricht dem zweiten Messtor 208 des VNA 204, wobei $X_A$ die Fehlermatrix $I_A$ mit den Matrixtermen $x_{00} = i_{00}$, $x_{01} = i_{01}$, $x_{10} = i_{10}$, $x_{11} = i_{11}$ und $X_B$ die Fehlermatrix $I_B$ mit den Matrixtermen $x_{22} = i_{22}$, $x_{23} = i_{23}$, $x_{32} = i_{32}$, $x_{33} = i_{33}$ ist. Ferner gilt $a_I$ 116 entspricht $a_1$ 218, $b_I$ 118 entspricht $b_1$ 220, $a_{II}$ 130 entspricht $a_2$ 222 und $b_{II}$ 132 entspricht $b_2$ 224. Weiterhin gilt für dieses erste Paar von Fehlerzweitoren:

$$\begin{bmatrix} b_1 \\ a_{DUT,1} \end{bmatrix} = I_A \begin{bmatrix} a_1 \\ b_{DUT,1} \end{bmatrix} \tag{63}$$

$$I_A = \begin{bmatrix} i_{00} & i_{01} \\ i_{10} & i_{11} \end{bmatrix} \tag{64}$$

$$\begin{bmatrix} a_{DUT,2} \\ b_2 \end{bmatrix} = I_B \begin{bmatrix} b_{DUT,2} \\ a_2 \end{bmatrix} \tag{65}$$

$$I_B = \begin{bmatrix} i_{22} & i_{23} \\ i_{32} & i_{33} \end{bmatrix} \tag{66}$$

Zweites Paar von Fehlerzweitoren zwischen dem DUT 20 und dem dritten/vierten sowie dem fünften/sechsten Messtor 210/212, 214/216 des VNA:

Das Messtor A 112 entspricht dem dritten/vierten Messtor 210/212 des VNA 204 und das Messtor B 126 entspricht dem fünften/sechsten Messtor 214/216 des VNA 205, wobei $X_A$ die Fehlermatrix $E_A$ mit den Matrixtermen $x_{00} = e_{00}$, $x_{01} = e_{01}$, $x_{10} = e_{10}$, $x_{11} = e_{11}$ und $X_B$ die Fehlermatrix $E_B$ mit den Matrixtermen $x_{22} = e_{22}$, $x_{23} = e_{23}$, $x_{32} = e_{32}$, $x_{33} = e_{33}$ ist. Ferner gilt $a_I$ 116 entspricht $a_{Mess,1}$ 226, $b_I$ 118 entspricht $b_{mess,1}$ 228, $a_{II}$ 130 entspricht $a_{Mess,2}$ 230 und $b_{II}$ 132 entspricht $b_{Mess,2}$ 232. Weiterhin gilt für dieses zweite Paar von Fehlerzweitoren:

$$\begin{bmatrix} b_{Mess,1} \\ a_{DUT,1} \end{bmatrix} = E_A \begin{bmatrix} a_{Mess,1} \\ b_{DUT,1} \end{bmatrix} \tag{67}$$

mit

$$E_A = \begin{bmatrix} e_{00} & e_{01} \\ e_{10} & e_{11} \end{bmatrix} \tag{68}$$

und

$$\begin{bmatrix} a_{DUT,2} \\ B_{Mess,2} \end{bmatrix} = E_B \begin{bmatrix} b_{DUT,2} \\ a_{Mess,2} \end{bmatrix} \tag{69}$$

mit

$$E_B = \begin{bmatrix} e_{22} & e_{23} \\ e_{32} & e_{33} \end{bmatrix} \tag{70}$$

Es ergeben sich somit zwei Signalflussgraphen analog zu Fig. 2.

Fig. 3 zeigt die gesuchten Wellengrößen $a_{DUT,1}$ 120 und $b_{DUT,1}$ 122 (die Wellengrößen der hin- und rücklaufenden Wellen linksseitig des DUT 20, d.h. am ersten Tor 114 des DUT 20 in der Kalibrierebene 20), sowie die gesuchten Wellengrößen $a_{DUT,2}$ 134 und $b_{DUT,2}$ 136 (die Wellengrößen der hin- und rücklaufenden Wellen rechtsseitig des DUT 20, d.h. am zweiten Tor 128 des DUT 20 in der Kalibrierebene 20). Diese lassen sich mit

$$\begin{pmatrix} b_{DUT,1} \\ a_{DUT,1} \end{pmatrix} = \boldsymbol{T}_A^{-1} \begin{pmatrix} b_{Mess,1} \\ a_{Mess,1} \end{pmatrix} \qquad (71)$$

und

$$\begin{pmatrix} a_{DUT,2} \\ b_{DUT,2} \end{pmatrix} = \boldsymbol{T}_B \begin{pmatrix} a_{Mess,2} \\ b_{Mess,2} \end{pmatrix} \qquad (72)$$

für das zweite Paar von Fehlerzweitoren berechnen, sofern die Transmissionsmatrizen $\boldsymbol{T}_A$ und $\boldsymbol{T}_B$ beziehungsweise die zugehörigen Streumatrizen $\boldsymbol{E}_A$ und $\boldsymbol{E}_B$ vollständig bekannt sind.

Um die Elemente der Matrizen $\boldsymbol{I}_A$ und $\boldsymbol{I}_B$ bzw. $\boldsymbol{E}_A$ und $\boldsymbol{E}_B$ zu erhalten wird jeweils der Algorithmus der TRL-Kalibrierung, wie er anhand der Gleichungen (10) bis (62) beschrieben wurde, angewendet. Die vom VNA 204 erfassten Streuparameter für einen jeweiligen Kalibrierstandard K mit K = "reflect", "line" oder "thru" in Abhängigkeit von der Frequenz f der Wellen mit den Wellengrößen $a_1$ 218 und $b_1$ 220 werden als Streuparameter $S_{xy,K,f}$ mit x = 1, 2, 3, 4, 5 oder 6 und y = 1 oder 2 zwischen dem y-ten und dem x-ten Messtor des VNA 204 für den Kalibrierstandard K und die Frequenz f bezeichnet. Die Eingangsstreumatrix $\boldsymbol{S}_{I,K,f}$ des TRL-Algorithmus für die Berechnung von $\boldsymbol{I}_A$ und $\boldsymbol{I}_B$ lautet dann

$$\boldsymbol{S}_{I,K,f} = \begin{bmatrix} S_{11,K,f} & S_{12,K,f} \\ S_{21,K,f} & S_{22,K,f} \end{bmatrix} \qquad (73)$$

Sollen die Terme der Matrizen $\boldsymbol{E}_A$ und $\boldsymbol{E}_B$ berechnet werden, so lautet die entsprechende Streumatrix

$$\boldsymbol{S}_{unkorr,K,f} = \begin{bmatrix} S_{11,unkorr,K,f} & S_{12,unkorr,K,f} \\ S_{21,unkorr,K,f} & S_{22,unkorr,K,f} \end{bmatrix} \qquad (74)$$

mit Streuparametern $S_{11,unkorr,K,f}$, $S_{12,unkorr,K,f}$, $S_{21,unkorr,K,f}$ und $S_{22,unkorr,K,f}$ die folgendermaßen berechnet werden

$$S_{11,unkorr,K,f} = \frac{b_{Mess,1,K,f}}{a_{Mess,1,K,f}} = \frac{S_{41,K,f}}{S_{31,K,f}} = \sigma_{11} \qquad (75)$$

$$S_{21,unkorr,K,f} = \frac{b_{Mess,2,K,f}}{a_{Mess,1,K,f}} = \frac{S_{61,K,f}}{S_{31,K,f}} = \sigma_{21} \qquad (76)$$

$$S_{12,unkorr,K,f} = \frac{b_{Mess,1,K,f}}{a_{Mess,2,K,f}} = \frac{S_{42,K,f}}{S_{52,K,f}} = \sigma_{12} \qquad (77)$$

$$S_{22,unkorr,K,f} = \frac{b_{Mess,2,K,f}}{a_{Mess,2,K,f}} = \frac{S_{62,K,f}}{S_{52,K,f}} = \sigma_{22} \qquad (78)$$

Hierbei sind auch die Größen $a_{Mess,1}$ 226, $b_{mess,1}$ 228, $a_{Mess,2}$ 230 und $b_{Mess,2}$ 232 durch den Index K einem jeweiligen Kalibrierstandard K = "reflect", "line" oder "thru" zugeordnet und der Index f kennzeichnet deren Abhängigkeit von der Frequenz f der erzeugten und über die Messtore 206 und 208 eingespeisten Wellen mit den Wellengrößen $a_1$, $b_1$, $a_2$ und $b_2$. Somit werden diese gemessenen Wellengrößen $a_{Mess,1}$ 226, $b_{Mess,1}$ 228, $a_{Mess,2}$ 230 und $b_{Mess,2}$ 232 für die Kalibriermessungen zu $a_{Mess,1,K,f}$ 226, $b_{Mess,1,K,f}$ 228, $a_{Mess,2,K,f}$ 230 und $b_{Mess,2,K,f}$ 232.

Um zu verdeutlichen, wie sich die Elemente der Matrix (74) zusammensetzen sind ihre Größen in (79) noch einmal in Abhängigkeit der verschiedenen Wellengrößen angegeben (vgl. Fig. 3).

$$S_{unkorr,K,f} = \begin{bmatrix} b_{Mess,1,K,f} \cdot \dfrac{a_1}{a_1 \quad a_{Mess,1,K,f}} & b_{Mess,1,K,f} \cdot \dfrac{a_2}{a_2 \quad a_{Mess,2,K,f}} \\ b_{Mess,2,K,f} \cdot \dfrac{a_1}{a_1 \quad a_{Mess,1,K,f}} & b_{Mess,2,K,f} \cdot \dfrac{a_2}{a_2 \quad a_{Mess,2,K,f}} \end{bmatrix} = \begin{bmatrix} \dfrac{b_{Mess,1,K,f}}{a_{Mess,1,K,f}} & \dfrac{b_{Mess,1,K,f}}{a_{Mess,2,K,f}} \\ \dfrac{b_{Mess,2,K,f}}{a_{Mess,1,K,f}} & \dfrac{b_{Mess,2,K,f}}{a_{Mess,2,K,f}} \end{bmatrix} \quad (79)$$

In diesem Fall ist dies jedoch noch nicht die Eingangsgröße des TRL-Algorithmus. Zuvor wird $S_{unkorr,K,f}$, wie nachfolgend gezeigt wird, zu einer korrigierten Streumatrix $\mathbf{S_{c,K,f}}$ umgerechnet.

Sowohl $\mathbf{S_{I,K,f}}$ als auch $\mathbf{S_{unkorr,K,f}}$ existieren jeweils für jeden der drei zu vermessenden Standards, wie durch den Index K kenntlich gemacht ist.

Die TRL-Kalibrierung kann auch hier nur die Produkte $i_{01}i_{10}$ und $i_{23}i_{32}$ bzw. $e_{01}e_{10}$ und $e_{23}e_{32}$ liefern. Im weiteren Verlauf des Verfahrens ist jedoch die Kenntnis der einzelnen Faktoren bzw. der einzelnen Terme von $\mathbf{E_A}$ und $\mathbf{E_B}$ gewünscht. Um diese zu erhalten, wird ein "Umweg" über die Zerlegung der Terme aus den $\mathbf{I}$-Matrizen verwendet. Werden die Produkte $i_{01}i_{10}$ und $i_{23}i_{32}$ korrekt zerlegt, können mit Hilfe dieser Informationen auch die Terme der $\mathbf{E}$-Matrizen aufgetrennt werden.

Um diese Zerlegung der $i$-Terme durchführen zu können, wird eine besondere Eigenschaft von $\mathbf{I_A}$ und $\mathbf{I_B}$ genutzt. Im Gegensatz zu $\mathbf{E_A}$ und $\mathbf{E_B}$ beschreiben die Fehlermatrizen $\mathbf{I_A}$ und $\mathbf{I_B}$ zwei reziproke Zweitore, da sie den Zusammenhang zwischen dem ersten Messtor 206 beziehungsweise dem zweiten Messtor 208 des VNA 204 und der Kalibrierebene 16 beschreiben. Es kann daher angenommen werden, dass

$$i_{01} = i_{10} = \pm\sqrt{i_{01}i_{10}} \qquad (80)$$

und

$$i_{23} = i_{32} = \pm\sqrt{i_{23}i_{32}} \qquad (81)$$

gilt. Die korrekte Wahl des Vorzeichens entspricht der korrekten Bestimmung der

Phase der Terme. Ist bei einem Frequenzpunkt die Phase hinreichend genau bekannt, so kann sie durch stetige Ergänzung für die restlichen Punkte fehlerfrei bestimmt werden. Übersteigt die Phasendifferenz der Faktoren des Produktes $i_{01}i_{10}$ und $i_{23}i_{32}$ von einem Frequenzpunkt zum nächsten dabei einen Schwellwert so wird sie um 180° vermindert, weil davon ausgegangen wird, dass die einzelnen Frequenzschritte derart dicht genug verteilt sind, dass der Schwellwert normalerweise nicht überschritten werden dürfte. Hierbei muss sichergestellt sein, dass sich die Phase der Einzelfaktoren von Punkt zu Punkt um weniger als 90° ändert, da die Drehung um 180° sonst fälschlicherweise durchgeführt würde. Beispielsweise über die elektrische Länge zwischen einem Messtor des VNA und der Kalibrierebene 16 kann eine initiale Phasenbestimmung vorgenommen werden. Des Weiteren sollte sichergestellt werden, dass bei einer Extrapolation der Phase bis hin zur Frequenz f= 0 dort die Phase 0° beträgt.

Zur Zerlegung der e-Terme wird ein anderer Ansatz gewählt. Die Matrizen $\mathbf{E_A}$ und $\mathbf{E_B}$ beschreiben keine reziproken oder physikalisch vorhandenen Zweitore. Über verschiedene mathematische Operationen wurden diese Matrizen erzeugt, um einen Zusammenhang zwischen den Wellengrößen in der Kalibrierebene und denen an den Ausgängen der Richtkoppler 200, 202 zu beschreiben.

Die Kalibrierstandards "*reflect*" (*Reflect-Standards*) einer TRL-Kalibrierung sind Eintorstandards (EUL, H.-J. ; SCHIEK, B.: "A generalized theory and new calibration procedures for network analyzer self-calibration.", Microwave Theory and Techniques, IEEE Transactions on 39 (1991), apr, Nr. 4, S. 724 -731). Es existiert somit keine Transmission von der linken Seite des Prüflings zur rechten oder umgekehrt, d.h. $S_{21,DUT} = S_{12,DUT} = 0$. Die weitere Berechnung wird daher hier exemplarisch für die linke Seite der Messvorrichtung gemäß Fig. 3 mit dem ersten Tor 114 des DUT 20 in der Kalibrierebene 16 durchgeführt, ist aber analog auf die rechte Seite der Messvorrichtung gemäß Fig. 3 mit dem zweiten Tor 128 des DUT 20 in der Kalibrierebene 16 anzuwenden. Aus dem Signalflussdiagramm gemäß Fig. 2 mit den Definitionen für das erste und zweite Paar Fehlerzweitore, wie zuvor angegenben, lassen sich im Fall des Reflect-Standards für die Welle $a_{DUT,1}$ 120 folgende Beziehungen ableiten:

$$a_{DUT,1,reflect,f} = \frac{i_{10}a_{1,reflect,f}}{1-i_{11}S_{11,DUT,reflect,f}} \qquad (82)$$

$$a_{DUT,1,reflect,f} = \frac{e_{10} a_{Mess,1,reflect,f}}{1 - e_{11} S_{11,DUT,reflect,f}} \qquad (83)$$

Aus diesen beiden Gleichungen lässt sich nun eine Definition für $e_{10}$ herleiten:

$$e_{10} = i_{10} \frac{a_1}{a_{Mess,1,reflect,f}} \frac{1 - e_{11} S_{11,DUT,reflect,f}}{1 - i_{11} S_{11,DUT,reflect,f}} \qquad (84)$$

Dabei ist $\dfrac{a_1}{a_{Mess,1,reflect,f}}$ der Kehrwert des vom VNA 204 ermittelten Streuparameters $S_{31,K,f}$. Der Reflexionsfaktor des Reflect-Standards, $S_{11,DUT}$, kann ebenfalls mit (24) aus den bereits durch die TRL-Kalibrierung berechneten Termen bestimmt werden. Nun kann das aus der TRL-Kalibrierung gewonnene Produkt $e_{01} e_{10}$ durch das Ergebnis aus (84) dividiert werden. Damit sind alle vier Elemente der Matrix $\boldsymbol{E_A}$ bestimmt und aus $a_{Mess,1,K,f}$ 226 und $b_{Mess',1,K,f}$ 228 können nun mit (71) die Wellengrößen $a_{DUT,1}$ 120 und $b_{DUT,1}$ 122 in der Kalibrierebene 16 bestimmt werden. Wie bereits erwähnt, kann die Berechnung analog für die Messung an dem zweiten fünften und sechsten Messtor 208, 214, 216 durchgeführt werden um damit zunächst $\boldsymbol{E_B}$ und in einer Messung dann $a_{DUT,2}$ 134 und $b_{DUT,2}$ 136 zu erhalten.

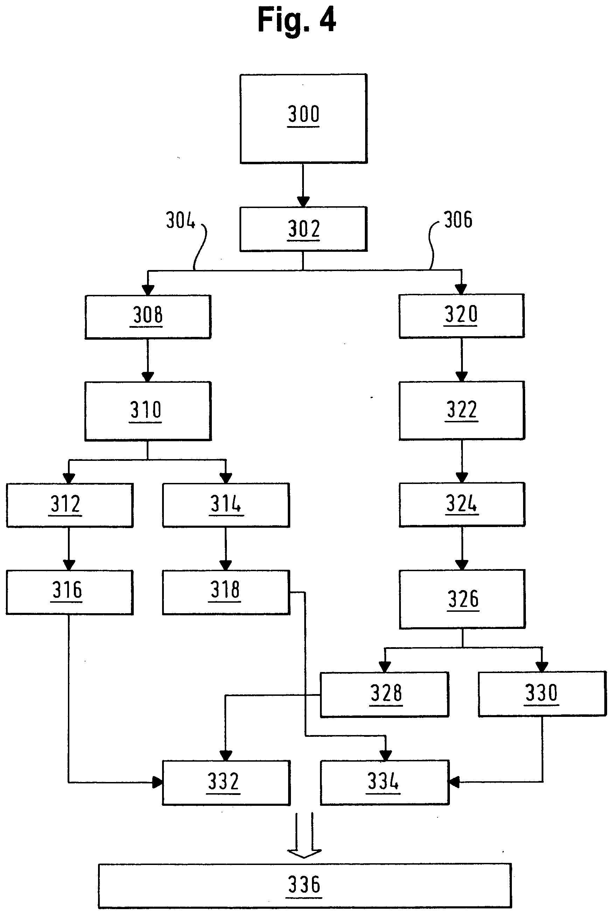

Der gesamte Ablauf des erweiterten Kalibrierverfahrens ist in Abbildung Fig. 4 noch einmal grafisch veranschaulicht. In einem Block "Messung der Standards mit VNA" 300 werden die verschiedenen Kalibrierstandards als DUT 16 in die Kalibrierebene 16 eingesetzt und die Streuparameter $S_{xy,K,f}$ mit x = 1, 2, 3, 4, 5 oder 6 und y = 1 oder 2 und K = "reflect", "line" oder "thru" bestimmt. In einem Block "$S_{xy,K,f}$" 302 stehen diese Terme zur Verfügung. Hier teilt sich das Verfahren in zwei Zweige, einem ersten Zweig 304 zum Bestimmen der Streumatrizen $\boldsymbol{I_A}$ und $\boldsymbol{I_B}$ sowie in einen zweiten Zweig 306 zum Bestimmen der Streumatrizen $\boldsymbol{E_A}$ und $\boldsymbol{E_B}$.

Im ersten Zweig 304 wird in einem Block "$\boldsymbol{S_{I,K,f}}$" 308 aus den Streuparameter $S_{xy,K,f}$ die Matrix $\boldsymbol{S_{I,K,f}}$ zusammengestellt. In einem Block "TRL-Algorithmus" 310 wird die Matrix $\boldsymbol{S_{I,K,f}}$ als Eingangswerte für einen TRL-Algorithums verwendet und mittels des TRL-Algoritmus werden die Terme $i_{00}$, $i_{01} \cdot i_{10}$ und $i_{11}$ sowie die Terme $i_{22}$, $i_{23} \cdot i_{32}$ und $i_{33}$ bestimmt. Diese stehen in Block "$\boldsymbol{I_A}$" 312 und Block "$\boldsymbol{I_B}$" 314 zur Verfügung. In einem Block "Auftrennung $i_{01} \cdot i_{10}$" 316 erfolgt die Berechnung der Einzelterme $i_{01}$ und $i_{10}$. In einem Block "Auftrennung $i_{23} \cdot i_{32}$" 318 erfolgt die Berechnung der Einzelterme $i_{23}$ und $i_{32}$. Hiermit sind dann die einzelnen Terme $i_{00}$, $i_{01}$, $i_{10}$ und $i_{11}$ sowie $i_{22}$, $i_{23}$, $i_{32}$ und $i_{33}$ der Fehlerstreumatrizen $\boldsymbol{I_A}$ und $\boldsymbol{I_B}$ vollständig bestimmt.

In dem zweiten Zweig 306 wird in Block "$\boldsymbol{S_{unkorr,K,f}}$" 320 aus den Streuparametern $S_{xy,K,f}$ die Matrix $\boldsymbol{S_{unkorr,K,f}}$ zusammengestellt. Aus dieser Streumatrix $\boldsymbol{S_{unkorr,K,f}}$ wird in einem Block "Korrektur" 322 über eine nachfolgend noch näher erläuterte Korrektur die korrigierte Streumatrix $\boldsymbol{S_{c,K,f}}$ bestimmt, die dann in Block "$\boldsymbol{S_{c,K,f}}$" 324 zur Verfügung steht. Diese korrigierte Streumatrix dient dann in Block "TRL-Algorithmus" 326 als Eingangswert für den TRL-Algorithmus, mit dem die Terme $e_{00}$, $e_{01} \cdot e_{10}$ und $e_{11}$ sowie die Terme $e_{22}$, $e_{23} \cdot e_{32}$ und $e_{33}$ der Fehlerstreumatrizen $\boldsymbol{E_A}$ und $\boldsymbol{E_B}$ bestimmt werden und in Block "$\boldsymbol{E_A}$" 328 und in Block "$\boldsymbol{E_B}$" 330 zur Verfügung stehen. In einem Block "Auftrennung $e_{01} \cdot e_{10}$" 332 erfolgt die Berechnung der Einzelterme $e_{01}$ und $e_{10}$, wobei hierfür die Ergebnisse aus Block 316, d.h. die Terme $i_{01}$ und $i_{10}$ zugeführt werden. In einem Block "Auftrennung $e_{23} \cdot e_{32}$" 334 erfolgt die Berechnung der Einzelterme $e_{23}$ und $e_{32}$, wobei hierfür die Ergebnisse aus Block 318, d.h. die Terme $i_{23}$ und $i_{32}$ zugeführt werden. Somit stehen dann in Block "Vollständig bestimmte Fehlermatrizen" 336 alle Einzelterme der vier Fehlersstreumatrizen $\boldsymbol{E_A}$ und $\boldsymbol{E_B}$ sowie $\boldsymbol{I_A}$ und $\boldsymbol{I_B}$ zur Verfügung. Die Kalibrierung ist abgeschlossen und die Einzelterme der vier Fehlersstreumatrizen $\boldsymbol{E_A}$ und $\boldsymbol{E_B}$ sowie $\boldsymbol{I_A}$ und $\boldsymbol{I_B}$ können zur Korrektur von Messergebnissen verwendet werden.

Im Hinblick auf eine reale Messung mit dem hier beschriebenen Aufbau muss mit der Herausforderung umgegangen werden, dass Netzwerkanalysatoren üblicherweise nur mit maximal vier Messtoren zur Verfügung stehen. Nach Fig. 3 werden jedoch sechs Messtore am VNA benötigt. Diese Schwierigkeit kann umgangen werden, da die Wellengrößen am dritten Messtor 210 und am vierten Messtor 212 nicht zwangsläufig zeitgleich mit denen an dem fünften und sechsten Messtor 214, 216 aufgenommen werden müssen. Zwei Messtore 206, 208 des VNA werden dabei fest an dem ersten und zweiten Tor 114, 128 des DUT 20 in der Kalibrierebene des Messaufbaus verwendet, während die übrigen zwei Messtore des VNA zur sequentiellen Messung von zunächst $a_{Mess,1}$ 226 sowie $b_{Mess,1}$ 228 und anschließend von $a_{Mess,2}$ 230 und $b_{Mess,2}$ 232 verwendet werden. Hierbei muss das jeweils nicht kontaktierte Tor der Richtkoppler 200 und 202 reflexionsfrei abgeschlossen sein, um eine Verfälschung der Ergebnisse zu vermeiden.

Nachfolgend erfolgt eine Erläuterung der Korrektur der Streumatrix $\boldsymbol{S_{unkorr,K,f}}$ zur korrigierten Streumatrix $\boldsymbol{S_{c,K,f}}$:

Bei den bisher dargelegten Rechenmethoden werden die Streuparameter unter der Bedingung verwendet, dass

$$S_{11} = \frac{b_1}{a_1}\bigg|_{a_2=0} \qquad\qquad (85)$$

Aus verschiedenen Gründen kann es jedoch vorkommen, dass $a_2$ ungleich Null ist. In so einem Fall muss der ermittelte Quotient $\frac{b_1}{a_1}$ um diesen Einfluss korrigiert werden, bevor er tatsächlich den Streuparameter $S_{11}$ darstellt.

Werden in einem Aufbau Messungen in Vorwärtsrichtung sowie auch in Rückwärtsrichtung vorgenommen, so muss die Signalquelle des verwendeten VNA 204 auf das erste Messtor 206 beziehungsweise auf das zweite Messtor 208 umgeschaltet werden. Ein Abschlusswiderstand von üblicherweise 50Ω wird mit dem jeweils nicht angeregten Tor verbunden. Es kann jedoch nicht garantiert werden, dass Quelle und Abschluss in beiden Systemzuständen eine identische Anpassung an die jeweiligen Messtore aufweisen. Da diese Störeinflüsse also klassischerweise durch das zuvor erwähnte Umschalten auftreten, werden die benötigten Korrekturfaktoren als *Switch-Terms* bezeichnet (MARKS, Roger B., "Formulations of the Basic Vector Network Analyzer Error Model including Switch-Terms", ARFTG Conference Digest-Fall, 50th Bd. 32, 1997, S. 115 -126).

Im hier vorliegenden Aufbau kommt den Switch-Terms besondere Bedeutung aufgrund der Verwendung externer Richtkoppler zu. Deren nichtideale Richtwirkung sorgt dafür, dass beispielsweise trotz einer Speisung am ersten Messtor 206 ein von Null verschiedenes $a_{Mess,2}$ 230 aufgenommen wird, selbst wenn der VNA 204 eine perfekte Anpassung am zweiten Messtor 208 aufweisen würde. Das bedeutet, dass die Messergebnisse den Anschein erwecken würden, als gäbe es in diesem Fall eine Welle, die vom zweiten Messtor 208 des VNA zum DUT 20 läuft ($a_{DUT,2}$ 134), obwohl nur eine Welle existiert, die vom DUT 20 zum zweiten Messtor 208 des VNA 204 läuft ($b_{DUT,2}$ 136). Ein Bruchteil der Welle $b_{DUT,2}$ 136 ist in diesem Fall nach der Auskopplung durch den Richtkoppler auch an dessen mit dem fünften Messtor 214 des VNA 204 verbundenen Ausgang gelaufen. Bei einem idealen Richtkoppler wäre der ausgekoppelte Teil von $b_{DUT,2}$ 136 ausschließlich zum Kopplerausgang am sechsten Messtor 216 des VNA 204 gelaufen. Die in der Realität immer auftretende Nichtidealität des Kopplers kann durch die Anwendung der *Switch*-Terms kompensiert werden.

Schreibt man (74) der Einfachheit halber allgemein als

$$S_{unkorr,K,f} = \begin{bmatrix} \sigma_{11} & \sigma_{12} \\ \sigma_{21} & \sigma_{22} \end{bmatrix} \qquad\qquad (86)$$

so ergibt sich durch die durch Anwendung der Switch-Terms korrigierte Streumatrix $\mathbf{S_{c,K,f}}$ nach MARKS, Roger B., "Formulations of the Basic Vector Network Analyzer Error Model including Switch-Terms", ARFTG Conference Digest-Fall, 50th Bd. 32, 1997, S. 115-126 zu

$$\mathbf{S_{c,K,f}} = \frac{1}{D}\begin{bmatrix} \sigma_{11} - \sigma_{12}\sigma_{21}\Gamma_{F,K,f} & \sigma_{12} - \sigma_{11}\sigma_{12}\Gamma_{R,K,f} \\ \sigma_{21} - \sigma_{22}\sigma_{21}\Gamma_{F,K,f} & \sigma_{22} - \sigma_{12}\sigma_{21}\Gamma_{R,K,f} \end{bmatrix} \qquad\qquad (87)$$

wobei $D = 1 - \sigma_{12}\sigma_{21}\Gamma_{F,k,f}\Gamma_{R,k,f}$ ist und $\Gamma_{F,K,f} = \frac{S_{51,K,f}}{S_{61,K,f}}$ das Verhältnis von am Ausgang des zweiten Richtkopplers gemessener hin- zu rücklaufender Welle bei Speisung durch das erste Messtor des VNA und $\Gamma_{R,K,f} = \frac{S_{32,K,f}}{S_{42,K,f}}$ das Verhältnis von am Ausgang des ersten Richtkopplers gemessener hin- zu rücklaufender Welle bei Speisung durch das zweite Messtor des VNA beschreibt. $S_{xy,K,f}$ steht wieder für die vom VNA 204 gemessenen Streuparameter. Durch $\Gamma_{F,K,f}$ und $\Gamma_{R,K,f}$ wird die begrenzte Richtschärfe der Richtkoppler 200, 202 ausgedrückt.

Die Korrektur muss für jeden Frequenzschritt f und für jeden Kalibrierstandard K einzeln durchgeführt werden. Bei der Berechnung der Matrizen $I_A$ und $I_B$ muss diese Korrektur nicht durchgeführt werden, da in diesem Fall der VNA 204 bereits korrekt berechnete Streuparameter ($S_{11,K,f}$, $S_{12,K,f}$, $S_{21,K,f}$, $S_{22,K,f}$) liefert.

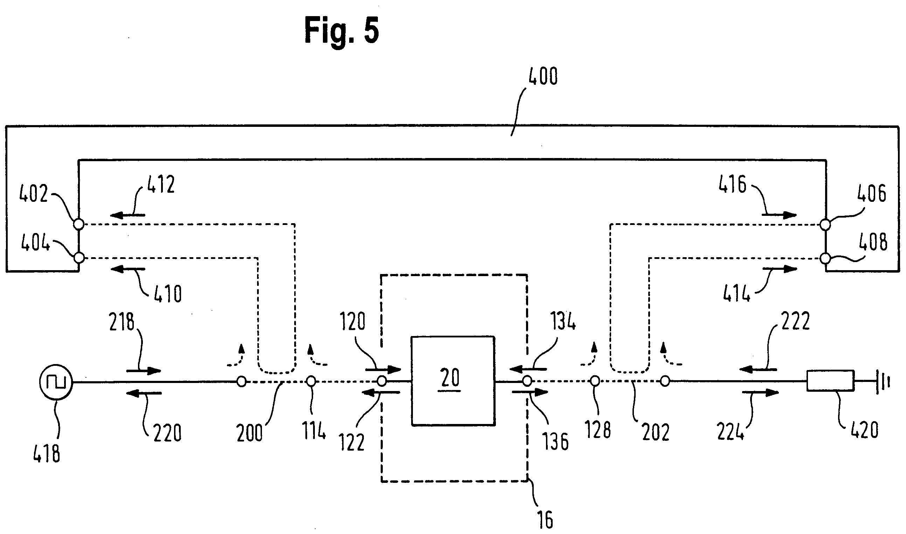

In Fig. 5 ist der zu Fig. 3 (Kalibrieraufbau) analoge Aufbau zur Messwertaufnahme im Zeitbereich dargestellt. Funktionsgleiche Teile sind mit gleichen Bezugszeichen wie in Fig. 3 bezeichnet, so dass zu deren Erläuterung auf die obige Beschreibung der Fig. 3 verwiesen wird.

Anstatt eines VNA kommt hier ein Oszilloskop 400 zum Einsatz, welches einen ersten Kanal 402, einen zweiten Kanal 404, einen dritten Kanal 406 und einen vierten Kanal 408 aufweist. Der erste und zweite Kanal 402, 404 ist jeweils mit einem Ausgang des ersten Richtkopplers 200 und der dritte und vierte Kanal 406, 408 ist jeweils mit einem Ausgang des zweiten Richtkopplers 202 verbunden. Auf diese Weise können nun die ausgekoppelten Wellen in Form von elektrischen Spannungen $v_3$ 410, $v_4$ 412, $v_5$ 414 und $v_6$ 416 jeweils an dem ersten bis vierten Kanal 402, 403, 404 und 406 erfasst werden, wie in Fig. 5 dargestellt. Eine Signalquelle 418 ist wahlweise mit dem ersten oder zweiten Richtkoppler 200, 202 verbunden und speist die Welle mit der Wellengröße $a_1$ 218 am ersten Richtkoppler 200 bzw. $a_2$ 222 am zweiten Richtkoppler 202 ein. Der jeweils andere Richtkoppler 202 bzw. 200 ist dann mit einem Abschlusswiderstand Z 420 verbunden.

Damit die Kalibrierung hierbei ihre Gültigkeit behält, dürfen sich die mit punktierter Linie dargestellten Teile des Aufbaus nach der Kalibrierung mit dem VNA 204 nicht mehr verändern. Anderenfalls würden die ermittelten Fehlerterme nicht mehr den korrekten Zusammenhang zwischen Messtoren und DUT-Ebene beschreiben. Demgegenüber haben jedoch Veränderungen der Signalquelle 418, des Abschlusswiderstands 420, sowie deren Zuleitungen zum jeweiligen Richtkoppler 200, 202 keinen Einfluss auf die Gültigkeit der Kalibrierkoeffizienten.

Nachfolgend wird beschrieben, wie aus den im Zeitbereich an den Ausgängen der Koppler an den Kanälen eins bis vier 402, 404, 406, 408 des Oszilloskops 400 gemessenen Spannungen die Ströme und Spannungen in der Kalibrierebene 16 bestimmt werden.

Hierzu werden die erfassten Spannungen $v_3$ 410, $v_4$ 412, $v_5$ 414 und $v_6$ 416 jeweils zunächst auf eine Zeitschrittweite von $\Delta t = \dfrac{0.5}{f_{max}}$ interpoliert, wobei mit $f_{max}$ die höchste Frequenz beschrieben wird, für die Kalibrierdaten vorhanden sind. Werden die am Kanal $i$ gemessenen Spannungen als $v_i$ mit $i = 3, 4, 5, 6$ bezeichnet, so lassen sich diese nun als Vektoren $(v_i(k \cdot \Delta t))$ darstellen. $k$ bezeichnet hierbei den Laufindex über alle $N$ Datenpunkte mit $k = 1, ..., N$. Anschließend wird eine Kurzzeit-Fouriertransformation durchgeführt. Die Breite des Fensters der STFT soll dabei $m$ Datenpunkte umfassen. Es werden also zum Beispiel die ersten $m$ Elemente der Vektoren $v_i$ in den Frequenzbereich transformiert.

$$\{V_i(l \cdot \Delta f)\} = FFT\{v_i(n \cdot \Delta t)\} \qquad (88)$$

Für beide Laufindizes $l$. und $n$ gilt $l, n = 1, ..., m$, da die Anzahl der Frequenzpunkte nach der Transformation mit der Anzahl der Datenpunkte im Zeitbereich übereinstimmt. Es ergibt sich für die Frequenzschrittweite

$$\Delta f = \frac{2 f_{max}}{m} \qquad (89)$$

Die Elemente der Fehlermatrizen $\boldsymbol{E_A}$ und $\boldsymbol{E_B}$ werden durch Interpolation ebenfalls an diese Frequenzschrittweite angepasst. Durch die FFT stellen die Vektoren $V_i$ zunächst ein symmetrisches Spektrum dar, dessen Elemente für $1 \leq l \leq \dfrac{m}{2}$ den Frequenzbereich $0 \leq f \leq f_{max}$ beschreiben, während die Elemente für $\dfrac{m}{2} < l \leq m$ die negativen Frequenzen mit $- f_{max} \leq f < 0$ darstellen. Da hier nur reelle Größen betrachtet werden, ist es ausreichend, nur die Frequenzanteile mit $f \geq 0$ zu berücksichtigen. Im Weiteren wird davon ausgegangen, dass die Eingänge bzw. Kanäle 402, 404, 406, 408 des zur Zeitbereichsmessung verwendeten Oszilloskops 400 die gleiche Impedanz $Z_0$ aufweisen, wie die Leitung selbst, so dass es keine vom Messgerät zurücklaufende Welle gibt. Die gleiche Annahme wurde bereits in der Kalibrierung in Bezug auf die Messtore 206, 208, 210, 212, 214, 216 des VNA 204 getroffen. Die Wellengrößen können dann mit

$$a_{Mess,1} = \frac{V_3}{\sqrt{Z_0}} \qquad (90)$$

$$b_{Mess,1} = \frac{V_4}{\sqrt{Z_0}} \qquad (91)$$

$$a_{Mess,2} = \frac{v_5}{\sqrt{Z_0}} \qquad\qquad (92)$$

$$b_{Mess,2} = \frac{v_6}{\sqrt{Z_0}} \qquad\qquad (93)$$

berechnet werden.

Diese Wellengrößen können nun mit Hilfe von (71) und (72) in die Wellengrößen in der Kalibrierebene 16 des DUT 20 umgerechnet werden. Um aus diesen Wellengrößen letztlich wieder die Ströme und Spannungen in der Kalibrierebene 16 zu berechnen werden die Gleichungen

$$U_{DUT,1} = \sqrt{Z_0}\left(a_{DUT,1} + b_{DUT,1}\right) \qquad\qquad (94)$$

$$I_{DUT,1} = \frac{1}{\sqrt{Z_0}}\left(a_{DUT,1} - b_{DUT,1}\right) \qquad\qquad (95)$$

$$U_{DUT,2} = \sqrt{Z_0}\left(a_{DUT,2} + b_{DUT,2}\right) \qquad\qquad (94)$$

$$I_{DUT,2} = \frac{1}{\sqrt{Z_0}}\left(a_{DUT,2} - b_{DUT,2}\right) \qquad\qquad (95)$$

angewendet.

Aufgrund der Eigenschaften der TRL-Kalibrierung ist der Frequenzbereich, für den Kalibrierdaten vorliegen, eingeschränkt (vgl. Gleichung (10)). In den soeben im Frequenzbereich berechneten Strom- und Spannungsvektoren müssen daher diejenigen Elemente, die Frequenzen unterhalb der niedrigsten Kalibrierfrequenz beschreiben, genullt werden. Somit wird sichergestellt, dass in diesem Frequenzbereich, für den ohnehin keine sinnvollen Daten berechnet werden können, keine Werte vorliegen.

Bevor die Vektoren anschließend wieder in den Zeitbereich zurücktransformiert werden, müssen diese zunächst noch gespiegelt werden, damit sie wieder ein symmetrisches Spektrum darstellen. Nach der inversen Fouriertransformation dieser Größen erhält man schließlich die zeitdiskreten Ströme und Spannungen am Prüfling, die, wie die Eingangsgrößen, wieder in $k$ Schritten mit dem Abstand $\Delta t$ vorliegen:

$$u_{DUT,1}(k \cdot \Delta t) = IFFT\left\{U_{DUT,1}(l \cdot \Delta f)\right\} \qquad\qquad (98)$$

$$i_{DUT,1}(k \cdot \Delta t) = IFFT\left\{I_{DUT,1}(l \cdot \Delta f)\right\} \qquad\qquad (99)$$

$$u_{DUT,2}(k \cdot \Delta t) = IFFT\left\{U_{DUT,2}(l \cdot \Delta f)\right\} \qquad\qquad (100)$$

$$i_{DUT,2}(k \cdot \Delta t) = IFFT\left\{I_{DUT,2}(l \cdot \Delta f)\right\} \qquad\qquad (101)$$

Anschließend wandert das eingangs erwähnte Fenster um $h$ Punkte weiter und der nächste Block wird transformiert und berechnet.

Obwohl die eigentliche Messung im Zeitbereich mit einem Oszilloskop erfolgt, wird die Kalibrierung mit einem Netzwerkanalysator durchgeführt, da dadurch eine erhöhte Dynamik erreicht wird.

**Patentansprüche**

1. Verfahren zum Kalibrieren einer, einen ersten und einen zweiten Richtkoppler (200, 202) aufweisenden Messvorrichtung zum Vermessen eines Zweitor-Prüfobjektes (20) (DUT - Device Under Test), welches in einer Kalibrierebene (16) ein erstes Tor (114) und ein zweites Tor (128) aufweist;

   wobei zum Kalibrieren der Messvorrichtung ein vektorieller Netzwerkanalysator (204) (VNA) mit einem ersten, zweiten, dritten, vierten, fünften und sechsten Messtor (206, 208, 210, 212, 214, 216) mit dem ersten und zweiten Tor (114, 128) in der Kalibrierebene (16) derart verbunden wird, dass das erste Messtor (206) mit dem ersten Tor (114) in der Kalibrierebene (16), das zweite Messtor (208) mit dem zweiten Tor (128) in der Kalibrierebene (16), das dritte und vierte Messtor (210, 212) mit dem ersten Richtkoppler (200) sowie das fünfte und sechste Messtor (214, 216) mit dem zweiten Richtkoppler (202) über einen jeweiligen Wellenleiter für elektromagnetische Wellen verbunden ist;

   wobei an dem ersten Messtor (206) eine elektromagnetische Welle $a_1$ (218) in Richtung des ersten Tors (114) in der Kalibrierebene (16) ausläuft und eine elektromagnetische Welle $b_1$ (220) aus Richtung des ersten Tores (114) in der Kalibrierebene (16) einläuft;

   wobei an dem zweiten Messtor (208) eine elektromagnetische Welle $a_2$ (222) in Richtung des zweiten Tors (128) in der Kalibrierebene (16) ausläuft und eine elektromagnetische Welle $b_2$ (224) aus Richtung des zweiten Tores (128) in der Kalibrierebene (16) einläuft;

   wobei an dem ersten Tor (114) in der Kalibrierebene (16) eine elektromagnetische Welle $a_{DUT,1}$ (120) aus Richtung des ersten Messtores (206) einläuft und eine elektromagnetische Welle $b_{DUT,1}$ (122) in Richtung des ersten Messtores (206) ausläuft;

   wobei an dem zweiten Tor (128) in der Kalibrierebene (16) eine elektromagnetische Welle $a_{DUT,2}$ (134) aus Richtung des zweiten Messtores (208) einläuft und eine elektromagnetische Welle $b_{DUT,2}$ (136) in Richtung des zweiten Messtores (208) ausläuft;

   wobei zwischen dem ersten Messtor (206) und dem ersten Tor (114) in der Kalibrierebene (16) ein Anteil der Welle $a_1$ (218) als $a_{Mess,1}$ (226) durch den ersten Richtkoppler (200) ausgekoppelt und dem dritten Messtor (210) des VNA (204) zugeführt wird;

   wobei zwischen dem ersten Messtor (206) und dem ersten Tor (114) in der Kalibrierebene (16) ein Anteil der Welle $b_1$ (220) als $b_{Mess,1}$ (228) durch den ersten Richtkoppler (200) ausgekoppelt und dem vierten Messtor (212) des VNA (204) zugeführt wird;

   wobei zwischen dem zweiten Messtor (208) und dem zweiten Tor (128) in der Kalibrierebene (16) ein Anteil der Welle $a_2$ 222) als $a_{Mess,2}$ (230) durch den zweiten Richtkoppler (202) ausgekoppelt und dem fünften Messtor (214) des VNA (204) zugeführt wird;

   wobei zwischen dem zweiten Messtor (208) und dem zweiten Tor (128) in der Kalibrierebene (16) ein Anteil der Welle $b_2$ (224) als $b_{Mess,2}$ (232) durch den zweiten Richtkoppler (202) ausgekoppelt und dem sechsten Messtor (216) des VNA (204) zugeführt wird;

   wobei zum Kalibrieren der Messvorrichtung anstatt des DUTs mindestens drei verschiedene Kalibrierstandards in der Kalibrierebene (16) angeordnet werden;

   wobei für jeden Kalibrierstandard K und für jeden gewünschten Frequenzpunkt einer Frequenz f von $a_1$ (218) bzw. $a_2$ (222) Streuparameter $S_{xy,K,f}$ mit x = 1, 2, 3, 4, 5 oder 6 und y = 1 oder 2 zwischen dem y-ten und dem x-ten Messtor des VNA (204) für den Kalibrierstandard K und die Frequenz f aus den bekannten Größen $a_{1,K,f}$ und $a_{2,K,f}$ sowie aus den gemessenen Größen $b_{1,K,f}$, $b_{2,K,f}$, $a_{Mess,1,K,f}$, $b_{Mess,1,K,f}$, $a_{Mess,2,K,f}$, $b_{Mess,2,K,f}$ bestimmt werden, wobei

$$\begin{bmatrix} b_{1,K,f} \\ b_{2,K,f} \end{bmatrix} = \begin{bmatrix} S_{11,K,f} & S_{12,K,f} \\ S_{21,K,f} & S_{22,K,f} \end{bmatrix} \begin{bmatrix} a_{1,K,f} \\ a_{2,K,f} \end{bmatrix}$$

$$\begin{bmatrix} a_{Mess,1,K,f} \\ b_{Mess,1,K,f} \end{bmatrix} = \begin{bmatrix} S_{31,K,f} & S_{32,K,f} \\ S_{41,K,f} & S_{42,K,f} \end{bmatrix} \begin{bmatrix} a_{1,K,f} \\ a_{2,K,f} \end{bmatrix}$$

$$\begin{bmatrix} a_{Mess,2,K,f} \\ b_{Mess,2,K,f} \end{bmatrix} = \begin{bmatrix} S_{51,K,f} & S_{52,K,f} \\ S_{61,K,f} & S_{62,K,f} \end{bmatrix} \begin{bmatrix} a_{1,K,f} \\ a_{2,K,f} \end{bmatrix}$$

   gilt;

   wobei aus den gemessenen Streuparametern $S_{xy,K,f}$ mit x = 3, 4, 5, 6 und y = 1, 2 der Kalibrierstandards eine die Übertragung über die Richtkoppler (200, 202) beschreibende Streumatrix $\mathbf{S_{unkorr,K,f}}$

$$S_{unkorr,K,f} = \begin{bmatrix} S_{11,unkorr,K,f} & S_{12,unkorr,K,f} \\ S_{21,unkorr,K,f} & S_{22,unkorr,K,f} \end{bmatrix},$$

mit Streuparametern $S_{11,unkorr,K,f}$, $S_{12,unkorr,K,f}$, $S_{21,unkorr,K,f}$ Und $S_{22,unkorr,K,f}$ berechnet wird, gemäß

$$S_{11,unkorr,K,f} = \frac{b_{Mess,1,K,f}}{a_{Mess,1,K,f}} = \frac{S_{41,K,f}}{S_{31,K,f}} = \sigma_{11}$$

$$S_{21,unkorr,K,f} = \frac{b_{Mess,2,K,f}}{a_{Mess,1,K,f}} = \frac{S_{61,K,f}}{S_{31,K,f}} = \sigma_{21}$$

$$S_{12,unkorr,K,f} = \frac{b_{Mess,1,K,f}}{a_{Mess,2,K,f}} = \frac{S_{42,K,f}}{S_{52,K,f}} = \sigma_{12}$$

$$S_{22,unkorr,K,f} = \frac{b_{Mess,2,K,f}}{a_{Mess,2,K,f}} = \frac{S_{62,K,f}}{S_{52,K,f}} = \sigma_{22}$$

wobei mit den gemessenen Streuparametern $S_{xy,K,f}$ mit x = 1, 2 und y = 1, 2 der Kalibrierstandards eine die Übertragung zwischen dem ersten Messtor (206) des VNA (204) und dem ersten Tor (114) in der Kalibrierebene (16) einerseits sowie zwischen dem zweiten Messtor (208) des VNA (204) und dem zweiten Tor (128) in der Kalibrierebene (16) andererseits beschreibende Streumatrix $S_{I,K,f}$ als

$$S_{I,K,f} = \begin{bmatrix} S_{11,K,f} & S_{12,K,f} \\ S_{21,K,f} & S_{22,K,f} \end{bmatrix}$$

bestimmt wird;

wobei mit den gemessenen Streuparametern $S_{xy,K,f}$ mit x = 1, 2 und y = 1, 2 der Streumatrix $S_{I,K,f}$ Terme $i_{00}$, $i_{01} \cdot i_{10}$ und $i_{11}$ einer Fehlermatrix $I_A$ mit

$$I_A = \begin{bmatrix} i_{00} & i_{01} \\ i_{10} & i_{11} \end{bmatrix}$$

für eine Signalübertragung zwischen dem ersten Messtor (206) einerseits und dem ersten Tor (114) in der Kalibrierebene (16) andererseits in Abhängigkeit von einer Frequenz f der Wellen $a_1$ (218) bzw. $a_2$ (222) mittels eines vorbestimmten Kalibrieralgorithmus bestimmt werden, wobei $I_A$ eine Streumatrix gemäß

$$\begin{bmatrix} b_1 \\ a_{DUT,1} \end{bmatrix} = I_A \begin{bmatrix} a_1 \\ b_{DUT,1} \end{bmatrix}$$

ist;

wobei mit den gemessenen Streuparametern $S_{xy,K,f}$ mit x = 1, 2 und y = 1, 2 der Streumatrix $S_{I,K,f}$ Terme $i_{22}$, $i_{23} \cdot i_{32}$ und $i_{33}$ einer Fehlermatrix $I_B$ mit

$$I_B = \begin{bmatrix} i_{22} & i_{23} \\ i_{32} & i_{33} \end{bmatrix}$$

für eine Signalübertragung zwischen dem zweiten Messtor (208) einerseits und dem zweiten Tor (128) in der Kalibrierebene (16) andererseits in Abhängigkeit von einer Frequenz f der Wellen $a_1$ (218) bzw. $a_2$ (222) mittels eines vorbestimmten Kalibrieralgorithmus bestimmt werden, wobei $\mathbf{I_B}$ eine Streumatrix gemäß

$$\begin{bmatrix} a_{DUT,2} \\ b_2 \end{bmatrix} = \mathbf{I_B} \begin{bmatrix} b_{DUT,2} \\ a_2 \end{bmatrix}$$

ist,

wobei für jeden Frequenzschritt mit der Frequenz f von $a_1$ (218) bzw. $a_2$ (222) und für jeden Kalibrierstandard K eine Korrektur der Streumatrix $\boldsymbol{S_{unkorr,K,f}}$ zu einer korrigierten Streumatrix $\boldsymbol{S_{c,K,f}}$ gemäß der Formel

$$\mathbf{S_{c,K,f}} = \frac{1}{D}\begin{bmatrix} \sigma_{11} - \sigma_{12}\sigma_{21}\Gamma_{F,K,f} & \sigma_{12} - \sigma_{11}\sigma_{12}\Gamma_{R,K,f} \\ \sigma_{21} - \sigma_{22}\sigma_{21}\Gamma_{F,K,f} & \sigma_{22} - \sigma_{12}\sigma_{21}\Gamma_{R,K,f} \end{bmatrix}$$

durchgeführt wird, wobei $D = 1 - \sigma_{21}\sigma_{21}\Gamma_{F,k,f}\Gamma_{R,k,f}$ ist und $\Gamma_{F,K,f} = \frac{S_{51,K,f}}{S_{61,K,f}}$ das Verhältnis von am Ausgang des zweiten Richtkopplers (202) gemessener hin- zu rücklaufender Welle (230, 232) bei Speisung durch das erste Messtor (206) des VNA (204) und $\Gamma_{R,K,f} = \frac{S_{32,K,f}}{S_{42,K,f}}$ das Verhältnis von am Ausgang des ersten Richtkopplers (200) gemessener hin- zu rücklaufender Welle (226, 228) bei Speisung durch das zweite Messtor (208) des VNA (204) beschreibt;

wobei mit den Streuparametern der Streumatrix $\boldsymbol{S_{c,K,f}}$ Terme $e_{00}$, $e_{01} \cdot e_{10}$ und $e_{11}$ einer Fehlermatrix

$$E_A = \begin{bmatrix} e_{00} & e_{01} \\ e_{10} & e_{11} \end{bmatrix}$$

für eine Signalübertragung zwischen dem dritten und vierten Messtor (210, 212) einerseits und dem ersten Tor (114) in der Kalibrierebene (16) andererseits in Abhängigkeit von einer Frequenz f der Wellen $a_1$ (218) bzw. $a_2$ (222) mittels eines vorbestimmten Kalibrieralgorithmus bestimmt werden, wobei $\mathbf{E_A}$ eine Streumatrix gemäß

$$\begin{bmatrix} b_{Mess,1} \\ a_{DUT,1} \end{bmatrix} = E_A \begin{bmatrix} a_{Mess,1} \\ b_{DUT,1} \end{bmatrix}$$

ist;

wobei mit den Streuparametern der Streumatrix $\boldsymbol{S_{c,K,f}}$ Terme $e_{22}$, $e_{23} \cdot e_{32}$ und $e_{33}$ einer Fehlermatrix

$$E_B = \begin{bmatrix} e_{22} & e_{23} \\ e_{32} & e_{33} \end{bmatrix}$$

für eine Signalübertragung zwischen dem fünften und sechsten Messtor (214, 216) einerseits und dem zweiten Tor (128) in der Kalibrierebene (16) andererseits in Abhängigkeit von einer Frequenz f der Wellen $a_1$ (218) bzw. $a_2$ (222) mittels eines vorbestimmten Kalibrieralgorithmus bestimmt werden, wobei $\mathbf{E_B}$ eine Streumatrix gemäß

$$\begin{bmatrix} a_{DUT,2} \\ b_{Mess,2} \end{bmatrix} = E_B \begin{bmatrix} b_{DUT,2} \\ a_{Mess,2} \end{bmatrix}$$

ist;

wobei die isolierten Terme $i_{01}$ und $i_{10}$ aus dem Produkt $i_{01} \cdot i_{10}$ sowie die isolierten Terme $i_{23}$ und $i_{32}$ aus dem Produkt $i_{23} \cdot i_{32}$ gemäß den Formeln

$$i_{01} = i_{10} = \pm\sqrt{i_{01}i_{10}}$$

und

$$i_{23} = i_{32} = \pm\sqrt{i_{23}i_{32}}$$

bestimmt werden, wobei das Vorzeichen jeweils ausgehend von einem Frequenzpunkt mit bekannter Phase durch stetige Ergänzung bestimmt wird, wobei eine Phasendifferenz von einem Frequenzpunkt zu einem nächsten Frequenzpunkt um 180° vermindert wird, wenn diese Phasendifferenz einen vorbestimmten Schwellwert überschreitet; wobei der isolierte Term $e_{10}$ aus dem Produkt $e_{10}\cdot e_{01}$ gemäß der Formel

$$e_{10} = i_{10} \cdot \frac{a_1}{a_{Mess,1}} \cdot \frac{1 - e_{11}S_{11,DUT,K^*}}{1 - i_{11}S_{11,DUT,K^*}}$$

berechnet und daraus der isolierte Term $e_{01}$ bestimmt wird, wobei

$$S_{11,DUT,K^*} = \frac{\left(S_{11,K^*,f} - i_{00}\right)}{\left(i_{10} \cdot i_{01} + i_{11} \cdot \left(S_{11,K^*,f} - i_{00}\right)\right)}$$

ist und K* einen Kalibrierstandard ohne Transmission bezeichnet;
wobei der isolierte Term $e_{23}$ aus dem Produkt $e_{32}\cdot e_{23}$ gemäß der Formel

$$e_{23} = i_{23} \cdot \frac{a_2}{a_{Mess,2}} \cdot \frac{1 - e_{22}S_{22,DUT,K^*}}{1 - i_{22}S_{22,DUT,K^*}}$$

berechnet und daraus der isolierte Term $e_{23}$ bestimmt wird, wobei

$$S_{22,DUT,K^*} = \frac{\left(S_{22,K^*,f} - i_{22,f}\right)}{\left(i_{32} \cdot i_{23} + i_{33} \cdot \left(S_{22,K^*,f} - i_{22,f}\right)\right)}$$

ist und K* einen Kalibrierstandard ohne Transmission bezeichnet.

2. Verfahren nach Anspruch 1, **dadurch gekennzeichnet, dass** das dritte und vierte Messtor (210, 212) des VNA (204) durch Umschaltung zusätzlich als fünftes und sechstes Messtor (214, 216) verwendet werden, so dass die Wellen $a_{Mess,1}$ (226) und $b_{Mess,1}$ (228) am dritten und vierten Messtor (210, 212) des VNA (204) zeitlich getrennt von den Wellen $a_{Mess,2}$ (230) und $b_{Mess,2}$ (232) am fünften und sechsten Messtor (214, 216) des VNA (204) gemessen werden.

3. Verfahren nach mindestens einem der vorhergehenden Ansprüche, **dadurch gekennzeichnet, dass** die Terme $e_{00}$, $e_{01}e_{10}$ und $e_{11}$ der Fehlermatrix **E_A** und die Terme $e_{22}$, $e_{23}e_{32}$ und $e_{33}$ der Fehlermatrix **E_B** über einen TRL-Algorithmus aus der korrigierten Streumatrix $\boldsymbol{S_{c,K,f}}$ bestimmt werden.

4. Verfahren nach mindestens einem der vorhergehenden Ansprüche, **dadurch gekennzeichnet, dass** die Terme $i_{00}$, $i_{01}i_{10}$ und $i_{11}$ der Fehlermatrix **I_A** und die Terme $i_{22}$, $i_{23}i_{32}$ und $i_{33}$ der Fehlermatrix **I_B** über einen TRL-Algorithmus aus der Streumatrix $\boldsymbol{S_{I,K,f}}$ bestimmt werden.

5. Verfahren nach Anspruch 3 oder 4, **dadurch gekennzeichnet, dass** für den TRL-Algorithmus drei verschieden Kalibrierstandards des folgenden Typs verwendet werden, ein erster Kalibriestandard des Typs "Durchverbindung" ("thru"), ein zweiter Kalibrierstandard des Typs "nicht angepasster Abschluss" ("reflect") und ein dritter Kalibrierstandard des Typs "Verzögerungsleitung" ("line"), wobei der Reflexionsfaktor des Kalibrierstandards "reflect" ungleich Null ist, wobei eine Phase der Reflexion an dem Kalibrierstandard "reflect" vorab auf +/-90° genau bestimmt ist, wobei für alle Messtore (206, 208, 210, 212, 214, 216) des VNA (204) der identische Kalibrierstandard "reflect" verwendet wird, wobei eine Leitungsimpedanz des Kalibrierstandards "thru" im Wesentlichen einer Leitungsimpedanz des Kalibrierstandards "line" entspricht, wobei die elektrische Länge des Kalibrierstandards "thru" definitionsgemäß 0 ist, wobei eine elektrische Länge des Kalibrierstandards "line" ungleich $n \cdot \frac{\lambda}{2}$ ist mit A = Wellenlänge und n eine ganze Zahl größer oder gleich 1, wobei K = "reflect", "line" oder "thru" und K* = "reflect" ist.

6. Verfahren nach Anspruch 5, **dadurch gekennzeichnet, dass** für einen Unterschied $\Delta\varphi$ der elektrischen Länge des Kalibrierstandards "line" zur elektrischen Länge des Kalibrierstandards "thru"

$$(n-1)\frac{\lambda}{2} + \delta < \Delta\varphi < n \cdot \frac{\lambda}{2} - \delta$$

mit $\delta \geq 20°$ gilt.

7. Verfahren nach Anspruch 5 oder 6, **dadurch gekennzeichnet, dass** der TRL-Algorithmus aus den Eingangsgrößen $S_{c,K,f}$ bzw. $S_{I,K,f}$ die Ausgangsgrößen $E_A$ und $E_B$ bzw. $I_A$ und $I_B$ folgendermaßen bestimmt, die Terme der Matrizen $E_A$, $E_B$ bzw. $I_A$ und $I_B$ werden über die Terme von deren jeweiliger Transmissionsmatrizen $T_A$ und $T_B$ mit

$$T_A = \begin{bmatrix} r_{11} & r_{12} \\ r_{21} & r_{22} \end{bmatrix} = r_{22} \begin{bmatrix} a & b \\ c & 1 \end{bmatrix}$$

und

$$T_B = \begin{bmatrix} \rho_{11} & \rho_{12} \\ \rho_{21} & \rho_{22} \end{bmatrix} = \rho_{22} \begin{bmatrix} \alpha & \beta \\ \gamma & 1 \end{bmatrix}$$

bestimmt, wobei

$$\begin{bmatrix} b_{DUT,1} \\ a_{DUT,1} \end{bmatrix} = T_A^{-1} \begin{bmatrix} b_{Mess,1} \\ a_{Mess,1} \end{bmatrix}$$

$$\begin{bmatrix} a_{DUT,2} \\ b_{DUT,2} \end{bmatrix} = T_B \begin{bmatrix} a_{Mess,2} \\ b_{Mess,2} \end{bmatrix}$$

gilt für $T_A$ = Transmissionsmatrix von $E_A$ und $T_B$ = Transmissionsmatrix von $E_B$ und wobei

$$\begin{bmatrix} b_{DUT,1} \\ a_{DUT,1} \end{bmatrix} = T_A^{-1} \begin{bmatrix} b_1 \\ a_1 \end{bmatrix}$$

$$\begin{bmatrix} a_{DUT,2} \\ b_{DUT,2} \end{bmatrix} = T_B \begin{bmatrix} a_2 \\ b_2 \end{bmatrix}$$

gilt für $T_A$ = Transmissionsmatrix von $I_A$ und $T_B$ = Transmissionsmatrix von $I_B$, wobei für eine gesuchte, um die Systemfehler bereinigte Transmissionsmatrix des DUT in der Kalibrierebene $T_{DUT}$ gilt

$$T_{DUT} = \frac{1}{r_{22}\rho_{22}} \frac{1}{a\alpha} \frac{1}{1-b\frac{c}{a}} \frac{1}{1-\gamma\frac{\beta}{\alpha}} \begin{bmatrix} 1 & -b \\ -c & a \end{bmatrix} T_M \begin{bmatrix} 1 & -\beta \\ -\gamma & \alpha \end{bmatrix}$$

wobei $T_M$ eine Transmissionsmatrix ist, welche aus einer an den Messtoren des VNA gemessenen Streumatrix bestimmt wird;

wobei zum Bestimmen der sieben Größen $a,b,c,\alpha,\beta,\gamma,r_{22}\rho_{22}$ eine Transmissionsmatrix $T_T$ für den Kalibriestandard "thru" und eine Transmissionsmatrix $T_D$ für den Kalibrierstandard "line" aus für diese Kalibrierstandards jeweils an den Messtoren des VNA gemessenen Streumatrizen bestimmt wird, wobei

$$T_T = T_A T_B = g \begin{bmatrix} d & e \\ f & 1 \end{bmatrix}$$

$$T_D = T_A T_L T_B$$

$$T_D T_T^{-1} = T_{DT} = \begin{bmatrix} t_{11} & t_{12} \\ t_{21} & t_{22} \end{bmatrix}$$

gilt, wobei $T_L$ eine Transmissionsmatrix des Kalibrierstandards "line" in der Kalibrierebene ist und zu

$$T_L = T_{DUT,D} = \begin{bmatrix} e^{-\overline{\gamma}l} & 0 \\ 0 & e^{+\overline{\gamma}l} \end{bmatrix}$$

definiert wird, wobei $l$ die tatsächliche, physikalische Länge der Leitung und $\overline{\gamma}$ die Ausbreitungskonstante mit $\overline{\gamma} = \overline{\alpha} + j\overline{\beta}$ ist, wobei $\overline{\alpha}$ eine Dämpfungskonstante und $\overline{\beta}$ eine Phasenkonstante ist;

wobei zum Bestimmen von b die betragsmäßig kleinere Lösung und zum Bestimmen von $\frac{a}{c}$ die betragsmäßig größer Lösung der quadratischen Gleichung

$$t_{21}x^2 + (t_{22} - t_{11})x - t_{12} = 0$$

berechnet wird;

wobei zum Bestimmen von $r_{22}\rho_{22}$ die Gleichung

$$r_{22}\rho_{22} = g \frac{1 - e\frac{c}{a}}{1 - b\frac{c}{a}}$$

berechnet wird;

wobei zum Bestimmen von $\gamma$, $\frac{\beta}{\alpha}$ und $a\alpha$ die Gleichungen

$$\gamma = \frac{f - \frac{c}{a}d}{1 - \frac{c}{a}e}$$

$$\frac{\beta}{\alpha} = \frac{e - b}{d - bf}$$

$$a\alpha = \frac{d - bf}{1 - \frac{c}{a}e}$$

berechnet werden;

wobei zum Bestimmen von a die Größen $b_{Mess,1,reflect,f}$ und $a_{Mess,1,reflect,f}$ sowie $b_{Mess,2,reflect,f}$ und $a_{Mess,2,reflect,f}$ für den transmissionsfreien Kalibrierstandard "reflect" mit einem Reflexionsfaktor $\Gamma_R$, dessen Vorzeichen bekannt ist, durch die Fehlerzweitore mit den Fehlermatrizen $\boldsymbol{E_A}$ und $\boldsymbol{E_B}$ gemessen werden und die Größen $w_1$ und $w_2$ gemäß

$$w_1 = \frac{b_{Mess,1,reflect,f}}{a_{Mess,1,reflect,f}} = \frac{a\Gamma_R + b}{c\Gamma_R + 1}$$

$$w_2 = \frac{b_{Mess,2,reflect,f}}{a_{Mess,2,reflect,f}} = \frac{\alpha\Gamma_R - \gamma}{\beta\Gamma_R - 1}$$

berechnet werden, wobei der Betrag von a gemäß

$$a = \pm\sqrt{\frac{w_1 - b}{w_2 + \gamma}\frac{1 + w_2\frac{\beta}{\alpha}}{1 - w_1\frac{c}{a}}\frac{d - bf}{1 - \frac{c}{a}e}}$$

berechnet wird, wobei das Vorzeichen von a durch Einsetzen der zwei möglichen Ergebnisse von a in die Gleichung

$$\Gamma_R = \frac{w_1 - b}{a\left(1 - w_1\frac{c}{a}\right)}$$

dadurch bestimmt wird, dass das jeweilige Vorzeichen mit dem für $\Gamma_R$ bekannten Vorzeichen verglichen und bei Übereinstimmung dieses Vorzeichen für a bestimmt wird,

wobei c aus dem bekannten Wert für a und $\frac{a}{c}$ bestimmt wird,

wobei zum Bestimmen von $\alpha$ und $\beta$ die Gleichungen

$$\alpha = \frac{1}{a}\frac{d - bf}{1 - \frac{c}{a}e}$$

$$\beta = \alpha\frac{e - b}{d - bf}$$

berechnet werden,

wobei aus den Größen $a,b,c,\alpha,\beta,\gamma,r_{22}\rho_{22}$ die Terme der Transmissionsmatrizen $\boldsymbol{T_A}$ und $\boldsymbol{T_B}$ bestimmt werden, wobei aus den Termen der Transmissionsmatrizen $\boldsymbol{T_A}$ und $\boldsymbol{T_B}$ mittels der Umrechnungsbeziehung zwischen Streumatrix und Transmissionsmatrix die Terme der zugehörigen Streumatrizen $\boldsymbol{E_A}$ und $\boldsymbol{E_B}$ bzw. $\boldsymbol{I_A}$ und $\boldsymbol{I_B}$ berechnet werden.

8. Verfahren nach Anspruch 7, **dadurch gekennzeichnet, dass** der Reflexionsfaktor $\Gamma_R = S_{11,DUT}$ für die Reflexionsmessung durch das Fehlerzweitor mit der Fehlermatrix $\boldsymbol{E_A}$ und $\Gamma_R = S_{22,DUT}$ für die Reflexionsmessung durch das Fehlerzweitor mit der Fehlermatrix $\boldsymbol{E_B}$ ist, wobei $S_{11,DUT}$ (138) und $S_{22,DUT}$ (144) Terme der Streumatrix $\boldsymbol{S_{DUT}}$

$$S_{DUT} = \begin{bmatrix} S_{11,DUT} & S_{12,DUT} \\ S_{21,DUT} & S_{22,DUT} \end{bmatrix}$$

des DUT (20) in Kalibrierebene (16) sind.

**Claims**

1. Method for calibrating a test apparatus, having a first and a second directional coupler (200, 202), for testing a two-port test object (20) (DUT - <u>D</u>evice <u>U</u>nder <u>T</u>est), which has a first port (114) and a second port (128) in a calibration plane (16);

   wherein for the purpose of calibrating the test apparatus a vectorial network analyser (204) (VNA) having a first, a second, a third, a fourth, a fifth and a sixth test port (206, 208, 210, 212, 214, 216) is connected to the first and second ports (114, 128) in the calibration plane (16) such that the first test port (206) is connected to the first port (114) in the calibration plane (16), the second test port (208) is connected to the second port (128) in the calibration plane (16), the third and fourth test ports (210, 212) are connected to the first directional coupler (200) and the fifth and sixth test ports (214, 216) are connected to the second directional coupler (202) via a respective waveguide for electromagnetic waves;

   wherein at the first test port (206) an electromagnetic wave $a_1$ (218) runs out in the direction of the first port (114) in the calibration plane (16) and an electromagnetic wave $b_1$ (220) runs in from the direction of the first port (114) in the calibration plane (16);

   wherein at the second test port (208) an electromagnetic wave $a_2$ (222) runs out in the direction of the second port (128) in the calibration plane (16) and an electromagnetic wave $b_2$ (224) runs in from the direction of the second port (128) in the calibration plane (16);

   wherein at the first port (114) in the calibration plane (16) an electromagnetic wave $a_{DUT,1}$ (120) runs in from the direction of the first test port (206) and an electromagnetic wave $b_{DUT,1}$ (122) runs out in the direction of the first test port (206);

   wherein at the second port (128) in the calibration plane (16) an electromagnetic wave $a_{DUT,2}$ (134) runs in from the direction of the second test port (208) and an electromagnetic wave $b_{DUT,2}$ (136) runs out in the direction of the second test port (208);

   wherein between the first test port (206) and the first port (114) in the calibration plane (16) a component of the wave $a_1$ (218) is coupled out by the first directional coupler (200) as $a_{Mess,1}$ (226) and fed to the third test port (210) of the VNA (204);

   wherein between the first test port (206) and the first port (114) in the calibration plane (16) a component of the wave $b_1$ (220) is coupled out by the first directional coupler (200) as $b_{Mess,1}$ (228) and fed to the fourth test port (212) of the VNA (204);

   wherein between the second test port (208) and the second port (128) in the calibration plane (16) a component of the wave $a_2$ (222) is coupled out by the second directional coupler (202) as $a_{Mess,2}$ (230) and fed to the fifth test port (214) of the VNA (204);

   wherein between the second test port (208) and the second port (128) in the calibration plane (16) a component of the wave $b_2$ (224) is coupled out by the second directional coupler (202) as $b_{Mess,2}$ (232) and fed to the sixth test port (216) of the VNA (204);

   wherein in order to calibrate the test apparatus, instead of the DUT at least three different calibration standards are arranged in the calibration plane (16);

   wherein for each calibration standard K and for each desired frequency point of a frequency f of $a_1$ (218) or $a_2$ (222) scatter parameters $S_{xy,K,f}$, where x = 1, 2, 3, 4, 5 or 6 and y = 1 or 2, are determined between the y-th and the x-th test port of the VNA (204) for the calibration standard K and the frequency f is determined from the known values $a_{1,K,f}$ and $a_{2,K,f}$ as well as from the measured values $b_{1,K,f}$, $b_{2,K,f}$, $a_{Mess,1,K,f}$, $b_{Mess,1,K,f}$ $a_{Mess,2,K,f}$, $b_{Mess,2,K,f}$, whereby

$$\begin{bmatrix} b_{1,K,f} \\ b_{2,K,f} \end{bmatrix} = \begin{bmatrix} S_{11,K,f} & S_{12,K,f} \\ S_{21,K,f} & S_{22,K,f} \end{bmatrix} \begin{bmatrix} a_{1,K,f} \\ a_{2,K,f} \end{bmatrix}$$

$$\begin{bmatrix} a_{Mess,1,K,f} \\ b_{Mess,1,K,f} \end{bmatrix} = \begin{bmatrix} S_{31,K,f} & S_{32,K,f} \\ S_{41,K,f} & S_{42,K,f} \end{bmatrix} \begin{bmatrix} a_{1,K,f} \\ a_{2,K,f} \end{bmatrix}$$

$$\begin{bmatrix} a_{Mess,2,K,f} \\ b_{Mess,2,K,f} \end{bmatrix} = \begin{bmatrix} S_{51,K,f} & S_{52,K,f} \\ S_{61,K,f} & S_{62,K,f} \end{bmatrix} \begin{bmatrix} a_{1,K,f} \\ a_{2,K,f} \end{bmatrix}$$

wherein a scatter matrix $\mathbf{S_{unkorr,K,f}}$

$$\mathbf{S_{unkorr,K,f}} = \begin{bmatrix} S_{11,unkorr,K,f} & S_{12,unkorr,K,f} \\ S_{21,unkorr,K,f} & S_{22,unkorr,K,f} \end{bmatrix}$$

describing the transmission via the directional coupler (200, 202) is calculated from the measured scatter parameters $S_{xy,K,f}$ of the calibration standards, where x = 3, 4, 5, 6 and y = 1, 2, with scatter parameters $S_{11,unkorr,K,f}$, $S_{12,unkorr,K,f}$, $S_{21,unkorr,K,f}$ and $S_{22,unkorr,K,f}$, according to

$$S_{11,unkorr,K,f} = \frac{b_{Mess,1,K,f}}{a_{Mess,1,K,f}} = \frac{S_{41,K,f}}{S_{31,K,f}} = \sigma_{11}$$

$$S_{21,unkorr,K,f} = \frac{b_{Mess,2,K,f}}{a_{Mess,1,K,f}} = \frac{S_{61,K,f}}{S_{31,K,f}} = \sigma_{21}$$

$$S_{12,unkorr,K,f} = \frac{b_{Mess,1,K,f}}{a_{Mess,2,K,f}} = \frac{S_{42,K,f}}{S_{52,K,f}} = \sigma_{12}$$

$$S_{22,unkorr,K,f} = \frac{b_{Mess,2,K,f}}{a_{Mess,2,K,f}} = \frac{S_{62,K,f}}{S_{52,K,f}} = \sigma_{22}$$

whereby a scatter matrix $\mathbf{S_{I,K,f}}$ describing the transmission between the first test port (206) of the VNA (204) and the first port (114) in the calibration plane (16) on the one hand, as well as between the second test port (208) of the VNA (204) and the second port (128) in the calibration plane (16) on the other hand, is determined with the measured scatter parameters $S_{xy,K,f}$ of the calibration standards, where x = 1, 2 and y = 1, 2, as

$$\mathbf{S_{I,K,f}} = \begin{bmatrix} S_{11,K,f} & S_{12,K,f} \\ S_{21,K,f} & S_{22,K,f} \end{bmatrix}$$

whereby, with the measured scatter parameters $S_{xy,K,f}$ of the scatter matrix $\mathbf{S_{I,K,f}}$, where x =1, 2 and y = 1, 2, terms $i_{00}$, $i_{01} \cdot i_{10}$ and $i_{11}$ of an error matrix $\mathbf{I_A}$ with

$$\mathbf{I_A} = \begin{bmatrix} i_{00} & i_{01} \\ i_{10} & i_{11} \end{bmatrix}$$

are determined for a signal transmission between the first test port (206) on the one hand and the first port (114) in the calibration plane (16) on the other hand depending on a frequency f of the waves $a_1$ (218) or $a_2$ (222) by means of a predetermined calibration algorithm, where $\mathbf{I_A}$ is a scatter matrix according to

$$\begin{bmatrix} b_1 \\ a_{DUT,1} \end{bmatrix} = \mathbf{I_A} \begin{bmatrix} a_1 \\ b_{DUT,1} \end{bmatrix}$$

whereby, with the measured scatter parameters $S_{xy,K,f}$ of the scatter matrix $\boldsymbol{S_{I,K,f}}$ where x = 1, 2 and y = 1, 2, terms $i_{22}$, $i_{23} \cdot i_{32}$ and $i_{33}$ of an error matrix $\boldsymbol{I_B}$ with

$$\mathbf{I_B} = \begin{bmatrix} i_{22} & i_{23} \\ i_{32} & i_{33} \end{bmatrix}$$

are determined for a signal transmission between the second test port (208) on the one hand and the second port (128) in the calibration plane (16) on the other hand depending on a frequency f of the waves $a_1$ (218) or $a_2$ (222) by means of a predetermined calibration algorithm, whereby $\mathbf{I_B}$ is a scatter matrix according to

$$\begin{bmatrix} a_{DUT,2} \\ b_2 \end{bmatrix} = \mathbf{I_B} \begin{bmatrix} b_{DUT,2} \\ a_2 \end{bmatrix}$$

wherein for each frequency step with the frequency f of $a_1$ (218) or $a_2$ (222) and for each calibration standard K a correction of the scatter matrix $\mathbf{S_{unkorr,K,f}}$ is carried out to produce a corrected scatter matrix $\mathbf{S_{c,K,f}}$ according to the formula

$$\mathbf{S_{c,K,f}} = \frac{1}{D} \begin{bmatrix} \sigma_{11} - \sigma_{12}\sigma_{21}\Gamma_{F,K,f} & \sigma_{12} - \sigma_{11}\sigma_{12}\Gamma_{R,K,f} \\ \sigma_{21} - \sigma_{22}\sigma_{21}\Gamma_{F,K,f} & \sigma_{22} - \sigma_{12}\sigma_{21}\Gamma_{R,K,f} \end{bmatrix}$$

where $D = 1 - \sigma_{12}\sigma_{21}\Gamma_{F,K,f}\Gamma_{R,K,f}$ and $\Gamma_{F,K,f} = \dfrac{S_{51,K,f}}{S_{61,K,f}}$ describes the ratio of propagated to reflected wave (230, 232) measured at the output of the second directional coupler (202) on feeding through the first test port (206) of the VNA (204) and $\Gamma_{R,K,f} = \dfrac{S_{32,K,f}}{S_{42,K,f}}$ describes the ratio of propagated to reflected wave (226, 228) measured at the output of the first directional coupler (200) on feeding through the second test port (208) of the VNA (204); whereby, with the scatter parameters of the scatter matrix $\boldsymbol{S_{c,K,f}}$, terms $e_{00}$, $e_{01} \cdot e_{10}$ and $e_{11}$ of an error matrix

$$\boldsymbol{E_A} = \begin{bmatrix} e_{00} & e_{01} \\ e_{10} & e_{11} \end{bmatrix}$$

are determined for a signal transmission between the third and fourth test port (210, 212) on the one hand and the first port (114) in the calibration plane (16) on the other hand depending on a frequency f of the waves $a_1$ (218) or $a_2$ (222) by means of a predetermined calibration algorithm, where $\boldsymbol{E_A}$ is a scatter matrix according to

$$\begin{bmatrix} b_{Mess,1} \\ a_{DUT,1} \end{bmatrix} = \boldsymbol{E_A} \begin{bmatrix} a_{Mess,1} \\ b_{DUT,1} \end{bmatrix}$$

whereby, with the scatter parameters of the scatter matrix $\boldsymbol{S_{c,K,f}}$, terms $e_{22}$, $e_{23} \cdot e_{32}$ and $e_{33}$ of an error matrix

$$\boldsymbol{E_B} = \begin{bmatrix} e_{22} & e_{23} \\ e_{32} & e_{33} \end{bmatrix}$$

are determined for a signal transmission between the fifth and sixth test port (214, 216) on the one hand and the second port (128) in the calibration plane (16) on the other hand depending on a frequency f of the waves $a_1$ (218) or $a_2$ (222) by means of a predetermined calibration algorithm, whereby $\boldsymbol{E_B}$ is a scatter matrix according to

$$\begin{bmatrix} a_{DUT,2} \\ b_{Mess,2} \end{bmatrix} = \boldsymbol{E_B} \begin{bmatrix} b_{DUT,2} \\ a_{Mess,2} \end{bmatrix}$$

whereby the isolated terms $i_{01}$ and $i_{10}$ from the product $i_{01} \cdot i_{10}$ as well as the isolated terms $i_{23}$ and $i_{32}$ from the product $i_{23} \cdot i_{32}$ are determined according to the formulas

$$i_{01} = i_{10} = \pm \sqrt{i_{01} i_{10}}$$

and

$$i_{23} = i_{32} = \pm \sqrt{i_{23} i_{32}}$$

whereby the sign is in each case determined starting out from a frequency point with known phase through continuous extrapolation, whereby a phase difference from one frequency point to a next frequency point is reduced by 180° if this phase difference exceeds a predetermined threshold value;
whereby the isolated term $e_{10}$ is calculated from the product $e_{10} \cdot e_{01}$ according to the formula

$$e_{10} = i_{10} \cdot \frac{a_1}{a_{Mess,1}} \cdot \frac{1 - e_{11} S_{11,DUT,K^*}}{1 - i_{11} S_{11,DUT,K^*}}$$

and the isolated term $e_{01}$ is determined from this, whereby

$$S_{11,DUT,K^*} = \frac{\left(S_{11,K^*,f} - i_{00}\right)}{\left(i_{10} \cdot i_{01} + i_{11} \cdot \left(S_{11,K^*,f} - i_{00}\right)\right)}$$

and K* designates a calibration standard without transmission;
whereby the isolated term $e_{23}$ from the product $e_{32} \cdot e_{23}$ is calculated according to the formula

$$e_{23} = i_{23} \cdot \frac{a_2}{a_{Mess,2}} \cdot \frac{1 - e_{22} S_{22,DUT,K^*}}{1 - i_{22} S_{22,DUT,K^*}}$$

and the isolated term $e_{23}$ is determined from this, whereby

$$S_{22,DUT,K^*} = \frac{\left(S_{22,K^*,f} - i_{22,f}\right)}{\left(i_{32} \cdot i_{23} + i_{33} \cdot \left(S_{22,K^*,f} - i_{22,f}\right)\right)}$$

and K* designates a calibration standard without transmission.

2. Method according to claim 1, **characterised in that,** through switching, the third and fourth test ports (210, 212) of the VNA (204) can in addition be used as fifth and sixth test ports (214, 216), so that the waves $a_{Mess,1}$ (226) and $b_{Mess,1}$ (228) are measured at the third and fourth test ports (210, 212) of the VNA (204) at a different time from the waves $a_{Mess,2}$ (230) and $b_{Mess,2}$ (232) at the fifth and sixth test ports (214, 216) of the VNA (204).

3. Method according to at least one of the preceding claims, **characterised in that** the terms $e_{00}$, $e_{01} \cdot e_{10}$ and $e_{11}$ of the error matrix $\mathbf{E_A}$ and the terms $e_{22}$, $e_{23} \cdot e_{32}$ and $e_{33}$ of the error matrix $\mathbf{E_B}$ are determined by means of a TRL algorithm from the corrected scatter matrix $\mathbf{S_{c,K,f}}$.

4. Method according to at least one of the preceding claims, **characterised in that** the terms $i_{00}$, $i_{01} \cdot i_{10}$ and $i_{11}$ of the error matrix $\mathbf{IA}$ and the terms $i_{22}$, $i_{23} \cdot i_{32}$ and $i_{33}$ of the error matrix $\mathbf{I_B}$ are determined by means of a TRL algorithm from the scatter matrix $\mathbf{S_{I,K,f}}$.

5. Method according to claim 3 or 4, **characterised in that** three different calibration standards of the following type are used for the TRL algorithm: a first calibration standard of the type "thru" (through-connection), a second calibration standard of the type "reflect" (unmatched termination) and a third calibration standard of the type "line" (delay line), whereby the reflection coefficient of the calibration standard "reflect" is unequal to zero, whereby a phase of the reflection at the calibration standard "reflect" is precisely determined in advance to +/-90°, whereby the identical calibration standard "reflect" is used for all test ports (206, 208, 210, 212, 214, 216) of the VNA (204), whereby a line impedance of the calibration standard "thru" substantially corresponds to a line impedance of the calibration standard "line", whereby the electrical length of the calibration standard "thru" is by definition 0, whereby an electrical length of the calibration standard "line" is unequal to $n \cdot \dfrac{\lambda}{2}$, where $\lambda$ = wavelength and n is a whole number greater than or equal to 1, where K = "reflect", "line" or "thru" and K* = "reflect".

6. Method according to claim 5, **characterised in that** for a difference $\Delta\varphi$ in the electrical length of the calibration standard "line" in relation to the electrical length of the calibration standard "thru",

$$(n-1)\frac{\lambda}{2} + \delta < \Delta\varphi < n \cdot \frac{\lambda}{2} - \delta$$

where $\delta \geq 20°$.

7. Method according to claim 5 or 6, **characterised in that** the TRL algorithm determines the output values $E_A$ and $E_B$ or $I_A$ and $I_B$ from the input values $S_{c,K,f}$ or $S_{I,K,f}$ as follows:

the terms of the matrices $E_A$, $E_B$ or $I_A$ and $I_B$ are determined through the terms of their respective transmission matrices $T_A$ and $T_B$ with

$$T_A = \begin{bmatrix} r_{11} & r_{12} \\ r_{21} & r_{22} \end{bmatrix} = r_{22} \begin{bmatrix} a & b \\ c & 1 \end{bmatrix}$$

and

$$T_B = \begin{bmatrix} \rho_{11} & \rho_{12} \\ \rho_{21} & \rho_{22} \end{bmatrix} = \rho_{22} \begin{bmatrix} \alpha & \beta \\ \gamma & 1 \end{bmatrix}$$

where

$$\begin{bmatrix} b_{DUT,1} \\ a_{DUT,1} \end{bmatrix} = T_A^{-1} \begin{bmatrix} b_{Mess,1} \\ a_{Mess,1} \end{bmatrix}$$

$$\begin{bmatrix} a_{DUT,2} \\ b_{DUT,2} \end{bmatrix} = T_B \begin{bmatrix} a_{Mess,2} \\ b_{Mess,2} \end{bmatrix}$$

applies for $T_A$ = transmission matrix of $E_A$ and $T_B$ = transmission matrix of $E_B$ and where

$$\begin{bmatrix} b_{DUT,1} \\ a_{DUT,1} \end{bmatrix} = T_A^{-1} \begin{bmatrix} b_1 \\ a_1 \end{bmatrix}$$

$$\begin{bmatrix} a_{DUT,2} \\ b_{DUT,2} \end{bmatrix} = T_B \begin{bmatrix} a_2 \\ b_2 \end{bmatrix}$$

applies for $T_A$ = transmission matrix of $I_A$ and $T_B$ = transmission matrix of $I_B$ and where, for a desired system-error-free transmission matrix of the DUT in the calibration plane **T<sub>DUT</sub>**,

$$T_{DUT} = \frac{1}{r_{22}\rho_{22}}\frac{1}{a\alpha}\frac{1}{1-b\frac{c}{a}}\frac{1}{1-\gamma\frac{\beta}{\alpha}}\begin{bmatrix} 1 & -b \\ -c & a \end{bmatrix}T_M\begin{bmatrix} 1 & -\beta \\ -\gamma & \alpha \end{bmatrix}$$

where $T_M$ is a transmission matrix which is determined from a scatter matrix measured at the test ports of the VNA; whereby, in order to determine the seven values $a,b,c,\alpha,\beta,\gamma,r_{22}\rho_{22}$, a transmission matrix $T_T$ for the calibration standard "thru" and a transmission matrix $T_D$ for the calibration standard "line" is determined from scatter matrices for these calibration standards, in each case measured at the test ports of the VNA, where

$$T_T = T_A T_B = g\begin{bmatrix} d & e \\ f & 1 \end{bmatrix}$$

$$T_D = T_A T_L T_B$$

$$T_D T_T^{-1} = T_{DT} = \begin{bmatrix} t_{11} & t_{12} \\ t_{21} & t_{22} \end{bmatrix}$$

where $T_L$ is a transmission matrix of the calibration standard "line" in the calibration plane and is defined as

$$T_L = T_{DUT,D} = \begin{bmatrix} e^{-\overline{\gamma}l} & 0 \\ 0 & e^{+\overline{\gamma}l} \end{bmatrix}$$

where $l$ is the actual physical length of the line and $\overline{\gamma}$ the propagation constant where $\overline{\gamma} = \overline{\alpha} + j\overline{\beta}$, where $\overline{\alpha}$ is a damping constant and $\overline{\beta}$ is a phase constant;

whereby in order to determine b the lesser solution in terms of amount, and in order to determine $\frac{a}{c}$ the greater solution in terms of amount to the quadratic equation

$$t_{21}x^2 + (t_{22} - t_{11})x - t_{12} = 0$$

is calculated;
whereby in order to determine $r_{22}\rho_{22}$ the equation

$$r_{22}\rho_{22} = g\frac{1-e\frac{c}{a}}{1-b\frac{c}{a}}$$

is calculated;

whereby in order to determine $\gamma$, $\frac{\beta}{\alpha}$ and $a\alpha$ the equations

$$\gamma = \frac{f-\frac{c}{a}d}{1-\frac{c}{a}e}$$

$$\frac{\beta}{\alpha} = \frac{e - b}{d - bf}$$

$$a\alpha = \frac{d - bf}{1 - \frac{c}{a}e}$$

are calculated;

whereby in order to determine a the values $b_{Mess,1,reflect,f}$ and $a_{Mess,1,reflect,f}$ as well as $b_{Mess,2,reflect,f}$ and $a_{Mess,2,reflect,f}$ for the transmission-free calibration standard "reflect" with a reflection coefficient $\Gamma_R$, the sign of which is known, are measured through the error two-ports with the error matrices $\boldsymbol{E_A}$ and $\boldsymbol{E_B}$, and the values $w_1$ and $w_2$ are calculated according to

$$w_1 = \frac{b_{Mess,1,reflect,f}}{a_{Mess,1,reflect,f}} = \frac{a\Gamma_R + b}{c\Gamma_R + 1}$$

$$w_2 = \frac{b_{Mess,2,reflect,f}}{a_{Mess,2,reflect,f}} = \frac{\alpha\Gamma_R - \gamma}{\beta\Gamma_R - 1}$$

whereby the amount of a is calculated according to

$$a = \pm\sqrt{\frac{w_1 - b}{w_2 + \gamma}\frac{1 + w_2\frac{\beta}{\alpha}}{1 - w_1\frac{c}{a}}\frac{d - bf}{1 - \frac{c}{a}e}}$$

whereby the sign of a is determined through insertion of the two possible results for a in the equation

$$\Gamma_R = \frac{w_1 - b}{a\left(1 - w_1\frac{c}{a}\right)}$$

in that the respective sign is compared with the known sign for $\Gamma_R$ and, if these correspond, this sign is determined for a,

where c is determined from the known value for a and $\frac{a}{c}$ is determined,

whereby in order to determine $\alpha$ and $\beta$ the equations

$$\alpha = \frac{1}{a}\frac{d - bf}{1 - \frac{c}{a}e}$$

$$\beta = \alpha\frac{e - b}{d - bf}$$

are calculated;

whereby the terms of the transmission matrices $\boldsymbol{T_A}$ and $\boldsymbol{T_B}$ are determined from the values $a,b,c,\alpha,\beta,\gamma,r_{22}\rho_{22}$, whereby the terms of the associated scatter matrices $\boldsymbol{E_A}$ and $\boldsymbol{E_B}$ or $\boldsymbol{I_A}$ and $\boldsymbol{I_B}$ are calculated from the terms of the transmission matrices $\boldsymbol{T_A}$ and $\boldsymbol{T_B}$ by means of the conversion relationship between scatter matrix and transmission matrix.

8. Method according to claim 7, **characterised in that** the reflection coefficient is hereby $\Gamma_R = \mathbf{S}_{11,\text{DUT}}$ for the reflection measurement through the error two-port with the error matrix $\mathbf{E_A}$, and $\Gamma_R = S_{22,\text{DUT}}$ for the reflection measurement through the error two-port with the error matrix $\mathbf{E_B}$, where $S_{11,\text{DUT}}$ (138) and $S_{22,\text{DUT}}$ (144) are terms of the scatter matrix $\mathbf{S}_{DUT}$

$$\mathbf{S}_{DUT} = \begin{bmatrix} S_{11,DUT} & S_{12,DUT} \\ S_{21,DUT} & S_{22,DUT} \end{bmatrix}$$

of the DUT (20) in the calibration plane (16).

**Revendications**

1. Procédé pour étalonner un dispositif de mesure présentant un premier et un deuxième coupleur directionnel (200, 202) servant à mesurer un objet à tester biporte (20) (DUT - <u>D</u>evice <u>U</u>nder <u>T</u>est, ou "dispositif à tester"), lequel présente une première porte (114) et une deuxième porte (128) dans un plan d'étalonnage (16) ;

   dans lequel, pour étalonner le dispositif de mesure, un analyseur de réseau vectoriel (204) (VNA) possédant une première, une deuxième, une troisième, une quatrième, une cinquième et une sixième porte de mesure (206, 208, 210, 212, 214, 216) est relié aux première et deuxième portes (114, 128) dans le plan d'étalonnage (16) de telle sorte que la première porte de mesure (206) soit reliée à la première porte (114) dans le plan d'étalonnage (16), la deuxième porte de mesure (208) à la deuxième porte (128) dans le plan d'étalonnage (16), la troisième et la quatrième porte de mesure (210, 212) au premier coupleur directionnel (200) et la cinquième et la sixième porte de mesure (214, 216) au deuxième coupleur directionnel (202) par l'intermédiaire d'un guide d'ondes respectif pour ondes électromagnétiques ;

   dans lequel, à la première porte de mesure (206), une onde électromagnétique $a_1$ (218) part en direction de la première porte (114) dans le plan d'étalonnage (16) et une onde électromagnétique $b_1$ (220) arrive de la direction de la première porte (114) dans le plan d'étalonnage (16) ;

   dans lequel, à la deuxième porte de mesure (208), une onde électromagnétique $a_2$ (222) part en direction de la deuxième porte (128) dans le plan d'étalonnage (16) et une onde électromagnétique $b_2$ (224) arrive de la direction de la deuxième porte (128) dans le plan d'étalonnage (16) ;

   dans lequel, à la première porte (114) dans le plan d'étalonnage (16), une onde électromagnétique $a_{\text{DUT},1}$ (120) arrive de la direction de la première porte de mesure (206) et une onde électromagnétique $b_{\text{DUT},1}$ (122) part en direction de la première porte de mesure (206) ;

   dans lequel, à la deuxième porte (128) dans le plan d'étalonnage (16), une onde électromagnétique $a_{\text{DUT},2}$ (134) arrive de la direction de la deuxième porte de mesure (208) et une onde électromagnétique $b_{\text{DUT},2}$ (136) part en direction de la deuxième porte de mesure (208) ;

   dans lequel, entre la première porte de mesure (206) et la première porte (114) dans le plan d'étalonnage (16), une partie de l'onde $a_1$ (218) est découplée en tant que $a_{\text{Mess},1}$ (226) par le premier coupleur directionnel (200) et amenée à la troisième porte de mesure (210) du VNA (204) ;

   dans lequel, entre la première porte de mesure (206) et la première porte (114) dans le plan d'étalonnage (16), une partie de l'onde $b_1$ (220) est découplée en tant que $b_{\text{Mess},1}$ (228) par le premier coupleur directionnel (200) et amenée à la quatrième porte de mesure (212) du VNA (204) ;

   dans lequel, entre la deuxième porte de mesure (208) et la deuxième porte (128) dans le plan d'étalonnage (16), une partie de l'onde $a_2$ (222) est découplée en tant que $a_{\text{Mess},2}$ (230) par le deuxième coupleur directionnel (202) et amenée à la cinquième porte de mesure (214) du VNA (204) ;

   dans lequel, entre la deuxième porte de mesure (208) et la deuxième porte (128) dans le plan d'étalonnage (16), une partie de l'onde $b_2$ (224) est découplée en tant que $b_{\text{Mess},2}$ (232) par le deuxième coupleur directionnel (202) et amenée à la sixième porte de mesure (216) du VNA (204) ;

   dans lequel, pour étalonner le dispositif de mesure, au moins trois étalons différents sont disposés dans le plan d'étalonnage (16) à la place du DUT ;

   dans lequel, pour chaque étalon K et pour chaque point de fréquence souhaité d'une fréquence f de $a_1$ (218) ou $a_2$ (222), des paramètres de dispersion $S_{xy,K,f}$ avec x = 1, 2, 3, 4, 5 ou 6 et y = 1 ou 2 sont déterminés entre la y-ème et la x-ème porte de mesure du VNA (204) pour l'étalon K et la fréquence f à partir des grandeurs connues $a_{1,K,f}$ et $a_{2,K,f}$ ainsi que des grandeurs mesurées $b_{1,K,f}$, $b_{2,K,f}$, $a_{\text{Mess},1,K,f}$, $b_{\text{Mess},1,K,f}$, $a_{\text{Mess},2,K,f}$, $b_{\text{Mess},2,K,f}$, les formules

$$\begin{bmatrix} b_{1,K,f} \\ b_{2,K,f} \end{bmatrix} = \begin{bmatrix} S_{11,K,f} & S_{12,K,f} \\ S_{21,K,f} & S_{22,K,f} \end{bmatrix} \begin{bmatrix} a_{1,K,f} \\ a_{2,K,f} \end{bmatrix}$$

$$\begin{bmatrix} a_{Mess,1,K,f} \\ b_{Mess,1,K,f} \end{bmatrix} = \begin{bmatrix} S_{31,K,f} & S_{32,K,f} \\ S_{41,K,f} & S_{42,K,f} \end{bmatrix} \begin{bmatrix} a_{1,K,f} \\ a_{2,K,f} \end{bmatrix}$$

$$\begin{bmatrix} a_{Mess,2,K,f} \\ b_{Mess,2,K,f} \end{bmatrix} = \begin{bmatrix} S_{51,K,f} & S_{52,K,f} \\ S_{61,K,f} & S_{62,K,f} \end{bmatrix} \begin{bmatrix} a_{1,K,f} \\ a_{2,K,f} \end{bmatrix}$$

s'appliquant ;

dans lequel, à partir des paramètres de dispersion mesurés $S_{xy,K,f}$ avec x = 3, 4, 5, 6 et y = 1, 2 des étalons, une matrice de dispersion $\mathbf{S_{unkorr,K,f}}$

$$S_{unkorr,K,f} = \begin{bmatrix} S_{11,unkorr,K,f} & S_{12,unkorr,K,f} \\ S_{21,unkorr,K,f} & S_{22,unkorr,K,f} \end{bmatrix},$$

décrivant la transmission par les coupleurs directionnels (200, 202) est calculée avec les paramètres de dispersion $S_{11,unkorr,K,f}$, $S_{12,unkorr,K,f}$, $S_{21,unkorr,K,f}$ et $S_{22,unkorr,K,f}$ selon

$$S_{11,unkorr,K,f} = \frac{b_{Mess,1,K,f}}{a_{Mess,1,K,f}} = \frac{S_{41,K,f}}{S_{31,K,f}} = \sigma_{11}$$

$$S_{21,unkorr,K,f} = \frac{b_{Mess,2,K,f}}{a_{Mess,1,K,f}} = \frac{S_{61,K,f}}{S_{31,K,f}} = \sigma_{21}$$

$$S_{12,unkorr,K,f} = \frac{b_{Mess,1,K,f}}{a_{Mess,2,K,f}} = \frac{S_{42,K,f}}{S_{52,K,f}} = \sigma_{12}$$

$$S_{22,unkorr,K,f} = \frac{b_{Mess,2,K,f}}{a_{Mess,2,K,f}} = \frac{S_{62,K,f}}{S_{52,K,f}} = \sigma_{22}$$

dans lequel, avec les paramètres de dispersion mesurés $S_{xy,K,f}$ avec x = 1, 2 et y = 1, 2 des étalons, une matrice de dispersion $\mathbf{S_{I,K,f}}$ décrivant la transmission entre la première porte de mesure (206) du VNA (204) et la première porte (114) dans le plan d'étalonnage (16), d'une part, et entre la deuxième porte de mesure (208) du VNA (204) et la deuxième porte (128) dans le plan d'étalonnage (16), d'autre part, est déterminée comme suit :

$$\mathbf{S_{I,K,f}} = \begin{bmatrix} S_{11,K,f} & S_{12,K,f} \\ S_{21,K,f} & S_{22,K,f} \end{bmatrix} ;$$

dans lequel, avec les paramètres de dispersion mesurés $S_{xy,K,f}$ avec x = 1, 2 et y = 1, 2 de la matrice de dispersion $\mathbf{S_{I,K,f}}$, les termes $i_{00}$, $i_{01} \cdot i_{10}$ et $i_{11}$ d'une matrice d'erreur $\mathbf{I_A}$ avec

$$\mathbf{I_A} = \begin{bmatrix} i_{00} & i_{01} \\ i_{10} & i_{11} \end{bmatrix}$$

pour une transmission de signal entre la première porte de mesure (206), d'une part, et la première porte (114) dans le plan d'étalonnage (16), d'autre part, sont déterminés en fonction d'une fréquence f des ondes $a_1$ (218) ou $a_2$ (222) au moyen d'un algorithme d'étalonnage prédéterminé, $\mathbf{I_A}$ étant une matrice de dispersion selon

$$\begin{bmatrix} b_1 \\ a_{DUT,1} \end{bmatrix} = \mathbf{I_A} \begin{bmatrix} a_1 \\ b_{DUT,1} \end{bmatrix} ;$$

dans lequel, avec les paramètres de dispersion mesurés $S_{xy,K,f}$ avec x = 1, 2 et y = 1, 2 de la matrice de dispersion $\boldsymbol{S_{I,K,f}}$, les termes $i_{22}$, $i_{23}\cdot i_{32}$ et $i_{33}$ d'une matrice d'erreur $\boldsymbol{I_B}$ avec

$$\mathbf{I_B} = \begin{bmatrix} i_{22} & i_{23} \\ i_{32} & i_{33} \end{bmatrix}$$

pour une transmission de signal entre la deuxième porte de mesure (208), d'une part, et la deuxième porte (128) dans le plan d'étalonnage (16), d'autre part, sont déterminés en fonction d'une fréquence f des ondes $a_1$ (218) ou $a_2$ (222) au moyen d'un algorithme d'étalonnage prédéterminé, $\mathbf{I_B}$ étant une matrice de dispersion selon

$$\begin{bmatrix} a_{DUT,2} \\ b_2 \end{bmatrix} = \mathbf{I_B} \begin{bmatrix} b_{DUT,2} \\ a_2 \end{bmatrix} ;$$

dans lequel, pour chaque pas de fréquence à la fréquence f de $a_1$ (218) ou $a_2$ (222) et pour chaque étalon K, une correction de la matrice de dispersion $\mathbf{S_{unkorr,K,f}}$ en une matrice de dispersion $\mathbf{S_{c,K,f}}$ corrigée selon la formule

$$\mathbf{S_{c,K,f}} = \frac{1}{D} \begin{bmatrix} \sigma_{11} - \sigma_{12}\sigma_{21}\Gamma_{F,K,f} & \sigma_{12} - \sigma_{11}\sigma_{12}\Gamma_{R,K,f} \\ \sigma_{21} - \sigma_{22}\sigma_{21}\Gamma_{F,K,f} & \sigma_{22} - \sigma_{12}\sigma_{21}\Gamma_{R,K,f} \end{bmatrix}$$

est effectuée, où $D = 1 - \sigma_{12}\sigma_{21}\Gamma_{F,K,f}\Gamma_{R,K,f}$ et $\Gamma_{F,K,f} = \dfrac{S_{51,K,f}}{S_{61,K,f}}$ décrit le rapport entre ondes incidente et réfléchie (230, 232) mesurées à la sortie du deuxième coupleur directionnel (202) en cas d'alimentation par la première porte de mesure (206) du VNA (204) et $\Gamma_{R,K,f} = \dfrac{S_{32,K,f}}{S_{42,K,f}}$ le rapport entre ondes incidente et réfléchie (226, 228) mesurées à la sortie du premier coupleur directionnel (200) en cas d'alimentation par la deuxième porte de mesure (208) du VNA (204) ;

dans lequel, avec les paramètres de dispersion de la matrice de dispersion $\boldsymbol{S_{c,K,f}}$, les termes $e_{00}$, $e_{01}\cdot e_{10}$ et $e_{11}$ d'une matrice d'erreur

$$\boldsymbol{E_A} = \begin{bmatrix} e_{00} & e_{01} \\ e_{10} & e_{11} \end{bmatrix}$$

pour une transmission de signal entre la troisième et la quatrième porte de mesure (210, 212), d'une part, et la première porte (114) dans le plan d'étalonnage (16), d'autre part, sont déterminés en fonction d'une fréquence f des ondes $a_1$ (218) ou $a_2$ (222) au moyen d'un algorithme d'étalonnage prédéterminé, $\mathbf{E_A}$ étant une matrice de dispersion selon

$$\begin{bmatrix} b_{Mess,1} \\ a_{DUT,1} \end{bmatrix} = \boldsymbol{E_A} \begin{bmatrix} a_{Mess,1} \\ b_{DUT,1} \end{bmatrix} ;$$

dans lequel, avec les paramètres de dispersion de la matrice de dispersion $\boldsymbol{S_{c,K,f}}$, les termes $e_{22}$, $e_{23}\cdot e_{32}$ et $e_{33}$ d'une matrice d'erreur

$$\boldsymbol{E_B} = \begin{bmatrix} e_{22} & e_{23} \\ e_{32} & e_{33} \end{bmatrix}$$

pour une transmission de signal entre la cinquième et la sixième porte de mesure (214, 216), d'une part, et la deuxième porte (128) dans le plan d'étalonnage (16), d'autre part, sont déterminés en fonction d'une fréquence f des ondes $a_1$ (218) ou $a_2$ (222) au moyen d'un algorithme d'étalonnage prédéterminé, $\mathbf{E_B}$ étant une matrice de dispersion selon

$$\begin{bmatrix} a_{DUT,2} \\ b_{Mess,2} \end{bmatrix} = E_B \begin{bmatrix} b_{DUT,2} \\ a_{Mess,2} \end{bmatrix} ;$$

dans lequel les termes isolés $i_{01}$ et $i_{10}$ du produit $i_{01} \cdot i_{10}$ ainsi que les termes isolés $i_{23}$ et $i_{32}$ du produit $i_{23} \cdot i_{32}$ sont déterminés selon les formules

$$i_{01} = i_{10} = \pm\sqrt{i_{01}i_{10}}$$

et

$$i_{23} = i_{32} = \pm\sqrt{i_{23}i_{32}}$$

dans lesquelles le signe est déterminé par extrapolation continue à partir d'un point de fréquence de phase connue, une différence de phase d'un point de fréquence à un point de fréquence suivant étant diminuée de 180° si cette différence de phase dépasse une valeur seuil prédéterminée ;
dans lequel le terme isolé $e_{10}$ du produit $e_{10} \cdot e_{01}$ est calculé selon la formule

$$e_{10} = i_{10} \cdot \frac{a_1}{a_{Mess,1}} \cdot \frac{1 - e_{11}S_{11,DUT,K^*}}{1 - i_{11}S_{11,DUT,K^*}}$$

et le terme isolé $e_{01}$ déterminé à partir de celui-ci, avec

$$S_{11,DUT,K^*} = \frac{\left(S_{11,K^*,f} - i_{00}\right)}{\left(i_{10} \cdot i_{01} + i_{11} \cdot \left(S_{11,K^*,f} - i_{00}\right)\right)}$$

et K* désignant un étalon sans transmission ; dans lequel le terme isolé $e_{23}$ du produit $e_{32} \cdot e_{23}$ est calculé selon la formule

$$e_{23} = i_{23} \cdot \frac{a_2}{a_{Mess,2}} \cdot \frac{1 - e_{22}S_{22,DUT,K^*}}{1 - i_{22}S_{22,DUT,K^*}}$$

et le terme isolé $e_{23}$ déterminé à partir de celui-ci, avec

$$S_{22,DUT,K^*} = \frac{\left(S_{22,K^*,f} - i_{22,f}\right)}{\left(i_{32} \cdot i_{23} + i_{33} \cdot \left(S_{22,K^*,f} - i_{22,f}\right)\right)}$$

et K* désignant un étalon sans transmission.

2. Procédé selon la 1, **caractérisé en ce que** les troisième et quatrième portes de mesure (210, 212) du VNA (204) sont utilisées en outre, par commutation, comme cinquième et sixième portes de mesure (214, 216), de sorte que les ondes $a_{Mess,1}$ (226) et $b_{Mess,1}$ (228) sont mesurées à la troisième et à la quatrième porte de mesure (210, 212) du VNA (204) à un moment différent des ondes $a_{Mess,2}$ (230) et $b_{Mess,2}$ (232) à la cinquième et à la sixième porte de mesure (214, 216) du VNA (204).

**3.** Procédé selon au moins l'une des revendications précédentes, **caractérisé en ce que** les termes $e_{00}$, $e_{01} \cdot e_{10}$ et $e_{11}$ de la matrice d'erreur $\mathbf{E_A}$ et les termes $e_{22}$, $e_{23} \cdot e_{32}$ et $e_{33}$ de la matrice d'erreur $\mathbf{E_B}$ sont déterminés par un algorithme TRL à partir de la matrice de dispersion corrigée $\mathbf{S_{c,K,f}}$.

**4.** Procédé selon au moins l'une des revendications précédentes, **caractérisé en ce que** les termes $i_{00}$, $i_{01} \cdot i_{10}$ et $i_{11}$ de la matrice d'erreur $\mathbf{I_A}$ et les termes $i_{22}$, $i_{23} \cdot i_{32}$ et $i_{33}$ de la matrice d'erreur $\mathbf{I_B}$ sont déterminés par un algorithme TRL à partir de la matrice de dispersion $\mathbf{S_{I,K,f}}$.

**5.** Procédé selon la revendication 3 ou 4, **caractérisé en ce que** trois étalons différents des types suivants sont utilisés pour l'algorithme TRL, un premier étalon du type « connexion traversante » (« thru »), un deuxième étalon du type « terminaison non adaptée » (« reflect ») et un troisième étalon du type « ligne à retard » (« line »), dans lequel le facteur de réflexion de l'étalon « reflect » est différent de zéro, dans lequel une phase de la réflexion sur l'étalon « reflect » est préalablement déterminée à +/-90° près, dans lequel un étalon « reflect » identique est utilisé pour toutes les portes de mesure (206, 208, 210, 212, 214, 216) du VNA (204), dans lequel une impédance de ligne de l'étalon « thru » correspond sensiblement à une impédance de ligne de l'étalon « line », dans lequel la longueur électrique de l'étalon « thru » est par définition égale à 0, dans lequel une longueur électrique de l'étalon « line » n'est pas égale à $n \cdot \dfrac{\lambda}{2}$, avec $\lambda$ = longueur d'onde et n un nombre entier supérieur ou égal à 1, dans lequel K = « reflect », « line » ou « thru » et K* = « reflect ».

**6.** Procédé selon la revendication 5, **caractérisé en ce qu'**une différence $\Delta\varphi$ entre la longueur électrique de l'étalon « line » et la longueur électrique de l'étalon « thru » est telle que

$$(n-1)\frac{\lambda}{2} + \delta < \Delta\varphi < n \cdot \frac{\lambda}{2} - \delta$$

avec $\delta \geq 20°$.

**7.** Procédé selon la revendication 5 ou 6, **caractérisé en ce que** l'algorithme TRL détermine les grandeurs de sortie $\mathbf{E_A}$ et $\mathbf{E_B}$, respectivement $\mathbf{I_A}$ et $\mathbf{I_B}$, à partir des grandeurs d'entrée $\mathbf{S_{c,K,f}}$, respectivement $\mathbf{S_{I,K,f}}$, de la manière suivante, les termes des matrices $\mathbf{E_A}$, $\mathbf{E_B}$, respectivement $\mathbf{I_A}$ et $\mathbf{I_B}$, sont déterminés par les termes de leurs matrices de transmission respectives $\mathbf{T_A}$ et $\mathbf{T_B}$ avec

$$\mathbf{T_A} = \begin{bmatrix} r_{11} & r_{12} \\ r_{21} & r_{22} \end{bmatrix} = r_{22} \begin{bmatrix} a & b \\ c & 1 \end{bmatrix}$$

et

$$\mathbf{T_B} = \begin{bmatrix} \rho_{11} & \rho_{12} \\ \rho_{21} & \rho_{22} \end{bmatrix} = \rho_{22} \begin{bmatrix} \alpha & \beta \\ \gamma & 1 \end{bmatrix}$$

où

$$\begin{bmatrix} b_{DUT,1} \\ a_{DUT,1} \end{bmatrix} = \mathbf{T_A^{-1}} \begin{bmatrix} b_{Mess,1} \\ a_{Mess,1} \end{bmatrix}$$

$$\begin{bmatrix} a_{DUT,2} \\ b_{DUT,2} \end{bmatrix} = \mathbf{T_B} \begin{bmatrix} a_{Mess,2} \\ b_{Mess,2} \end{bmatrix}$$

s'applique pour $\mathbf{T_A}$ = matrice de transmission de $\mathbf{E_A}$ et $\mathbf{T_B}$ = matrice de transmission de $\mathbf{E_B}$ et où

$$\begin{bmatrix} b_{DUT,1} \\ a_{DUT,1} \end{bmatrix} = T_A^{-1} \begin{bmatrix} b_1 \\ a_1 \end{bmatrix}$$

$$\begin{bmatrix} a_{DUT,2} \\ b_{DUT,2} \end{bmatrix} = T_B \begin{bmatrix} a_2 \\ b_2 \end{bmatrix}$$

s'applique pour $T_A$ = matrice de transmission de $I_A$ et $T_B$ = matrice de transmission de $I_B$,

dans lequel s'applique, pour une matrice de transmission recherchée, corrigée des erreurs du système, du DUT dans le plan d'étalonnage $T_{DUT}$

$$T_{DUT} = \frac{1}{r_{22}\rho_{22}} \frac{1}{a\alpha} \frac{1}{1 - b\frac{c}{a}} \frac{1}{1 - \gamma\frac{\beta}{\alpha}} \begin{bmatrix} 1 & -b \\ -c & a \end{bmatrix} T_M \begin{bmatrix} 1 & -\beta \\ -\gamma & \alpha \end{bmatrix}$$

où $T_M$ est une matrice de transmission qui est déterminée à partir d'une matrice de dispersion mesurée aux portes de mesure du VNA ;

dans lequel, pour déterminer les sept grandeurs $a, b, c, \alpha, \beta, \gamma, r_{22}\rho_{22}$, une matrice de transmission $T_T$ pour l'étalon « thru » et une matrice de transmission $T_D$ pour l'étalon « line » sont déterminées à partir de matrices de dispersion respectivement mesurées pour ces étalons aux portes de mesure du VNA, les formules suivantes

$$T_T = T_A T_B = g \begin{bmatrix} d & e \\ f & 1 \end{bmatrix}$$

$$T_D = T_A T_L T_B$$

$$T_D T_T^{-1} = T_{DT} = \begin{bmatrix} t_{11} & t_{12} \\ t_{21} & t_{22} \end{bmatrix}$$

s'appliquant, où $T_L$ est une matrice de transmission de l'étalon « line » dans le plan d'étalonnage et est définie comme

$$T_L = T_{DUT,D} = \begin{bmatrix} e^{-\overline{\gamma}l} & 0 \\ 0 & e^{+\overline{\gamma}l} \end{bmatrix},$$

où $l$ est la longueur physique réelle de la ligne et $\overline{\gamma}$ la constante de propagation, avec $\overline{\gamma} = \overline{\alpha} + j\overline{\beta}$, où $\overline{\alpha}$ est une constante d'amortissement et $\overline{\beta}$ une constante de phase ;

dans lequel, pour déterminer b, la solution la plus petite en valeur absolue et pour déterminer $\frac{a}{c}$ la solution la plus grande en valeur absolue de l'équation quadratique

$$t_{21}x^2 + (t_{22} - t_{11})x - t_{12} = 0 ;$$

est calculée ;

dans lequel, pour déterminer $r_{22}\rho_{22}$, l'équation

$$r_{22}\rho_{22} = g \frac{1 - e\frac{c}{a}}{1 - b\frac{c}{a}}$$

est calculée ;

dans lequel, pour déterminer $\gamma$, $\dfrac{\beta}{\alpha}$ et $a\alpha$, les équations

$$\gamma = \frac{f - \dfrac{c}{a}d}{1 - \dfrac{c}{a}e}$$

$$\frac{\beta}{\alpha} = \frac{e - b}{d - bf}$$

$$a\alpha = \frac{d - bf}{1 - \dfrac{c}{a}e}$$

 sont calculées ;

dans lequel, pour déterminer a, les grandeurs $b_{Mess,1,reflect,f}$ et $a_{Mess,1,reflect,f}$ ainsi que $b_{Mess,2,reflect,f}$ et $a_{Mess,2,reflect,f}$ pour l'étalon « reflect » sans transmission avec un facteur de réflexion $\Gamma_R$, dont le signe est connu, sont mesurées par les biportes d'erreur avec les matrices d'erreurs $\boldsymbol{E_A}$ et $\boldsymbol{E_B}$ et les grandeurs $w_1$ et $w_2$ sont calculées selon

$$w_1 = \frac{b_{Mess,1,reflect,f}}{a_{Mess,1,reflect,f}} = \frac{a\Gamma_R + b}{c\Gamma_R + 1}$$

$$w_2 = \frac{b_{Mess,2,reflect,f}}{a_{Mess,2,reflect,f}} = \frac{\alpha\Gamma_R - \gamma}{\beta\Gamma_R - 1}$$

où la valeur de a est calculée selon

$$a = \pm\sqrt{\frac{w_1 - b}{w_2 + \gamma}\frac{1 + w_2\dfrac{\beta}{\alpha}}{1 - w_1\dfrac{c}{a}}\frac{d - bf}{1 - \dfrac{c}{a}e}}$$

où le signe de a est déterminé en introduisant les deux résultats possibles de a dans l'équation

$$\Gamma_R = \frac{w_1 - b}{a\left(1 - w_1\dfrac{c}{a}\right)}$$

par le fait que le signe respectif est comparé avec le signe connu pour $\Gamma_R$ et qu'en cas de correspondance, ce signe est déterminé pour a,

dans lequel c est déterminé à partir de la valeur connue de a et $\dfrac{a}{c}$,

dans lequel, pour déterminer $\alpha$ et $\beta$, les équations

$$\alpha = \frac{1}{a}\frac{d - bf}{1 - \dfrac{c}{a}e}$$

$$\beta = \alpha \frac{e - b}{d - bf}$$

sont calculées,

dans lequel les termes des matrices de transmission $\textbf{T}_\textbf{A}$ et $\textbf{T}_\textbf{B}$ sont déterminés à partir des grandeurs $a,b,c,\alpha,\beta,\gamma,$ $r_{22}\rho_{22}$, les termes des matrices de dispersion associées $\textbf{E}_\textbf{A}$ et $\textbf{E}_\textbf{B}$, respectivement $\textbf{I}_\textbf{A}$ et $\textbf{I}_\textbf{B}$, étant calculés à partir des termes des matrices de transmission $\textbf{T}_\textbf{A}$ et $\textbf{T}_\textbf{B}$ au moyen de la relation de conversion entre matrice de dispersion et matrice de transmission.

8. Procédé selon la revendication 7, **caractérisé en ce que** le facteur de réflexion est $\Gamma_R = S_{11,DUT}$ pour la mesure de réflexion par le biporte d'erreur avec la matrice d'erreur $\textbf{E}_\textbf{A}$ et $\Gamma_R = S_{22,DUT}$ pour la mesure de réflexion par le biporte d'erreur avec la matrice d'erreur $\textbf{E}_\textbf{B}$, $S_{11,DUT}$ (138) et $S_{22,DUT}$ (144) étant des termes de la matrice de dispersion $\textbf{S}_{\textbf{DUT}}$

$$S_{DUT} = \begin{bmatrix} S_{11.DUT} & S_{12.DUT} \\ S_{21.DUT} & S_{22.DUT} \end{bmatrix}$$

du DUT (20) dans le plan d'étalonnage (16).

**Fig. 1**

EP 3 039 443 B1

# Fig. 2

# Fig. 3

EP 3 039 443 B1

# Fig. 4

# Fig. 5

EP 3 039 443 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **UWE SIART;.** *Kalibrierung von Netzwerkanalysatoren,* 04. Januar 2012, http://www.siart.de/lehre/nwa.pdf
- **D. ROOT et al.** X-Parameter: Das neue Paradigma zur Beschreibung nichtlinearer HF- und Mikrowellenbauelemente. *tm - Technisches Messen,* 2010, vol. 77 (7-8
- **HIEBEL, MICHAEL.** Grundlagen der vektoriellen Netzwerkanalyse. Rohde & Schwarz GmbH & Co, 2006
- **HU J. et al.** Calibrated non-linear vector network measurement without using a multi-haromic generator. *IET MICROWAVES ANTENNAS & PROPAGATION,* 11. April 2011, vol. 5 (5), 616-624
- **HIEBEL, MICHAEL.** Grundlagen der vektoriellen Netzwerkanalyse. Rohde & Schwarz GmbH & Co, 2006
- **EUL, H.-J. ; SCHIEK, B.** A generalized theory and new calibration procedures for network analyzer self-calibration. *Microwave Theory and Techniques, IEEE Transactions,* April 1991, vol. 39 (4), ISSN 0018-9480, 724-731, http://dx.doi.org/10.1109/22.76439

- **ENGEN, G.F. ; HOER, C.A.** Thru-Reflect-Line: An Improved Technique for Calibrating the Dual Six-Port Automatic Network Analyzer. *Microwave Theory and Techniques, IEEE Transactions,* Dezember 1979, vol. 27 (12), ISSN 0018-9480, 987-993, http://dx.doi.org/10.1109/TMTT.1979.1129778
- **ENGEN, G.F. ; HOER, C.A.** Thru-Reflect-Line: An Improved Technique for Calibrating the Dual Six-Port Automatic Network Analyzer. *IEEE Transactions Microwave Theory and Techniques,* Dezember 1979, vol. MTT-27 (12
- **SCHIEK, BURKHARD.** Grundlagen der Hochfrequenz-Messtechnik. Springer-Verlag, 1999
- **EUL, H.-J. ; SCHIEK, B.** A generalized theory and new calibration procedures for network analyzer self-calibration. *Microwave Theory and Techniques, IEEE Transactions,* April 1991, vol. 39 (4), 724-731
- **MARKS, ROGER B.** Formulations of the Basic Vector Network Analyzer Error Model including Switch-Terms. *ARFTG Conference Digest-Fall,* 1997, vol. 32, 115-126
- **MARKS, ROGER B.** Formulations of the Basic Vector Network Analyzer Error Model including Switch-Terms. *ARFTG Conference Digest-Fall,* 1997, vol. 32, 115-126